(19) **Europäisches Patentamt / European Patent Office / Office européen des brevets**

(11) **EP 1 104 110 B1**

(12) **EUROPEAN PATENT SPECIFICATION**

(45) Date of publication and mention
of the grant of the patent:
**21.09.2011 Bulletin 2011/38**

(51) Int Cl.:
*H03L 7/081* (2006.01)    *H04L 7/033* (2006.01)
*H03K 5/13* (2006.01)    *H03K 5/151* (2006.01)

(21) Application number: **00310447.8**

(22) Date of filing: **24.11.2000**

(54) **Phase-combining circuit and timing signal generator circuit for carrying out a high-speed signal transmission**

Phasenkombinationsschaltung und Taktsignalgenerator zur Signalübertragung mit hoher Geschwindigkeit

Circuit de combinaison de phase et circuit générateur de signal d'horloge pour transmission de signal à grande vitesse

(84) Designated Contracting States:
**DE FR GB**

(30) Priority: **26.11.1999 JP 33632899**
            **22.03.2000 JP 2000080792**
            **12.10.2000 JP 2000312181**

(43) Date of publication of application:
**30.05.2001 Bulletin 2001/22**

(60) Divisional application:
**05002166.6 / 1 538 753**

(73) Proprietor: **FUJITSU LIMITED**
**Kawasaki-shi,**
**Kanagawa 211-8588 (JP)**

(72) Inventors:
• **Tamura, Hirotaka**
**Kawasaki-shi,**
**Kanagawa 211-8588 (JP)**
• **Kibune, Masaya**
**Kawasaki-shi,**
**Kanagawa 211-8588 (JP)**

(74) Representative: **Stebbing, Timothy Charles et al**
**Haseltine Lake LLP**
**Lincoln House, 5th Floor**
**300 High Holborn**
**London WC1V 7JH (GB)**

(56) References cited:
**EP-A- 0 884 732**     **WO-A-98/37656**
**US-A- 5 841 325**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a phase-combining circuit and a timing signal generator circuit, and more particularly, to a phase-combining circuit and a timing signal generator circuit for carrying, out a high-speed signal transmission between a plurality of LSI chips, between a plurality of elements within one chip, and between circuit blocks, respectively.

Recently, the performance of components used to construct computers and other information processing apparatuses has improved greatly, and with these improvements there has developed a need to increase the operating speed and data transfer rate of semiconductor memory devices. For example, there has been a remarkable improvement in the performance of semiconductor memory such as a dynamic random access memory (DRAM) and processors. Along with the improvement in the performance of semiconductor memories and processors, it has now come to a stage where it is no longer possible to improve the performance of systems without improving the signal transmission speed between parts and between elements.

Specifically, a gap in signal transmission speed between a DRAM and a processor (a logic circuit), for example, has been in an increasing trend. This speed gap has come to interrupt the improvement in the performance of computers in recent years. Along with an increase in the size of chips, this gap in the signal transmission speed between elements within one chip and between circuit blocks has been a large factor that limits the performance of chips, not only the signal transmission between chips (between LSI chips). Therefore, there has been a large demand for a provision of a timing signal generator circuit that has high precision based on a smaller number of input phases (that is, a smaller number of phases of input signals).

In order to speed up the signal transmission between LSI chips, it is necessary that a circuit that receives a signal operates at a correct timing to this signal. As a method of generating a correct timing, it has been proposed that a phase-variable timing signal generator circuit using a phase interpolator is provided in a feedback loop like a DLL (Delay-Locked Loop) or a PLL (Phase-Locked Loop).

According to United States Patent No. 5,485,490, issued on January 16, 1996, for example, a first phase (signal) and a second phase (signal) are selected from a clock signal of twelve different phases, and the two selected signals are supplied to a phase interpolator and are assigned by a control code so that a signal (clock; timing signal) having a phase between these two signals is generated. In other words, the phase interpolator is an amplifier circuit for a sum of the two weighted input phases (input signals). The phase interpolator shifts a weight from the first phase (signal) to the second phase (signal) according to a control signal, thereby to generate a clock having a phase between the two phases.

In the PLL according to the United States Patent No. 5,485,490, a clock generated by the phase interpolator is compared with a reference clock, and a feedback is applied to the control signal so that the phases become equal to each other, thereby locking the clock to the reference clock.

According to the conventional timing signal generator circuit, the output precision of the PLL (or the DLL) is determined based on the precision of the phase interpolator. Therefore, the precision of a timing signal (clock) is prescribed by the linearity and the quantization error of an output phase to a control signal (control code) given as a digital signal, and a random phase variation (jitter).

Further, according to the conventional phase interpolator, the input signal has a large number of phases like twelve phases, for example, in order to obtain a high time resolution. Increasing the number of phases of the input signals makes it possible to set a smaller interpolation interval, and this is the simplest method of improving linearity.

However, in the case of using a large number of interpolators in a multi-channel signal transmission, it is difficult to distribute a multi-phase clock (for example, a clock of twelve phases) by keeping a mutual positional relationship within the chip. Further, it is also difficult to realize a circuit of a small phase error that selects two specific signals (phases) from among a large number of input signals having different phases. Further, when a clock signal (input signal) is input to the phase interpolator via a selector circuit and a changeover circuit, this becomes another factor degrading the precision of the output signal.

Generally, the phase interpolator is an amplifier circuit for a sum of the weighted phases of input signals. A signal (clock) that is input to this circuit keeps a complete cycle waveform so long as the input phase is not changed over. However, once the phase (input signal) has been changed over, a deviation occurs from the complete cycle. When the input signal has been changed over, this affects a sum of the weighted phases by a phase-combining circuit from the input due to a capacity coupling or the like. Because of this influence, there occurs a problem that a timing error (jitter) becomes larger at a boundary where the phase is changed over due to a residual coupling from the input phase to the output, even if the input signal has a zero nominal weight in its phase. This jitter can become a fatal problem for the timing signal generator circuit for high-speed signal transmission that always requires a correct timing signal.

WO 98/37656 A describes delay locked loop circuitry for generating a predetermined phase relationship between a pair of clocks. A first delay-locked loop includes delay elements arranged in a chain receiving an input clock and generating, from each delay element, a set of phase vectors, each shifted a unit delay from the adjacent vector. The first delay-locked loop adjusts the unit delays in the delay chain using a delay adjustment signal so that the phase vectors span a predetermined phase shift of the input clock. A second delay-locked loop selects, from the first delay-locked loop, a pair of phase vectors which brackets the phase of an input clock. A phase interpolator receives the selected pair of vectors and generates an output clock and a delayed output clock, the amount of the delay being controlled by the delay adjustment signal of the first delay-locked loop circuitry. A phase detector compares the delayed output clock with the input clock and adjusts the phase interpolator, based on the phase comparison, so that the phase of the delayed output clock is in phase with the input clock. As a result, there is a predetermined phase relationship between the output clock and the input clock, the phase relationship being the amount of delay between the output clock and the delayed output clock. Different phase relationships between the input and output clock are possible depending on the number of unit delays used in the path of the delayed output clock or the output clock.

A consideration of the present invention is to provide a high-precision timing signal generator circuit that has a simple structure based on a small number of input phases (small number of phases of input signals). Further, it is another consideration of the present invention to provide a timing signal generator circuit that does not require a phase selector circuit (an input-signal selector circuit) that becomes a cause of a phase error and jitter.

The present invention is defined in the attached independent claims, to which reference should now be made. Further, preferred features may be found in the sub-claims appended thereto.

A detailed description of preferred embodiments of the description will now be given, by way of example, with reference to the accompanying drawings, in which:

Fig. 1A, Fig. 1B and Fig. 1C are diagrams (part 1) for explaining the principle of a phase-combining circuit relating to the present invention;

Fig. 2 is a diagram (part 2) for explaining the principle of the phase-combining circuit relating to the present invention;

Fig. 3A and Fig. 3B are diagrams for explaining modifications of Fig. 1A to Fig. 1C;

Fig. 4 is a diagram for explaining a modification of Fig. 2;

Fig. 5 is a block diagram showing a first embodiment of a timing signal generator circuit relating to the present invention;

Fig. 6 is a circuit diagram showing one example of a phase detector in a four-phase clock generator circuit of the timing signal generator circuit shown in Fig. 5;

Fig. 7 is a circuit diagram showing one example of a charge pump in the four-phase clock generator circuit of the timing signal generator circuit shown in Fig. 5;

Fig. 8 is a circuit diagram showing one example of a delayed stage in the four-phase clock generator circuit of the timing signal generator circuit shown in Fig. 5;

Fig. 9 is a circuit diagram showing one example of a differential buffer in the four-phase clock generator circuit of the timing signal generator circuit shown in Fig. 5;

Fig. 10 is a circuit diagram showing one example of a receiver in the timing signal generator circuit shown in Fig. 5;

Fig. 11 is a circuit diagram showing one example of a phase-combining circuit in the timing signal generator circuit shown in Fig. 5;

Fig. 12A and Fig. 12B are diagrams for explaining a method of giving a weight in a control signal generator circuit shown in Fig. 11;

Fig. 13 is a circuit diagram showing one example of a load device in the phase-combining circuit shown in Fig. 11;

Fig. 14 is a block circuit diagram showing one example of a control signal generator circuit in the timing signal generator circuit shown in Fig. 5;

Fig. 15 is a block circuit diagram showing one example of an up-down counter in the control signal generator circuit shown in Fig. 14;

Fig. 16 is a circuit diagram showing one example of a clock generator circuit for supplying a clock signal to the up-down counter shown in Fig. 15;

Fig. 17 is a circuit diagram showing an example of a structure of a switch in the clock generator circuit shown in Fig. 16;

Fig. 18 is a circuit diagram showing one example of a D/A converter shown in Fig. 14;

Fig. 19 is a circuit diagram showing one example of a circuit for generating a weight selection control signal to be used in the D/A converter shown in Fig. 18;

Fig. 20 is a block circuit diagram showing one example of a phase-combining circuit as a second embodiment of the timing signal generator circuit relating to the present invention;

Fig. 21 is a circuit diagram showing one example of a D/A converter in the phase-combining circuit shown in Fig. 20;

Fig. 22 is a block circuit diagram showing one example of a pre-driver in the phase-combining circuit shown in Fig. 20;

Fig. 23 is a circuit diagram showing one example of a pre-driver unit in the pre-driver shown in Fig. 22;

Fig. 24 is a block circuit diagram showing one example of a mixer and output buffer in the phase-combining circuit shown in Fig. 20;

Fig. 25 is a circuit diagram showing one example of a mixer section in the mixer and output buffer shown in Fig. 24;

Fig. 26 is a circuit diagram showing one example of an output buffer section in the mixer and output buffer shown in Fig. 24;

Fig. 27 is a circuit diagram showing one example of a weight processing circuit in the phase-combining circuit shown in Fig. 20;

Fig. 28 is a circuit diagram showing another example of a four-phase clock generator circuit in the timing signal generator circuit relating to the present invention;

Fig. 29A and Fig. 29B are diagrams showing one example of a change in the weight in the timing signal generator circuit of the present invention;

Fig. 30A and Fig. 30B are diagrams showing another example of a change in the weight in the timing signal generator circuit of the present invention;

Fig. 31 is a block circuit diagram showing one example of a phase-combining circuit as a third embodiment of the timing signal generator circuit relating to the present invention;

Fig. 32 is a circuit diagram showing one example of a phase-combining circuit as a fourth embodiment of the timing signal generator circuit relating to the present invention;

Fig. 33 is a circuit diagram showing one example of a phase-combining circuit as a fifth embodiment of the timing signal generator circuit relating to the present invention;

Fig. 34 is a circuit diagram showing one example of a phase-combining circuit as a sixth embodiment of the timing signal generator circuit relating to the present invention;

Fig. 35 is a diagram showing one example of a change in the weight in the phase-combining circuit shown in Fig. 34;

Fig. 36 is a circuit diagram showing one example of a pre-driver in a phase-combining circuit as a seventh embodiment of the timing signal generator circuit relating to the present invention ;

Fig. 37 is a circuit diagram showing one example of a weight signal generator circuit in a phase-combining circuit as an eighth embodiment of the timing signal generator circuit relating to the present invention;

Fig. 38 is a circuit diagram showing a modified example of pairs of differential transistors to be applied to the phase-combining circuit of the present invention;

Fig. 39A and Fig. 39B are diagrams for explaining a problem when a phase of an input signal to be used in the phase-combining circuit has been deviated;

Fig. 40 is a diagram for explaining the principle of a timing signal generator circuit as another aspect of the present invention;

Fig. 41 is a block diagram schematically showing the timing signal generator circuit shown in Fig. 40;

Fig. 42 is a diagram for explaining one operation principle of the timing signal generator circuit in this aspect of the present invention;

Fig. 43 is a block circuit diagram schematically showing a ninth embodiment of the timing signal generator circuit to which the operation principle shown in Fig. 42 has been applied;

Fig. 44 is a circuit diagram showing one example of a phase-combining circuit in the timing signal generator circuit shown in Fig. 43;

Fig. 45 is a diagram showing one example of a change in the weight in the phase-combining circuit shown in Fig. 44;

Fig. 46 is a block circuit diagram schematically showing a tenth embodiment of the timing signal generator circuit to which the operation principle shown in Fig. 42 has been applied;

Fig. 47 is a circuit diagram showing one example of a phase-combining circuit in the timing signal generator circuit shown in Fig. 46;

Fig. 48 is a diagram for explaining another operation principle of the timing signal generator circuit in this aspect of the present invention;

Fig. 49 is a block circuit diagram schematically showing an eleventh embodiment of the timing signal generator circuit to which the operation principle shown in Fig. 48 has been applied;

Fig. 50 is a circuit diagram showing one example of a phase-combining circuit in the timing signal generator circuit shown in Fig. 49;

Fig. 51 is a diagram showing one example of a change in the weight in the phase-combining circuit shown in Fig. 50;

Fig. 52 is a circuit diagram showing another example of a phase-combining circuit in the timing signal generator circuit shown in Fig. 49;

Fig. 53 is a diagram showing one example of a change in the weight in the phase-combining circuit shown in Fig. 52;

Fig. 54 is a block diagram showing one example of a system having master and slave phase-combining circuits;

Fig. 55 is a diagram (part 1) showing one example of a prior art phase-combining circuit;

Fig. 56 is a diagram (part 2) showing one example of a prior art phase-combining circuit;

Fig. 57 is a block diagram showing the basic functional configuration of a phase-combining circuit not forming part of the present invention;

Figs. 58A and 58B are diagrams for explaining the operation of the -combining circuit shown in Fig. 57;

Fig. 59 is a diagram (part 1) showing a first embodiment of a phase-combining circuit not forming part of the present invention;

Fig. 60 is a diagram (part 2) showing the first embodiment of a phase-combining circuit not forming part of the present invention;

Figs. 61A and 61B are diagrams showing one example of how weights change in the phase-combining circuit;

Fig. 62 is a block diagram showing a second embodiment of a phase-combining circuit not forming part of the present invention;

Fig. 63 is a block diagram showing a third embodiment of a phase-combining circuit not forming part of the present invention;

Fig. 64 is a block diagram showing a control code converter circuit as a phase-combining circuit not Forming part of the present invention;

Fig. 65 is a diagram showing an output phase versus control code relationship for explaining a fifth embodiment of a phase-combining circuit not forming part of the present invention;

Fig. 66 is a circuit diagram showing a sixth embodiment of a phase-combining circuit not forming part of the present invention;

Fig. 67 is a circuit diagram showing a seventh embodiment of a phase-combining circuit not forming part of the present invention;

Fig. 68 is a circuit diagram showing an eighth embodiment of a phase-combining circuit not forming part of the present invention;

Figs. 69A and 69B are diagrams for explaining the operation of the phase-combining circuit shown in Fig. 68; and

Fig. 70 is a diagram for explaining a ninth embodiment of a phase-combining circuit not forming part of the present invention.

Before describing embodiments of a phase-combining circuit and a timing signal generator circuit relating to the present invention in detail, the principle of the present invention will be explained first.

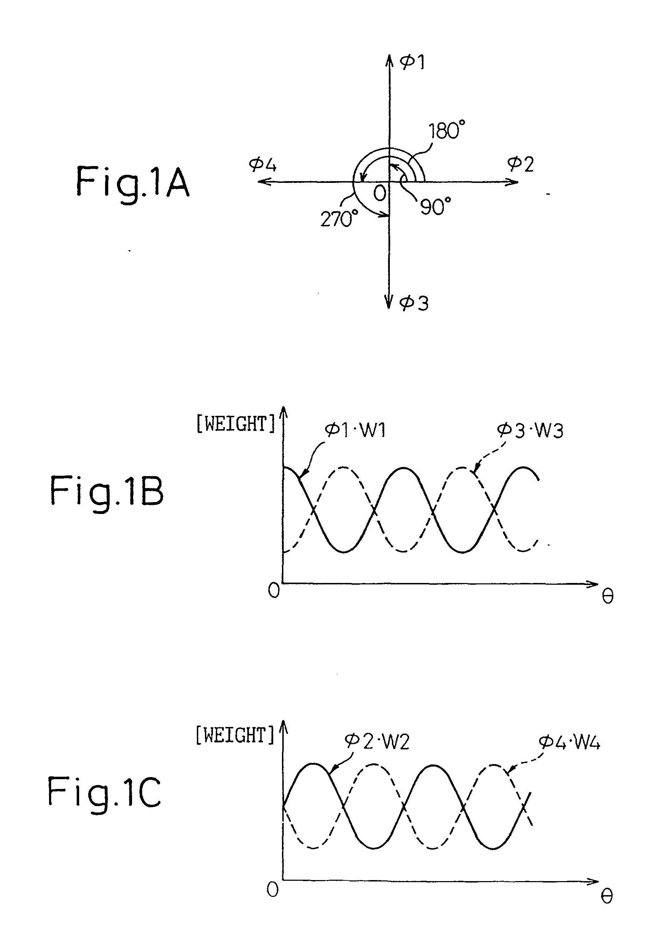

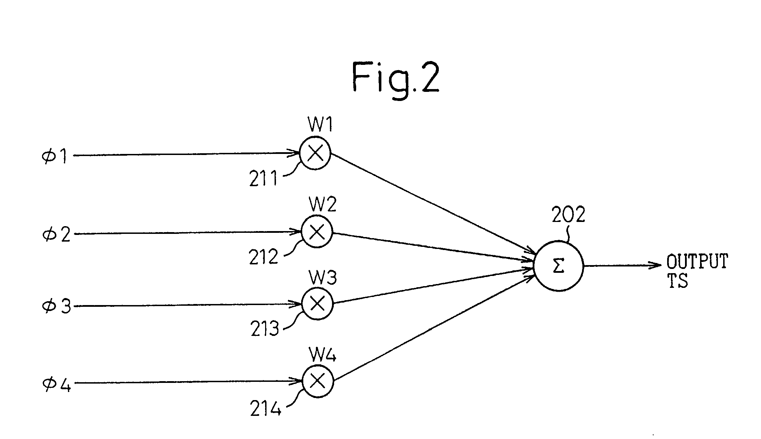

Fig. 1A to Fig. 1C and Fig. 2 are diagrams for explaining the principle of the phase-combining circuit (weighting circuit) relating to the present invention. Fig. 1A shows an example of input signals (input phases: $\phi1$ to $\phi4$) that are used in the phase-combining circuit, and Fig. 1B and Fig. 1C show weights (positive weights: W1 to W4) to be applied to the respective input signals. In Fig. 2, reference numbers 211 to 214 denote multipliers and 202 denotes an adder.

This phase-combining circuit relating to the invention is applied to a timing signal generator circuit, for example, and the phase-combining circuit supplies at least three input phases (at least three input signals of different phases) directly to the phase-combining circuit without passing through a selector circuit, and generates a sum of the weighted phases.

More specifically, the phase-combining circuit (timing signal generator circuit) of the present invention uses, for example, four input phases $\phi1$, $\phi2$, $\phi3$ and $\phi4$ with a phase difference of 90 degrees between adjacent phases, as shown in Fig. 1A. The multipliers 211 to 214 give weights W1, W2, W3 and W4 to the respective input phases as shown in Fig. 1B and Fig. 2. The adder 202 adds up the four weighted input phases (weighted phases: W1*$\phi1$, W2*$\phi2$, W3*$\phi3$, and W4*$\phi4$), and outputs the sum (a phase-combined signal) as TS (= W1*$\phi1$ + W2*$\phi2$ + W3*$\phi3$ + W4*$\phi4$). Thus, it becomes possible to generate a high-precision signal without generating a jump or an error of a phase due to a changeover of the input phases. As the timing signal generator circuit of the above principle has three or more input phases, it is possible to cover an output phase range from 0 to 360 degrees based on only the weight control without changing over the input phases.

The phase-combining circuit (timing signal generator circuit) of the present invention can also be implemented using single-end clocks or differential clocks. In the case of differential clocks, there are different ways of counting phases depending on whether the clocks in a mutually complementing relationship are considered as one differential phase, or whether they are considered as two differential phases each having a 180-degree phase deviation, or whether they are considered as two phases of a single end with a phase deviation of 180 degrees. Therefore, in the present specification, the number of input phases (input signals) is counted by a weighting circuit that can apply different weights to the input phases. For example, three phases means that there are three phases to which mutually different weights can be applied by the phase-combining circuit.

The effect of obtaining an output phase range from 0 to 360 degrees by using inputs of at least three phases can also be obtained by applying weights that change within a positive and negative range to phase inputs of at least two phases and adding up the weighted phases.

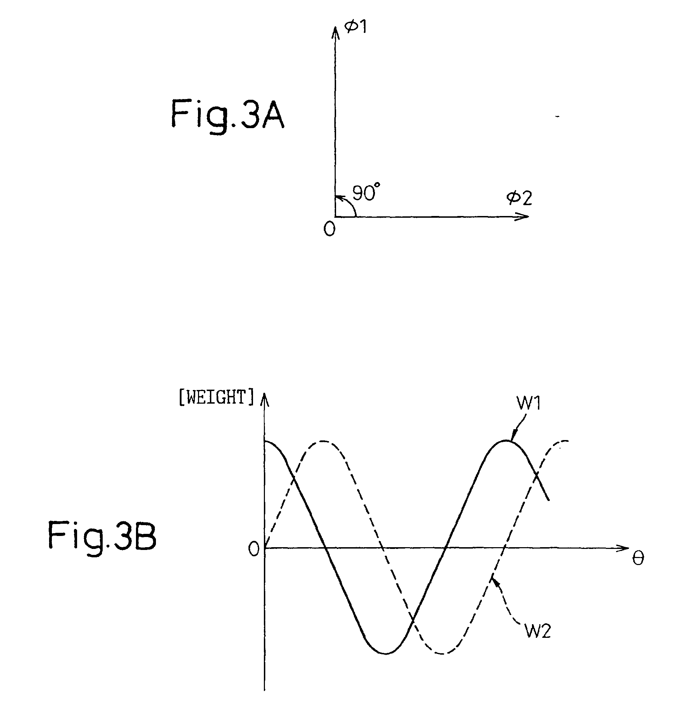

Fig. 3A and Fig. 3B are diagrams for explaining a modification of the principle of the phase-combining circuit shown in Fig. 1A to Fig. 1C. Fig. 3A shows an example of phases (input phases $\phi1$ and $\phi2$) that are used in the phase-combining circuit, and Fig. 3B shows weights (weights having positive and negative signs: W1 and W2) to be applied to the respective phases.

When the weighting circuit adds signs to the weights W1 and W2 as shown in Fig. 3A and Fig. 3B, it is possible to cover the whole phases (0 to 360 degrees) without using a selector circuit for selecting phases outside the phase-combining circuit. In order to decrease the number of input phases, it is preferable to use a circuit that can handle input phases of which mutual phase difference is as large as possible. Therefore, in the present invention, a phase-combining circuit is used that is not limited to the conventional phase interpolator.

The conventional phase interpolator interpolates between selected two input phases and obtains an output. This interpolator is an amplifier circuit for a sum of the weighted input phases. This interpolator interpolates between the phases by successively changing the weight from a state where the weight is 100% given to a first phase to a state where the weight is 100% given to a second phase. When the amplifier circuit responds at a sufficiently high speed, a phase interpolated between the two input phases becomes the output phase.

As the phase-combining circuit of the present invention can cover 0 to 360 degrees as the phase output range, the output phase of the phase-combining circuit does not need to be in between the two input phases. Accordingly, it is possible to use the phase-combining circuit that is not limited to the interpolator.

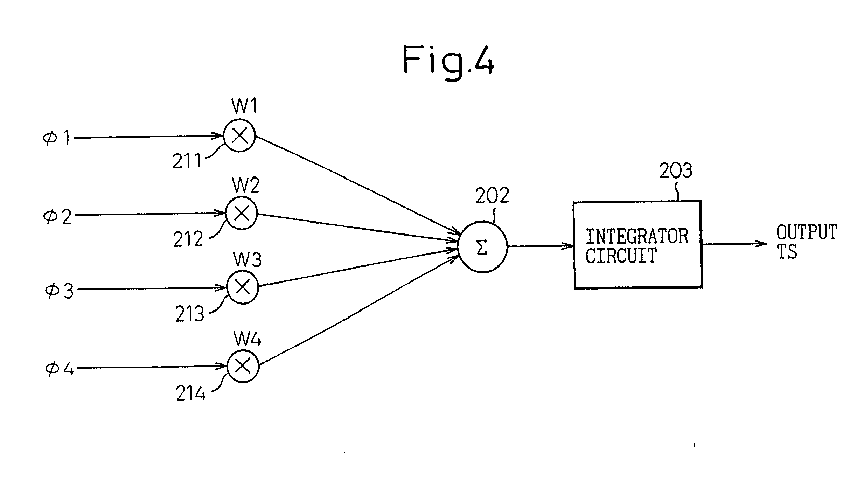

Fig. 4 is a diagram for explaining a modification of the principle of the phase-combining circuit shown in Fig. 2. In Fig. 4, reference numbers 211 to 214 denote multipliers, 202 denotes an adder, and 203 denotes an integrator circuit.

The phase-combining circuit (timing signal generator circuit) of the present invention can be structured as an integration-type phase-combining circuit that uses the integrator circuit 203 in place of the amplifier circuit that has been used in the conventional phase interpolator, as shown in Fig. 4. According to this integration-type phase-combining circuit, the multipliers 211 to 214 give weights W1 to W4 to respective input phases (input signals) $\phi1$ to $\phi4$. The adder 202 adds up the four weighted input phases (W1*$\phi1$, W2*$\phi2$, W3*$\phi3$, and W4*$\phi4$), and obtains the sum of the weighted phases (W1*$\phi1$ + W2*$\phi2$ + W3*$\phi3$ + W4*$\phi4$). Then, the integrator circuit 203 integrates this sum of the weighted phases to combine the phases, thereby producing an output TS. For actual application, it may be so structured that a multi-input integrator circuit that can give different weights to individual input phases is used to obtain a weighted integration sum.

When the input is a square wave, an integration waveform corresponding to this is a triangular wave. Therefore, there are advantages in the modification of the principle of the phase combination that it is possible to obtain a linear phase change by giving a linear weight to input phases and that it is possible to obtain high linearity even if there is a large phase difference between the input phases.

As described above, the timing signal generator circuit of the present invention has an advantage in that it is possible to obtain the whole phase range from 0 to 360 degrees based on inputs of a small number of phases. Therefore, it is not necessary to distribute a large number (for example, twelve phases) of clocks to each circuit (interpolator) while keeping a mutual phase relationship. Further, it is not necessary to provide a circuit for selecting an input phase. Therefore, it is possible to avoid an occurrence of a phase error attributable to a selecting circuit.

Embodiments of the phase-combining circuit and the timing signal generator circuit relating to the present invention will be explained in detail with reference to the drawings.

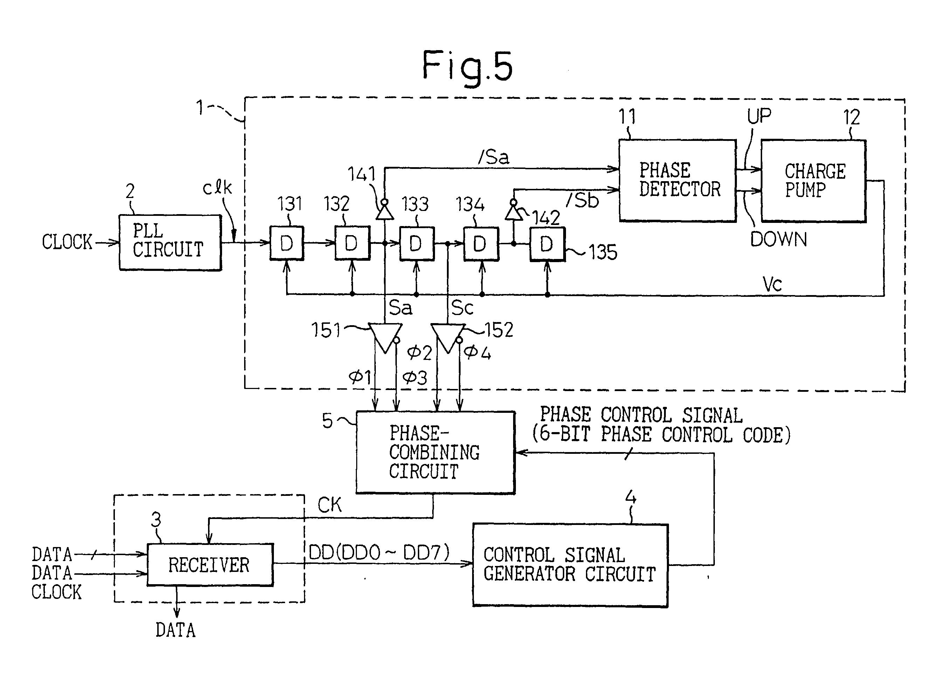

Fig. 5 is a block diagram showing a first embodiment of the timing signal generator circuit relating-to the present invention. In Fig. 5, a reference number 1 denotes a four-phase clock generator circuit, 2 denotes a PLL circuit, 3 denotes a receiver, 4 denotes a control signal generator circuit, and 5 denotes a phase-combining circuit (weighting circuit). Further, a reference number 11 denotes a phase detector, 12 denotes a charge pump, 131 to 135 denote delayed stages, 141 and 142 denote inverters, and 151 and 152 denote differential buffers. The first embodiment provides the timing signal generator circuit that generates a clock for the signal reception circuit (receiver 3) and that generates a receiver driving clock (timing signal) CK synchronous with a clock (data clock) that has been transmitted to the receiver 3 together with data.

As shown in Fig. 5, the timing signal generator circuit of the first embodiment is constructed of the four-phase clock generator circuit that receives a reference clock clk synchronous with a clock supplied from the outside of the chip via the PLL circuit 2, the control signal generator circuit 4, and the phase-combining circuit 5.

The output signal (timing signal) CK of the phase-combining circuit 5 is supplied to the receiver 3, for example, and the transmitted data is received. The receiver 3 compares the phase of the data clock supplied from the outside with the phase of the internal clock

(the output of the timing signal generator circuit) CK. The receiver then feeds back a signal according to a result of the phase comparison to the phase-combining circuit 5 via the control signal generator circuit 4. As described above, the receiver 3 (signal reception circuit) is only one example, and the timing signal generator circuit of the present embodiment can also be applied to other various circuits (for example, a driver, a signal transmission circuit). While the output (reference clock clk) of the PLL circuit 3 is a single-phase signal in the first embodiment, it is also possible to structure such that the output signal is a differential (complementary) signal.

The four-phase clock generator circuit 1 is structured in a PLL, which is constructed of the delayed stages 131 to 135, the phase detector 11, the charge pump 12, the inverters 141 and 142, and the differential buffers 151 and 152. The phase detector 11 sets a phase difference between a phase of a signal /Sa that is an output signal Sa of the delayed stage 132 inverted by the inverter 141 and a phase of a signal /Sb that is an output signal Sb of the delayed stage 134 inverted by the inverter 142, to 180 degrees (n). In other words, the phase detector 11 outputs to the charge pump control signals (an up signal UP and a down signal DOWN) according to a difference between the phase of the signal /Sa (Sa) and the phase of the signal /Sb (Sb), and sets this phase difference to 180 degrees.

The charge pump 12 generates a control voltage Vc according to the up signal UP and the down signal DOWN from the phase detector 11, and applies this control voltage to the delayed stages 131 to 135. Thus, the charge pump 12 controls the difference between the phase of the signal Sa and the phase of the signal Sb so that this phase difference accurately becomes 180 degrees. With this arrangement, the difference between the phase of the output signal Sa of the delayed stage 132 and the phase of the output signal Sc of the delayed stage 133 can be accurately set to 90 degrees. The delayed stages 131 and 132 are for shaping the waveform of the reference clock clk. The delayed stage 135 is for giving a suitable load to the output of the delayed stage 134.

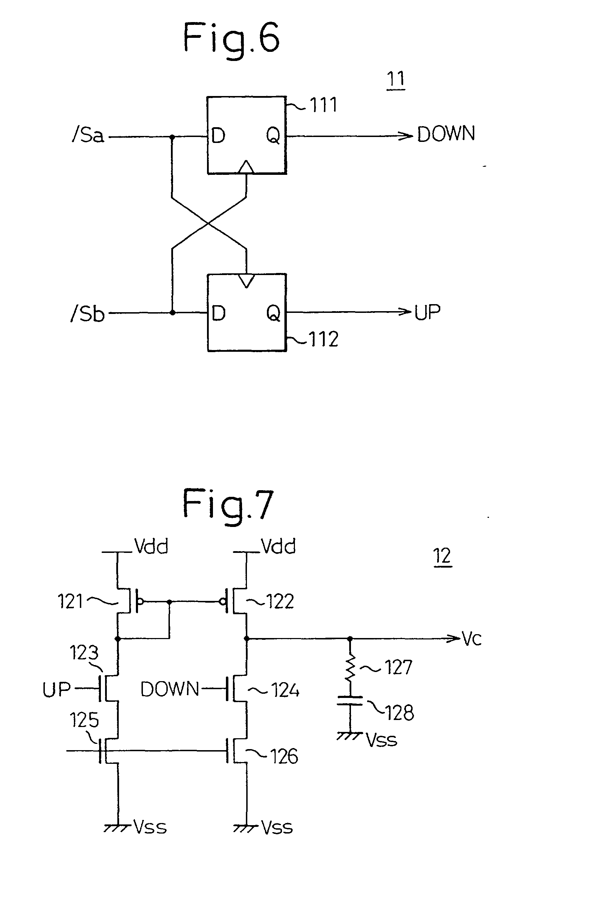

Fig. 6 is a circuit diagram showing one example of the phase detector 11 in the four-phase clock generator circuit 1 of the timing signal generator circuit shown in Fig. 5. ,

As shown in Fig. 6, the phase detector 11 is constructed of two latches 111 and 112. The latch 111 having the inverted output /Sb of the delayed stage 134 as a trigger takes in the inverted output /Sa of the delayed stage 132. Further, the latch 112 having the inverted output /Sa of the delayed stage 132 as a trigger takes in the inverted output /Sb of the delayed stage 134. The phase detector 11 generates the down signal DOWN and the up signal UP as the outputs of the latches 111 and 112 respectively, and supplies these signals to the charge pump 12.

Fig. 7 is a circuit diagram showing one example of a charge pump in the four-phase clock generator circuit 1 of the timing signal generator circuit shown in Fig. 5.

As shown in Fig. 7, the charge pump 12 is constructed of p-channel MOS transistors (p-MOS transistors) 121 and 122, n-channel MOS transistors (n-MOS transistors) 123 to 126, a resistor 127, and a capacitor 128. The charge pump 12 receives the up signal UP and the down signal DOWN as the outputs of the phase detector 11 by the pair of differential transistors 123 and 124 respectively, and outputs the control voltage Vc. The control voltage Vc is applied to all the delayed stages 131 to 135 to control the delay volume of each delayed stage.

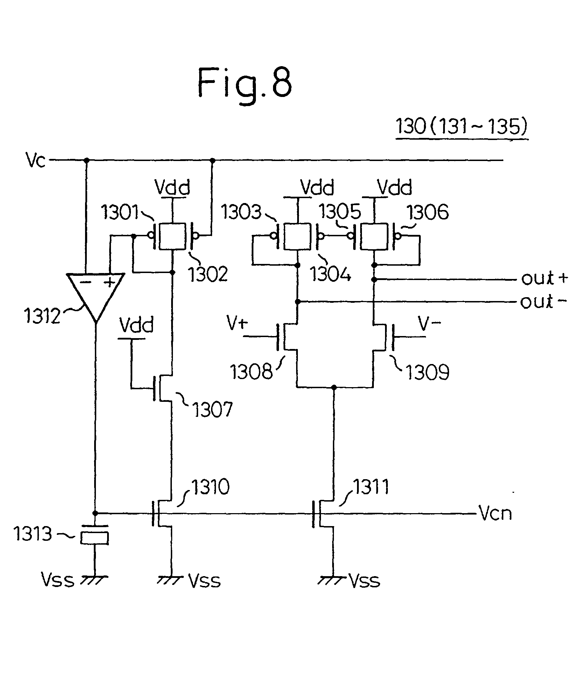

Fig. 8 is a circuit diagram showing one example of a delayed stage 130 (131 to 135) in the four-phase clock generator circuit 1 of the timing signal generator circuit shown in Fig. 5.

As shown in Fig. 8, the delayed stage 130 is constructed of p-MOS transistors 1301 to 1306, n-MOS transistors 1307 to 1311, a differential amplifier 1312, and a load 1313. The control voltage Vc is applied to a negative load of the differential amplifier 1312, and is also applied to a gate of the transistor 1302. A positive input of the differential amplifier 1312 is connected to a common connection node of a gate and a drain of the transistor 1301 provided in parallel with the transistor 1302. A reference number Vcn denotes a bias voltage of the transistors 1310 and 1311, V+(V-) denotes an input signal (an output of the preceding delayed stage (PLL circuit)), and out+(out-) denotes an output signal (an input to the next delayed stage).

As described above, the signals Sa and Sc that have a correct phase difference of 90 degrees are supplied to the differential buffers 151 and 152 respectively, so that the differential buffers 151 and 152 produce four-phase clocks φ1 to φ4 each having a phase difference of 90 degrees between adjacent clocks.

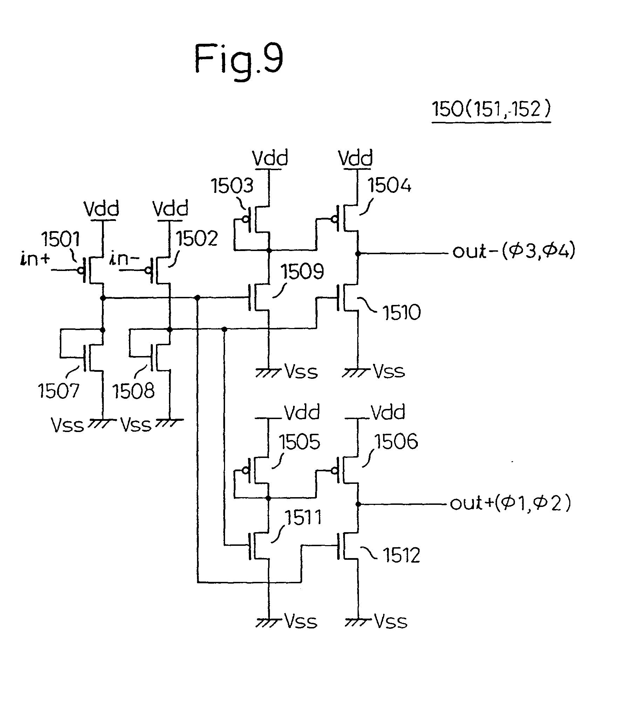

Fig. 9 is a circuit diagram showing one example of a differential buffer 150 (151, 152) in the four-phase clock generator circuit 1 of the timing signal generator circuit shown in Fig. 5.

As shown in Fig. 9, the differential buffers 151 and 152 are constructed of p-MOS transistors 1501 to 1506 and n-MOS transistors 1507 to 1512 respectively, to generate the signals φ1, φ3 (φ2, φ4) having a phase difference of 180 degrees from the signal Sa (Sc).

The four-phase clock generator circuit 1 generates the four-phase clocks φ1 to φ4 each having a phase difference of 90 degrees between adjacent clocks, in the manner as described above, and supplies them to the phase-combining circuit 5.

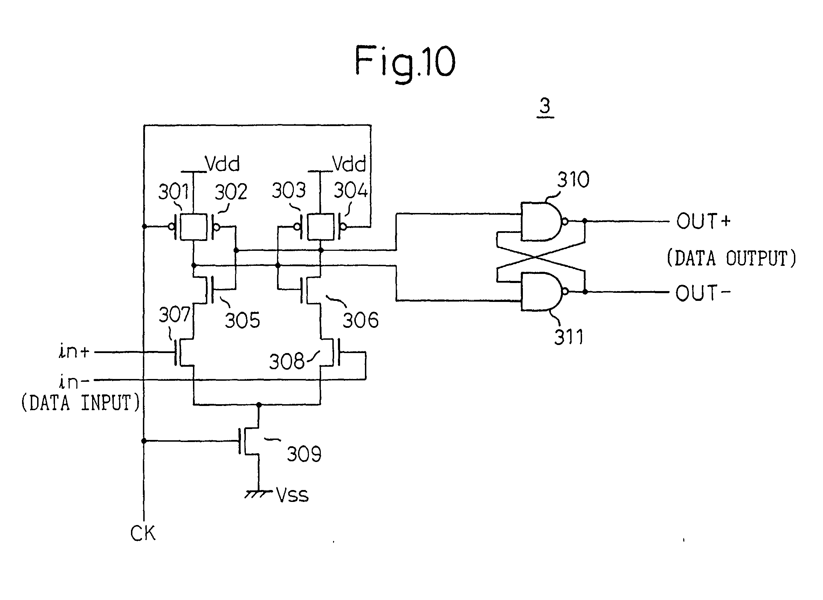

Fig. 10 is a circuit diagram showing one example of the receiver 3 in the timing signal generator circuit shown in Fig. 5.

At a rise of the clock (internal clock CK), a decision is made about data input (in+, in-). The receiver 3 has a phase comparator similar to that for receiving data (decision), and the phase comparator decides a phase relationship between the internal clock CK and the data clock. Then, the receiver 3 feedback-controls the internal clock CK via the control signal generator circuit 4 and the phase-combining circuit 5 as described later. -

As shown in Fig. 10, the receiver 3 is constructed of p-MOS transistors 301 to 304, n-MOS transistors 305 to 309, and NAND gates 310 and 311. Data (differential signals in+ and in-) that have been transmitted are supplied to differential inputs (gates of the transistors 307 and 308), and are driven (decided) by the internal clock (output of the timing signal generator circuit) CK. Data (OUT+ and OUT-) are output via the latch circuits (NAND gates 310 and 311). When the internal clock CK is at a low level "L", the transistors 301 and 304 are turned on and the transistor 309 is turned off, so that a pre-charging is carried out.

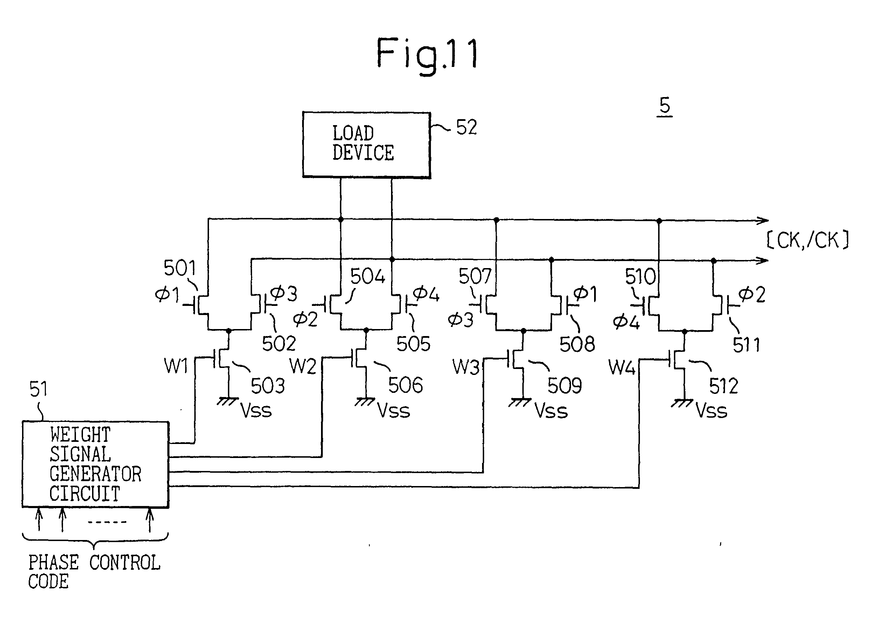

Fig. 11 is a circuit diagram showing one example of the phase-combining circuit 5 in the timing signal generator circuit shown in Fig. 5.

As shown in Fig. 11, the phase-combining circuit 5 is constructed of pairs of differential transistors 501, 502, 504, 505, 507, 508, 510 and 511 supplied with clocks (input phases) φ1, φ3, φ2, φ4, φ3, φ1, φ4, φ2 respectively, transistors 503, 506, 509 and 512 supplied with weights (weight signals) W1, W2, W3 and W4 at gates respectively, a weight signal generator circuit 51 for generating the weight signals W1 to W4, and a load device 12 connected in common to each of the pairs of differential of transistors.

More specifically, phase control codes are supplied from the control signal generator circuit 4 to the weight signal generator circuit 51. The weight signal generator circuit 51 generates the weight signals W1 to W4 corresponding to the phase control signals. These weight signals W1, W2, W3 and W4 are supplied to the gates of the transistors 503, 506, 509 and 512 , so that currents proportional to the weight signals flow.

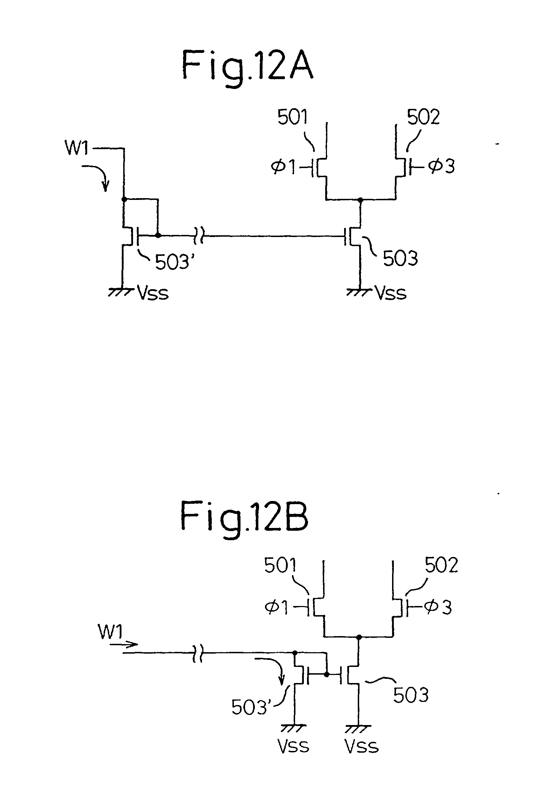

Fig. 12A and Fig. 12B are diagrams for explaining a method of giving a weight in the control signal generator circuit shown in Fig. 11. Fig. 12A and Fig. 12B show the transistor 503 and the pair of differential transistors 501 and 502 that are supplied with the weight W1 to their gates respectively. The rest of the weights W2, W3 and W4 are also given in a similar manner.

The weight W1 (W1 to W4) is given as an output current of a D/A converter for digital-to-analog converting a control code, for example. This current (weight) W1 flows to a diode-connected transistor 503'. A gate voltage same as that of the transistor 503' is applied to the transistor 503 to give the weight (the current W1 flows). Fig. 12A shows a state that the transistor 503' is provided in the weight signal generator circuit 51. However, when the weight signal generator circuit 51 and the transistor 503 (506, 509, 512) that gives the weight are separated and a ground voltage (Vss) is not the same, the transistor 503' may be provided adjacent to the transistor 503, as shown in Fig. 12B.

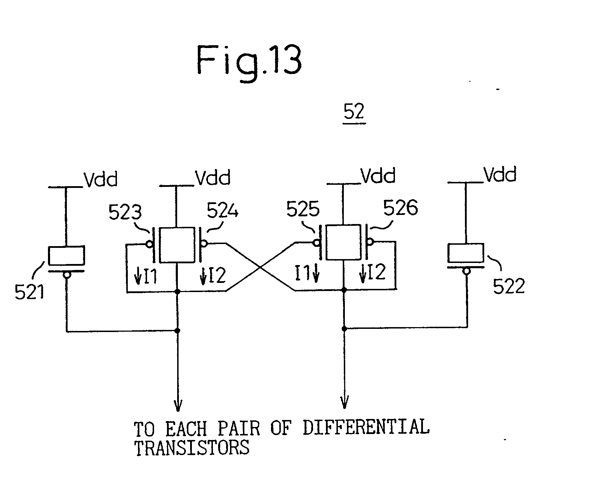

Fig. 13 is a circuit diagram showing one example of a load device 52 in the phase-combining circuit 5 shown in Fig. 11.

As shown in Fig. 13, the load device 52 in the phase-combining circuit 5 is constructed of capacitors (MOS capacitor) 521 and 522 and p-MOS transistors 523 to 526. The integration capacitor (521 and 522) are added to the cross-coupled p-MOS loads (523 to 526) having a differential impedance in high resistance. As a constant current (I1 + I2) flows to each pair of differential transistors, the cross-coupled p-MOS load shows a high impedance for a differential signal. However, the cross-coupled p-MOS load shows a low impedance for an in-phase signal. Therefore, it is possible to prevent a common-mode voltage from drifting to a high level or a low level without the need for providing a common-mode feedback circuit. There may be provided only one load device (integration load device) for four input pairs of differential transistors for an equivalent circuit. However, depending on the convenience of the layout, four load devices of the same sizes may be connected in parallel.

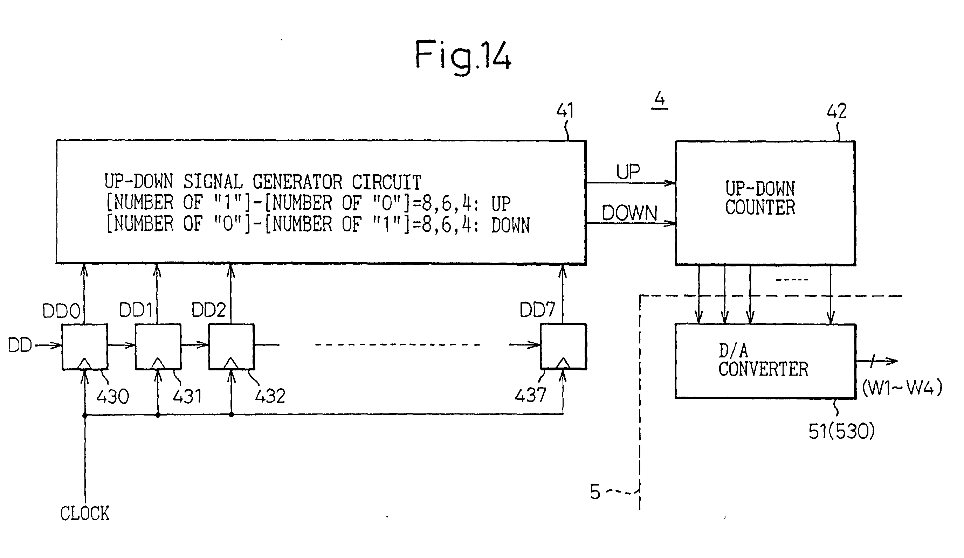

Fig. 14 is a block circuit diagram showing one example of the control signal generator circuit 4 in the timing signal generator circuit shown in Fig. 5. In Fig. 14, a reference number 41 denotes an up-down signal generator circuit, 42 denotes an up-down counter, and 430 to 437 denote registers. A reference number 530 denotes the weight signal generator circuit 51 (D/A converter) in the phase-combining circuit 5.

The timing signal generator circuit of the present embodiment is for generating a receiver driving clock (internal clock CK) synchronous with the data clock that has been transmitted to the receiver 3 together with the data. A phase comparator compares the phase of the data clock with the phase of the internal clock CK. The phase comparator is one similar to that for receiving data (decision). By driving a decision circuit with the internal clock CK, a phase relationship (an advance or a delay: DD) between the internal clock CK and the data clock is decided.

An advance or delay DD is sequentially stored in eight registers 430 to 437, for example, and results of decisions DD0 to DD7 for eight cycle clocks are taken into the up-down signal generator circuit 41. The up-down signal generator circuit 41 generates an up signal UP and a down signal DOWN based on a difference of numbers of "1" and "0" of each of the results of decisions DD0 to DD7.

In other words, when a difference between the numbers of decisions of an advance and a delay is two or less, neither an up signal UP nor a down signal DOWN is issued. When a decision has been made that at least three internal phases have advanced, an up signal UP is issued to increase the phase of the internal clock CK (in this case, a delaying is defined as an increase in phase). On the other hand, when a decision has been made that at least three data clocks have advanced more than the internal clock CK, a down signal DOWN is issued. More specifically, when the [number of "1"] minus the [number of "0"] is 8, 6 or 4, an up signal UP is output. On the other hand, when the [number of "0"] minus the [number of "1"] is 8, 6 or 4, a down signal DOWN is output. When a difference between the [number of "1"] and the [number of "0"] is 2 or 0, neither an up signal UP nor a down signal DOWN is output.

The up signal UP and the down signal DOWN are supplied to the up-down counter 42, and they are converted into control codes (for example, six bits). The control codes from the up-down counter 42 are supplied to the weight signal generator circuit 51 (D/A converter 530) in the phase-combining circuit 5. The D/A converter 530 may be structured as a look-up table of a ROM or the like to output the weight signals (W1 to W4) corresponding to the supplied control codes.

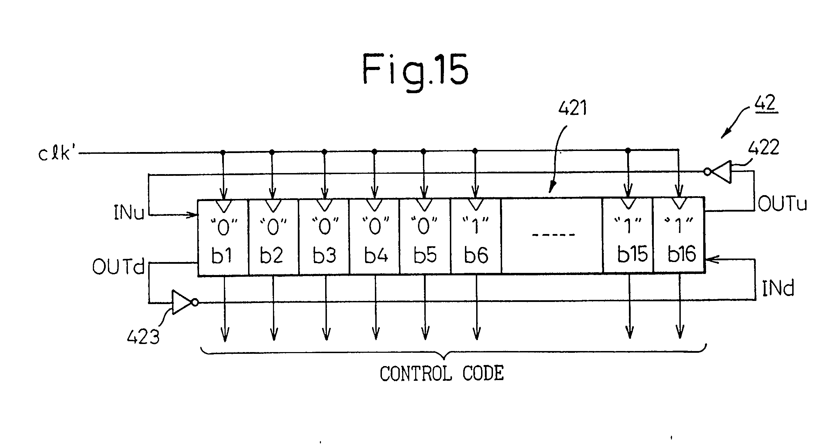

Fig. 15 is a block circuit diagram showing one example of the up-down counter 42 in the control signal generator circuit shown in Fig. 14. In Fig. 15, a reference number 421 denotes a shift register, and 422 and 423 denote inverters.

The up-down counter 42 shown in Fig. 15 is structured as a Johnson counter that is shift-controlled by a clock clk'. For example, out of 16-bit data from b1 to b16, at an initial state, the first half eight bits (b1 to b8) are set to "1" (high level "H"), and the latter half eight bits (b9 to b16) are set to "0" (low level "L"). When the up-down signal generator circuit 41 has input an up signal UP, the data of the bit b16 is inverted by an inverter 422, and is shifted to the right so that the inverted data is written into the bit 1. On the other hand, when the up-down signal generator circuit 41 has input a down signal DOWN, the data of, the bit b1 is inverted by an inverter 423, and is shifted to the left so that the inverted data is written into the bit 16. Fig. 15 shows an example that the bits b1 to b5 are "1" and the bits b6 to b16 are "0".

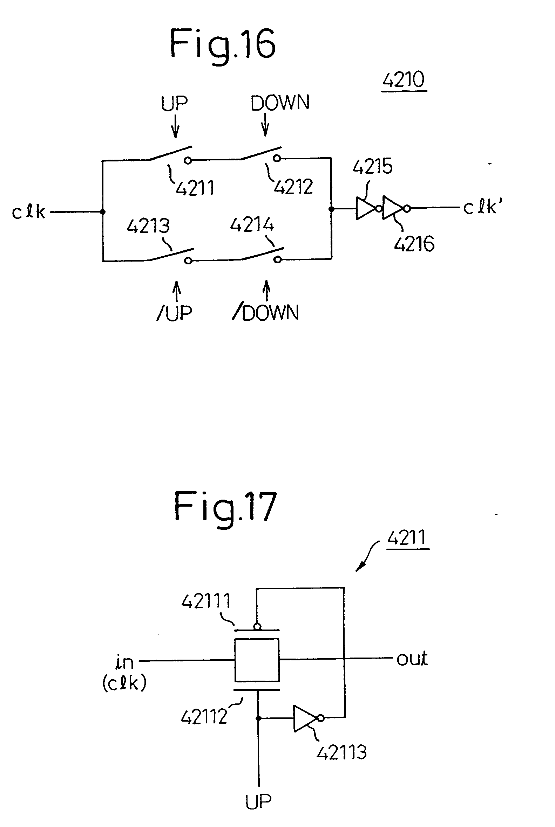

Fig. 16 is a circuit diagram showing one example of a clock generator circuit 4210 for supplying a clock signal to the up-down counter shown in Fig. 15.

As shown in Fig. 16, the clock clk' to be used in the shift register 421 can be constructed of a switch 4211 that is controlled by an up signal UP, a switch 4212 that is controlled by a down signal DOWN, a switch 4213 that is controlled by an inverted up signal /UP, a switch 4214 that is controlled by an inverted down signal/DOWN, and inverters 4215 and 4216.

Fig. 17 is a circuit diagram showing an example of a structure of the switch4211 in the clock generator circuit shown in Fig. 16.

As shown in Fig. 17, the switch 4211 is structured by a transfer gate consisting of a p-MOS transistor 4211, an n-MOS transistor 42112, and an inverter 42113. When the up signal UP is at the high level "H", the switch 4211 is turned on. Other switches 4212 to 4214 also have a similar structure.

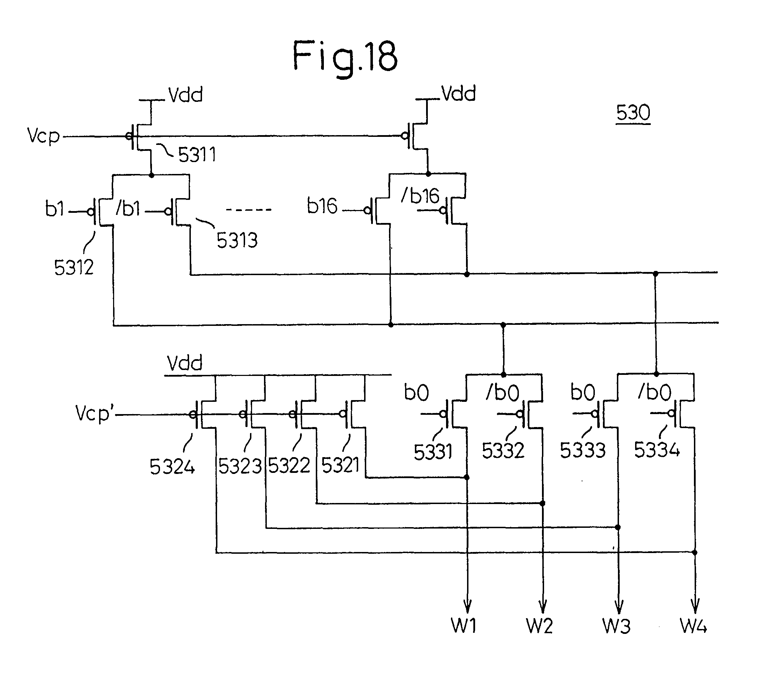

Fig. 18 is a circuit diagram showing one example of the D/A converter shown in Fig. 14.

As shown in Fig. 18, the D/A converter 530 (51) analog-to-digital converts complementary control codes b1, /bi to b16 and /b16 to output four weights (currents) W1 to W4. For example, the control codes b1 and /b1 are supplied to the gates of the p-MOS transistors 5312 and 5313, and other codes b2, /b2 to b16 and /b16 are also supplied to gates of similar transistors. Currents that flow through these transistors are added up and they are output as the weights (currents) W1 to W4 via the transistors 5331 to 5334.

A bias voltage Vcp is applied to the gate of the transistor 5311. The bias voltage is also applied to other corresponding transistors. A bias voltage Vcp' is applied to the gates of the transistors 5321 to 5324 respectively. The transistors 5321 to 5324 add predetermined bias currents to the weights W1 to W4 to ensure the operation of the circuit that gives the weights. The transistors 5331 to 5334 that control currents based on the control codes b1, /b1 to b16 and /b16 and output the weights W1 to W4 are further controlled by other control codes (weight selection control signals) b0 and /b0.

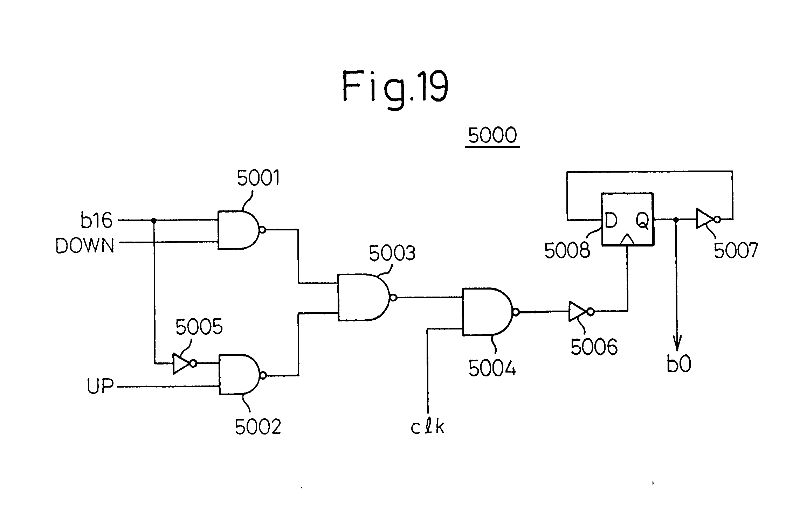

Fig. 19 is a circuit diagram showing one example of a circuit for generating a weight selection control signal to be used in the D/A converter shown in Fig. 18.

As shown in Fig. 19, a circuit 5000 for generating the weight selection control signal b0 (/b0) is constructed of NAND gates 5001 to 5004, inverters 5005 to 5007, and a flip-flop 5008. Based on this structure, the circuit 5000 generates the weight selection control signal b0 from a control code b16, an up signal UP, a down signal DOWN and a clock clk.

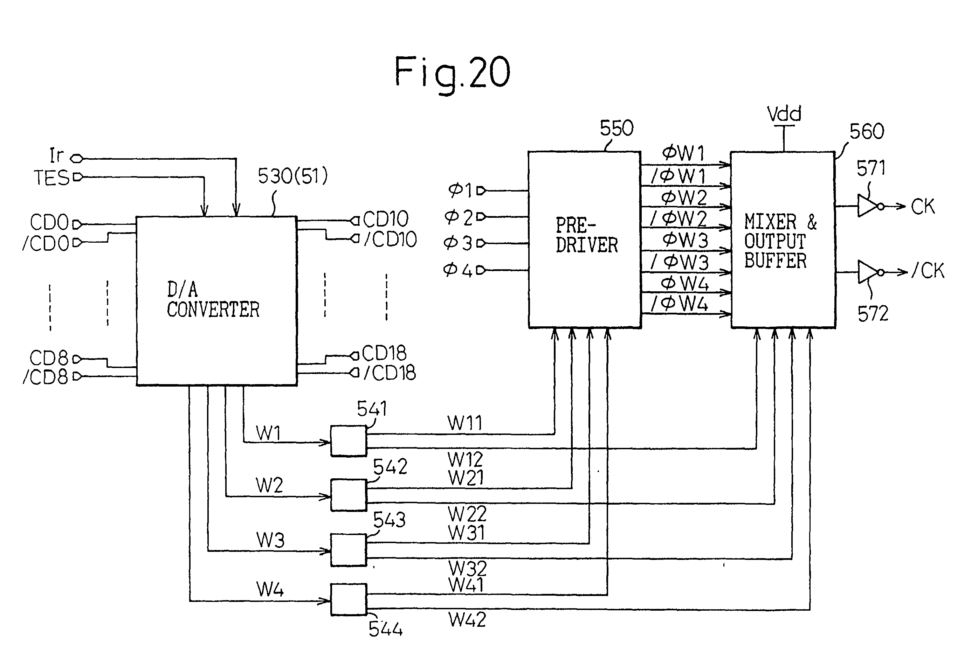

Fig. 20 is a block circuit diagram showing one example of a phase-combining circuit as a second embodiment of the timing signal generator circuit relating to the present invention. In Fig. 20, a reference number 530 denotes a D/A converter, 541 to 544 denote weight processing circuits, 550 denotes a pre-driver, and 560 denotes a mixer and output buffer.

As shown in Fig. 20, the phase-combining circuit 5 is constructed of the D/A converter 530, the weight processing circuits 541 to 544, the pre-driver 550, the mixer and output buffer 560, and inverters 571 and 572.

The D/A converter 530 is applied with inputs of a reference current Ir and a plurality of control codes such as, for example, complementary 18-bit control codes CDO, /CDO to CD8 and /CD8, and CD10, /CD10 to CD18 and /CD18. The D/A converter 530 then outputs four weights (currents) W1 to W4 corresponding to these control codes. A reference symbol TES denotes a testing signal that is used for testing a circuit. The weight processing circuits 541 to 544 receive the weights W1 to W4, and produces outputs (W11 to W41) for the pre-driver 550 linked to these weights W1 to W4 and outputs (W12 to W42) for the mixer and output buffer 560.

The pre-driver 550 receives different input phases (such as, for example, four-phase input signals each having a 90-degree phase difference between adjacent phases) $\phi$1 to $\phi$4, and the weight signals W11 to W41 for the pre-driver, and outputs adjusted input phases (input signals of different phases) $\phi$W1, /$\phi$W1 to $\phi$W4 and $\phi$W4. The mixer and output buffer 560 receives the weight signals W12 to W42 for the mixer and output buffer, and the adjusted input phases $\phi$W1, /$\phi$W1 to $\phi$W4 and /$\phi$W4 from the pre-driver 550, and outputs the internal clocks (timing signals) CK and /CK via the inverters 571 and 572.

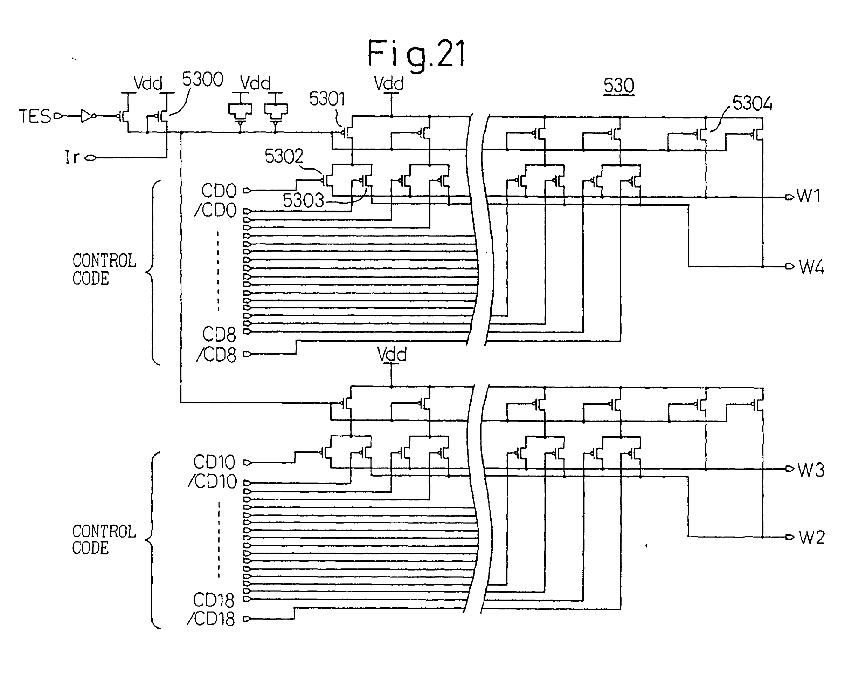

Fig. 21 is a circuit diagram showing one example of the D/A converter 530 in the phase-combining circuit shown in Fig. 20.

As shown in Fig. 21, the D/A converter 530 is constructed of a p-MOS transistor 5300 to which the reference current Ir flows, a p-MOS transistor 5301 that is current-mirror-connected with the transistor 5300, and switch p-MOS transistors 5302 and 5303 to which the control codes (CD0 and /CD0) have been supplied at their gates. The transistors 5301 to 5303 are provided for each complementary control code (CD0, /CD0; CD1, /CD1; --- CD8, /CD8, and CD10, /CD10; CD11, /CD11;-CD18, /CD18). In Fig. 21, the p-MOS transistor 5304 that is current-mirror-connected with the transistor 5300 gives a bias current to the weight (current) W1.

In the manner as described above, the D/A converter 530 digital-to-analog converts the control codes CD0, /CD0 to CD8 and /CD8, and CD10, /CD10 to CD18 and /CD18, and outputs the weights (currents) W1 to W4.

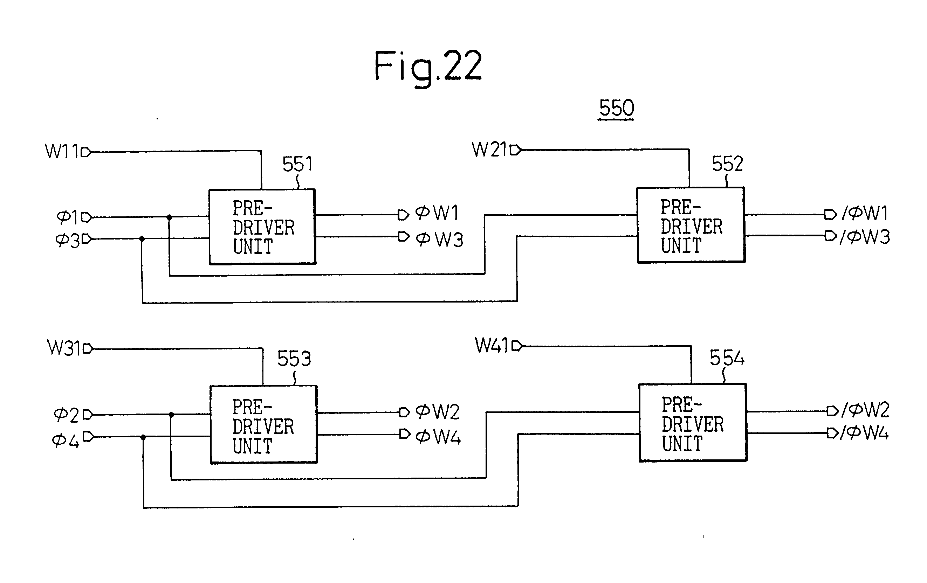

Fig. 22 is a block circuit diagram showing one example of the pre-driver 550 in the phase-combining circuit shown in Fig. 20.

As shown in Fig. 22, the pre-driver 550 is constructed of a pre-driver unit 551 that receives the weight signal W11 for the pre-driver and the phase signals φ1 and φ3 and outputs the adjusted input phases (input signals of mutually different phases) φW1 and φW3, a pre-driver unit 552 that receives the weight signal W21 and the phase signals φ1 and φ3 and outputs the adjusted input phases /φW1 and /φW3, a pre-driver unit 553 that receives the weight signal W31 and the phase signals φ2 and φ4 and outputs the adjusted input phases φW2 and φW4, and a pre-driver unit 554 that receives the weight signal W41 and the phase signals φ2 and φ4 and outputs the adjusted input phases /φW2 and /φW4.

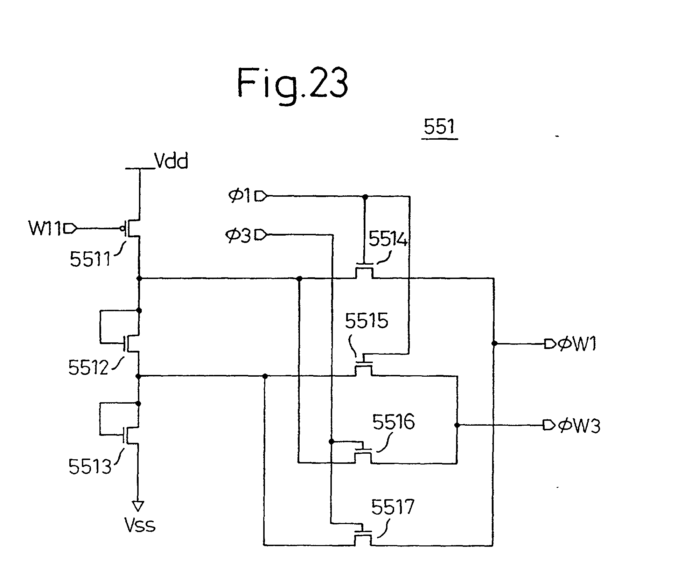

Fig. 23 is a circuit diagram showing one example of the pre-driver unit 551 in the pre-driver shown in Fig. 22.

As shown in Fig. 23, the pre-driver unit 551 is constructed of a p-MOS transistor 5511 and n-MOS transistors 5512 to 5517. The weight signal W11 for the pre-driver is supplied to the gate of the transistor 5511, and the phase signals φ1 and φ3 are supplied to the gates of the transistors 5514 and 5515 and the gates of the transistors 5516 and 5517 respectively. The pre-driver unit 551 takes out the adjusted input phase φW1 from a common source of the transistors 5514 and 5517, and takes out the adjusted input phase φW3 from a common source of the transistors 5515 and 5516. In other words, the adjusted input phases φw1 and φW3 are output with their amplitudes and DC levels adjusted so as to be suitable for a mixer section 561 in the mixer and output buffer to be described later. Other pre-driver units 552 to 554 are also structured to have a similar construction to that of the pre-driver unit 551 except their input and output signals.

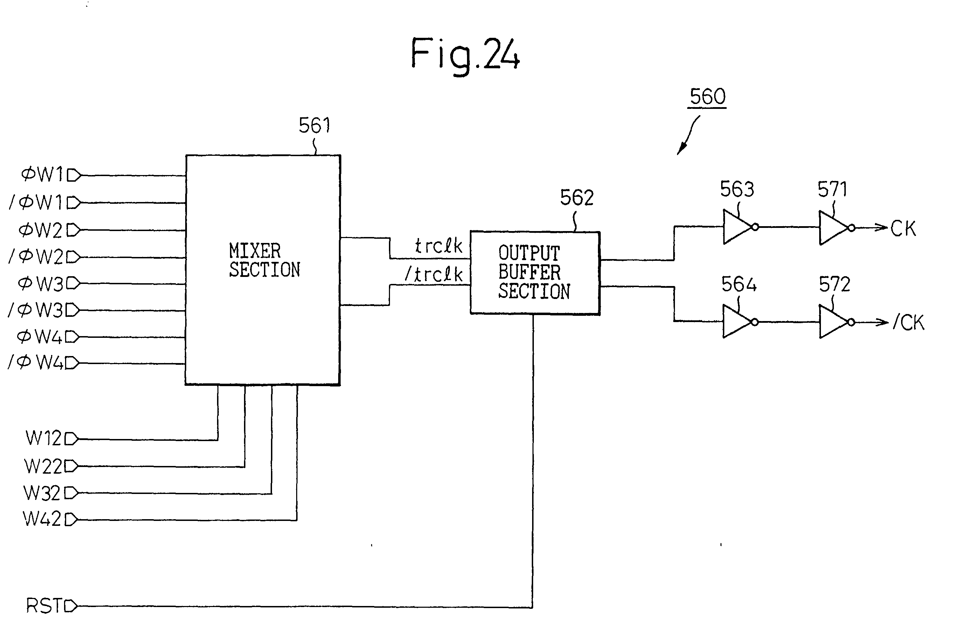

Fig. 24 is a block circuit diagram showing one example of the mixer and output buffer 560 in the phase-combining circuit shown in Fig. 20.

As shown in Fig. 24, the mixer and output buffer 560 is constructed of a mixer section 561, an output buffer section 562, and inverters 563 and 564. The mixer section 561 receives the adjusted input phases φW1, φW1 to φW4 and φW4, and the weight signals W12 to W42 for the mixer and output buffer, and supplies output signals trclk and /trclk to the output buffer section 562. The mixer section 561 adds (multiplies) the weight signals W12 to W42 to the input phases φw1, φW1 to φW4 and φW4, and sums up these weighted signals and integrates a result.

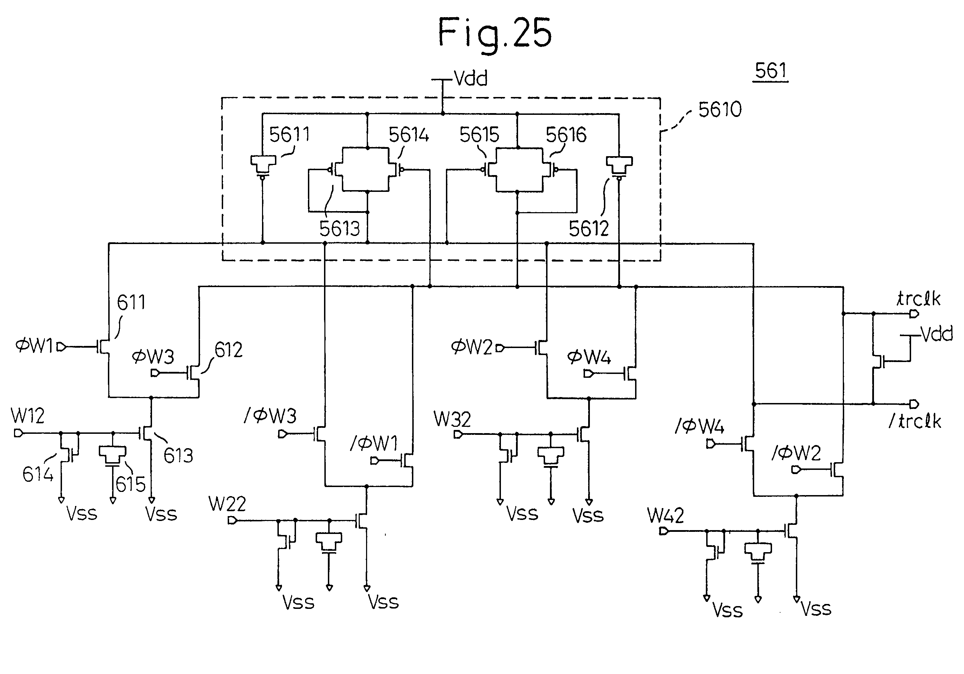

Fig. 25 is a circuit diagram showing one example of the mixer section 561 in the mixer and output buffer shown in Fig. 24.

As shown in Fig. 25, the mixer section 561 includes a load device 5610, a pair of differential transistors 611 and 612 that have been supplied at their gates with the adjusted input phases φw1 and φW3 from the pre-driver 550, and a transistor 613 that has been supplied at its gate with the weight signal W12 for the mixer and output buffer from the weight processing circuit 541. The gate (weight signal W12) of the transistor 613 is connected with the gate and the drain of the transistor 614 and one end of a MOS capacitor 615. The structures of the transistors 611 to 615 taken for the input phases φW1 and φW3 and the weight signal W12 are also provided in a similar manner for other input phases φW3 and φW1 and the weight signal W22, the input phases φW2 and φW4 and the weight signal W32, and the input phases φW4 and φW2 and the weight signal W42. The load device 5610 has a structure similar to that of the load device 52 explained with reference to Fig. 13. The load device 5610 is constructed of MOS capacitors 5611 and 5612, and p-MOS transistors 5613 to 5616.

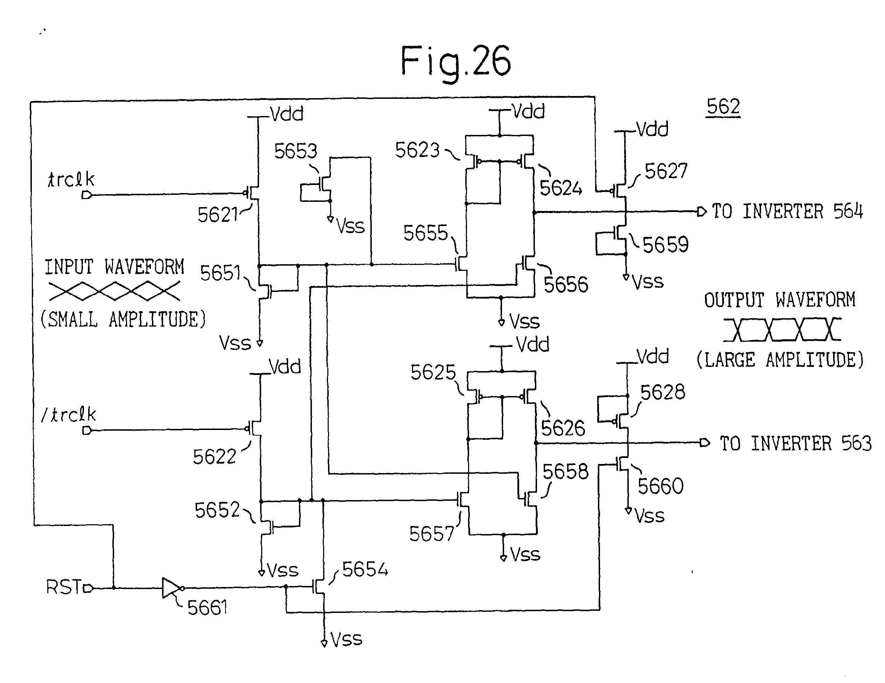

Fig. 26 is a circuit diagram showing one example of the output buffer section 562 in the mixer and output buffer shown in Fig. 24. This circuit is called a supply-insensitive buffer in which a delay is not much dependent on a power source voltage.

As shown in Fig. 26, the output buffer section 562 is constructed of p-MOS transistors 5621 to 5628, n-MOS transistors 5651 to 5660, and an inverter 5661. The output buffer section 562 amplifies an input signal of a small amplitude (trclk, /trclk), and produces an output signal of a large amplitude (full CMOS amplitude). A reference symbol RST denotes a reset signal. The reset signal RST is set to a low level "L" at the time of resetting the circuit.

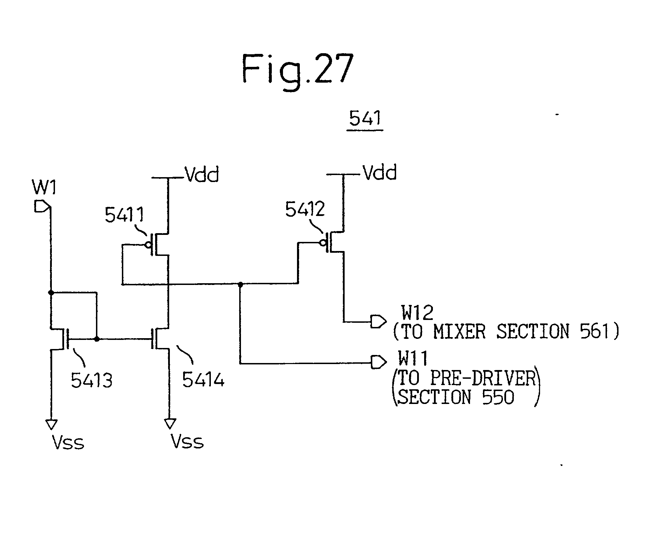

Fig. 27 is a circuit diagram showing one example of the weight processing circuit 541 in the phase-combining circuit shown in Fig. 20.

As shown in Fig. 27, the weight processing circuit 541 is constructed of p-MOS transistors 5411 and 5412, and n-MOS transistors 5413 and 5414. The weight processing circuit 541 processes the weight (current) W1 from the D/A converter 530, and produces a weight signal W11 (voltage) suitable for the pre-driver section 550 (gate input of the p-MOS transistor 5511 shown in Fig. 23), and a weight signal W12 (current) suitable for the mixer section 561 (common connection mode of the transistors 613 and 614 and the capacitor 615 shown in Fig. 25) of the mixer and output buffer.

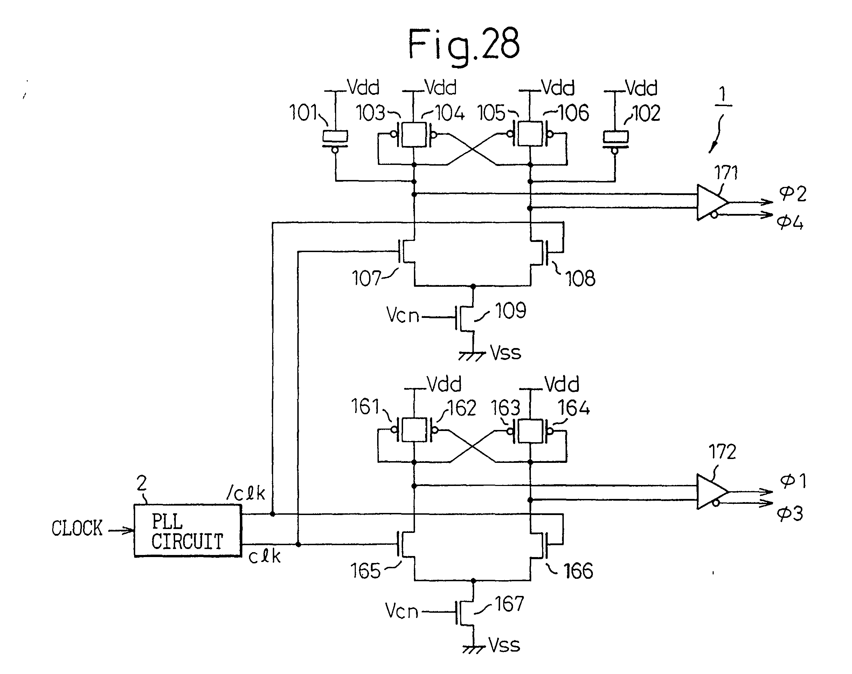

Fig. 28 is a circuit diagram showing another example of a four-phase clock generator circuit (reference number 1 in Fig. 5) in the timing signal generator circuit relating to the present invention.

As shown in Fig. 28, the four-phase clock generator circuit 1 for driving the phase-combining circuit 5 is constructed of a load device consisting of integrated capacitors 101 and 102 and cross-coupled p-MOS loads 103 to 106, a pair of differential amplifiers 107 and 108, a n-MOS transistor 109 that has applied to it a bias voltage Vcn at its gate, cross-coupled p-MOS loads 161 to 164, a pair of differential amplifiers 165 and 166, a n-MOS transistor 167 that has applied to it a bias voltage Vcn at its gate, and clock buffers 171 and 172.

In other words, the four-phase clock generator circuit 1 shown in Fig. 28 generates four signals (phases) φ1, φ2, φ3 and φ4 each having a 90-degree phase difference between adjacent phases, from differential reference clocks (clk and /clk) supplied from the PLL circuit 2. The four-phase clock generator circuit 1 generates the signals φ2 and φ4 that have phases of 90 degrees and 270 degrees respectively from the input phases (0 degree and its complement of 180 degrees) by using a 90-degree phase shifter using an integrator circuit. These phases φ1, φ2, φ3 and φ4 are regarded as differential four-phase signals, and an increase in the number of phase is defined as a direction in which a delay increases. The four-phase clocks can also be supplied directly from the PLL circuit.

The phase-combining circuit (refer to the phase-combining circuit 5 shown in Fig. 11 (refer to the pre-driver unit 551 shown in Fig. 23 and the mixer section 561 shown in Fig. 25)) has such a structure that the pairs of differential transistors 501 to 503 and 611 to 614 are provided for the four input phases φ1 to φ4 respectively, and tail currents of respective phase signals are controlled by the currents (W1 to W4; W11 to W41; and W12 to W42) supplied from the D/A converter (51; 530). -

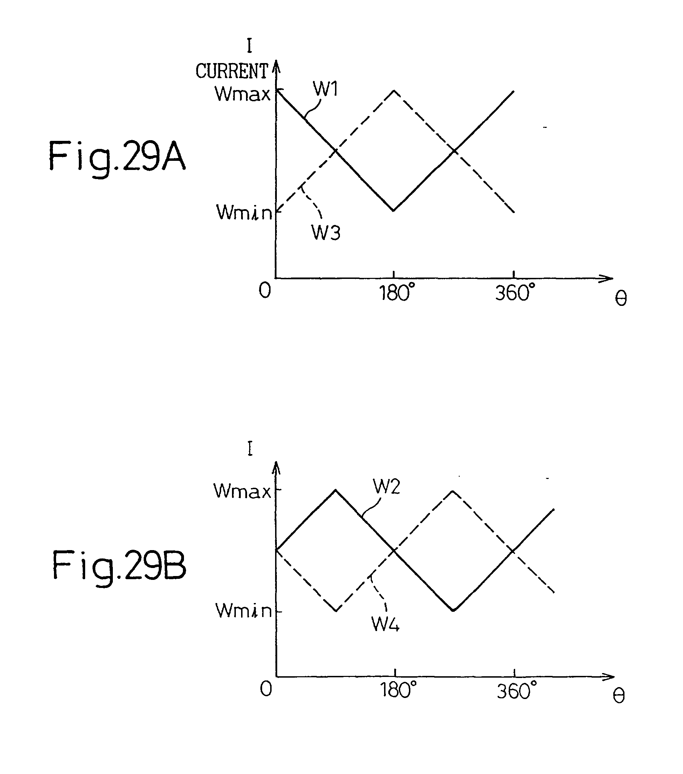

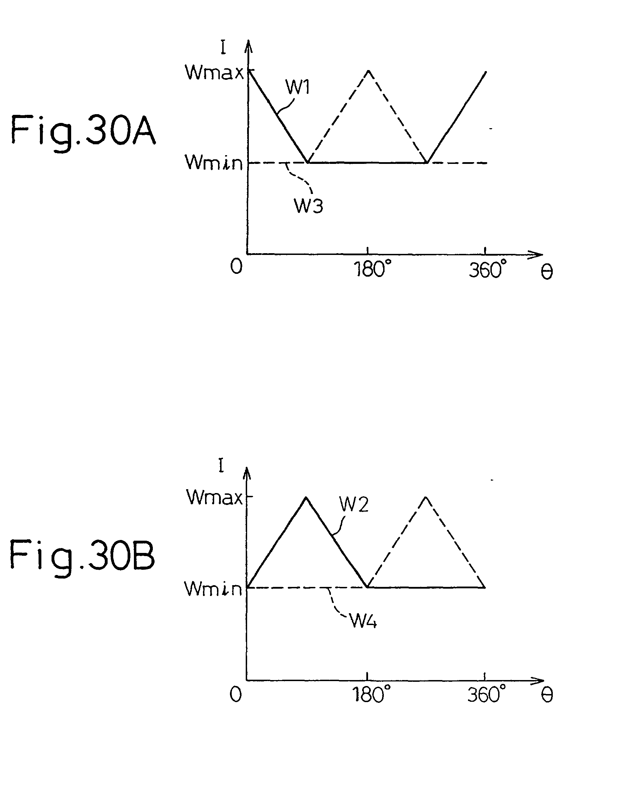

Fig. 29A and Fig. 29B are diagrams showing one example of a change in the weight in the timing signal generator circuit of the present invention. Fig. 30A and Fig. 30B are diagrams showing another example of a change in the weight in the timing signal generator circuit of the present invention. Fig. 29A and Fig. 30A show the weights W1 and W3, and Fig. 29B and Fig. 30B show the weights W2 and W4.

The weights W1 to W4 (output currents of the weight signal generator circuit 51 or the D/A converter 530) in the phase-combining circuit 5 change as shown in Fig. 29A and Fig. 29B, for example. A vertical axis I shows a current, and a horizontal axis θ shows an output phase of the phase-combining circuit. The output phase when the weight W1 takes a maximum value Wmax is the origin of the phase.

As shown in Fig. 29A and Fig. 29B, each weight Wn (W1 to W4) takes Wmax as a maximum value and Wmin as a minimum value. Each output phase takes a non-zero value (including a predetermined bias current). In other words, as explained with reference to Fig. 18, the weights (currents) W1 to W4 generated by the D/A converter 530 include a predetermined (Wmin) bias current according to the transistors 5321 to 5324.

Fig. 29A shows an example of triangular waves in which the phases of the weights W1 and W3 are inverted (deviated by 180 degrees). Fig. 29B shows an example of waveforms in which the phases of the weights W2 and W4 are delayed by 90 degrees from the weights W1 and W3 respectively.

Further, as shown in Fig. 30A and Fig. 30B, each weight Wn (W1 to W4) may be formed in a triangular wave with its lower half clamped.

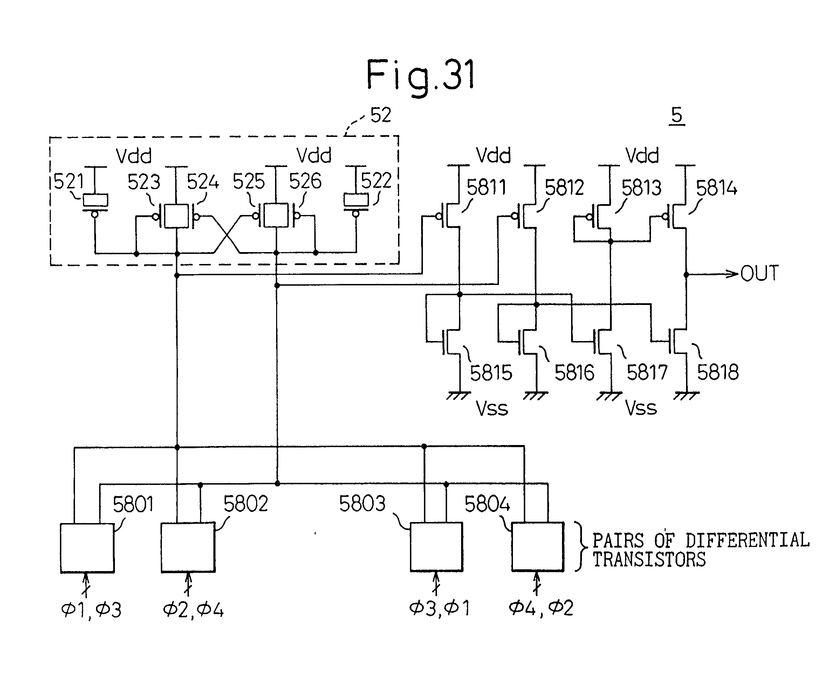

Fig. 31 is a block circuit diagram showing one example of a phase-combining circuit as a third embodiment of the timing signal generator circuit relating to the present invention. This shows a modification of the phase-combining circuit shown in Fig. 11. In the third embodiment, the load device 52 is similar to that shown in Fig. 11, and the pairs of differential amplifiers 5801 to 5804 correspond to the transistors 501, 502 to 510 and 511 shown in Fig. 11.

As shown in Fig. 31, the phase-combining circuit 5 of the present embodiment has an output buffer consisting of p-MOS transistors 5811 to 5814 and n-MOS transistors 5815 to 5818, in the phase-combining circuit shown in Fig. 11. This output buffer is a supply-insensitive buffer circuit in which a delay is not very dependent on a power source voltage Vdd. This circuit corresponds to the output buffer section 562 shown in Fig. 26 that amplifies a signal of a small amplitude and outputs a signal of a large amplitude.

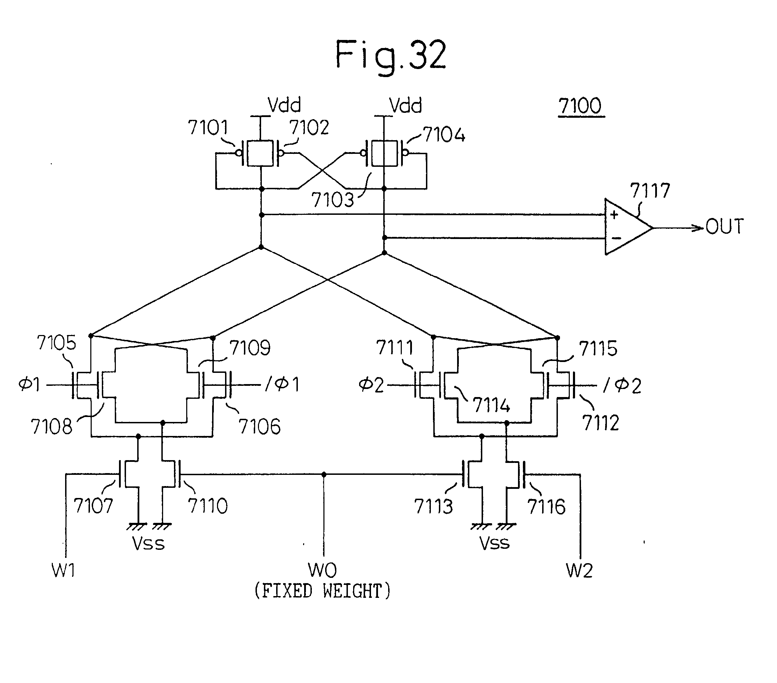

Fig. 32 is a circuit diagram showing one example of a phase-combining circuit as a fourth embodiment of the timing signal generator circuit relating to the present invention.

As shown in Fig. 32, a phase-combining circuit 7100 of the fourth embodiment uses two input phases φ1 and φ2, and is constructed of p-MOS transistors 7101 to 7104, n-MOS transistors 7105 to 7116, and a comparator (differential amplifier) 7117. The transistors 7105, 7106, 7108, 7109, 7111, 7112, 7114 and 7115 constitute pairs of differential amplifiers respectively. These transistors give the weight W1 to the gate of the transistor 7107, give the weight W2 to the gate of the transistor 7116, and give a fixed weight W0 to the gates of the transistors 7110 and 7113 respectively.

More specifically, according to the phase-combining circuit 7100 of the fourth embodiment, the four phases (φ1 to φ4: φ1, φ1 to φ4, φ4) are not input as in the phase-combining circuit 5 shown in Fig. 11, but the two phases (φ1, φ2: φ1, φ1, φ2, φ2) are input. These two phases are weighted with both polarities of positive and negative, thereby to obtain the outputs that cover the whole phase range from 0 to 360 degrees. It is also possible to give two phases of φ1 and φ2 to the phase-combining circuit 5 shown in Fig. 11 and to give weights having signs to these phases thereby to cover the whole phase range. However, since it is possible to give different weights to the four phases in the phase-combining circuit shown in Fig. 11, the input of the four phases has been assumed. On the other hand, in the case of the phase-combining circuit of the fourth embodiment, the input of two phases has been assumed, as there are only two weights that can be controlled. It is preferable that the phase signals φ1 and φ2 have a phase difference of 90 degrees. However, the phase signals can be used so long as their phases are deviated.

As shown in Fig. 32, the phase-combining circuit 7100 of the fourth embodiment has the pairs of differential transistors (7108 and 7109; 7111 and 7112) to which the fixed weight W0 has been supplied respectively, and the pairs of differential transistors (7105 and 7106; 7114 and 7115) to which the externally-controlled weights W1 and W2 have been supplied respectively. In this case, the pairs of differential transistors applied with the fixed weight and the pairs of differential transistors applied with the variable weights have their output lines mutually inverted. Therefore, the pairs of differential transistors supplied with the fixed weight give opposite polarity to the pairs of differential transistors applied with the variable weights. When the variable weight Wi (W1, W2) is smaller than the fixed weight W0, an effective weight (Wi - W0) takes a negative value. When the variable weight Wi (W1, W2) is larger than the fixed weight W0, an effective weight (Wi - W0) takes a positive value. The output (OUT) is given as an output of the comparator 7117.

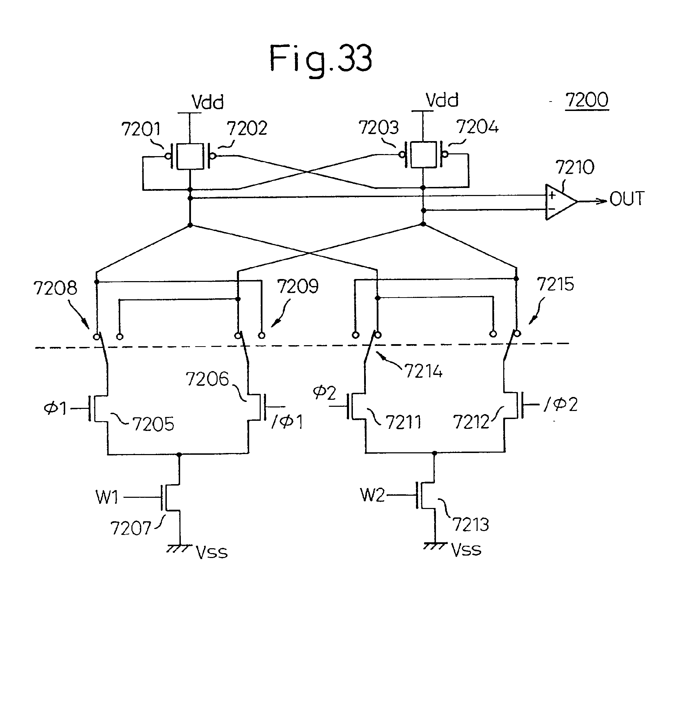

Fig. 33 is a circuit diagram showing one example of a phase-combining circuit as a fifth embodiment of the timing signal generator circuit relating to the present invention.

As shown in Fig. 33, a phase-combining circuit 7200 of the fifth embodiment uses two input phases φ1 and φ2 in a similar manner to that of the fourth embodiment. The phase-combining circuit 7200 is constructed of p-MOS transistors 7201 to 7204, n-MOS transistors 7205 to 7207 and 7211 to 7213, polarity switches 7208, 7209 and 7214, 7215, and a differential amplifier 7210. The transistors 7205, 7206 and 7211, 7112 constitute pairs of differential transistors respectively. The polarity switches 7208, 7209 and 7214, 7215 invert polarities of the pairs of differential transistors that give weights.

When a control code is a 6-bit code, for example, the control code may be so arranged that the upper two bits are for controlling the polarity switches 7208, 7209 and 7214, 7215, and other four bits are for controlling the weighting of the D/A converter 530. In other words, the polarity switches have weight-controlling digital values expressed in a signed binary, for controlling weights using the sign bits. The output (OUT) is given as an output of the differential amplifier 7210.

Unlike the conventional phase-combining circuit that uses a phase selector circuit, the phase-combining circuit 7200 of the fifth embodiment uses always one kind of clock signal (input phase φ1, /φ1;φ2, /θ2) that is input to the pairs of differential transistors. Therefore, there is no disturbance in the operation of the pairs of the differential transistors attributable to a phase selection. Further, when the phase-combining circuit is used in a clock synchronizing circuit, the phase value changes by every step based on the UP signal and the DOWN signal. Further, when the polarity of the weight changes inside the phase-combining circuit, the value of the weight is always zero. Therefore, the influence that the polarity inversion applies to the operation inside the phase-combining circuit is extremely small.

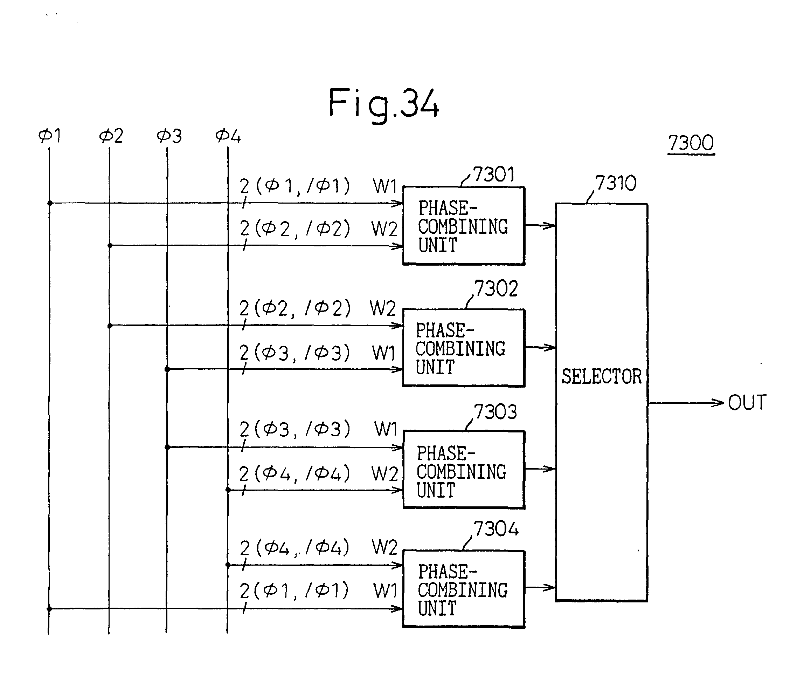

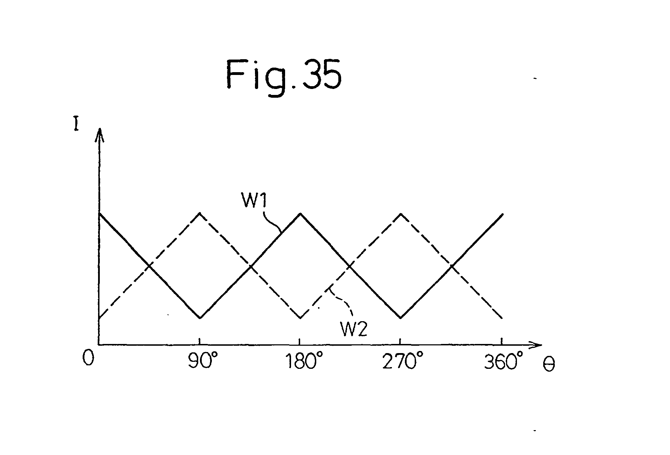

Fig. 34 is a circuit diagram showing one example of a phase-combining circuit as a sixth embodiment of the timing signal generator circuit relating to the present invention, and Fig. 35 is a diagram showing one example of a change in the weight in the phase-combining circuit shown in Fig. 34.

As shown in Fig. 34, the phase-combining circuit of the sixth embodiment is constructed of a plurality of (four) phase-combining units 7301 to 7304, and a selector 7310. The four phase-combining units 7301, 7302, 7303 and 7304 are for combining two input phases (φ1,φ2:φ1, /φ1;φ2, /φ2), (φ2,φ3), (φ3,φ4), and (φ4,φ1), based on the weights W1 and W2 respectively. Outputs of these four phase-combining units 7301 to 7304 are produced via the selector 7310. The weights W1 and W2 change as shown in Fig. 35, for example.

More specifically, one of outputs of the phase-combining units 7301 to 7304 is selectively produced according to a range of the control code. The phase-combining units 7301 and 7303 and the phase-combining units 7302 and 7304 operate in mutually completely opposite phase signals respectively. Therefore, it is also possible to structure the whole phase-combining circuit using only two phase-combining units by exchanging the polarities of the outputs.

According to a phase-combining circuit 7300 of the sixth embodiment, an input phase is supplied to each of the phase-combining units 7301 to 7304 without using a changeover switch or a selector circuit. Therefore, the signals input to the pairs of differential transistors are always completely cyclical signals of the same phase. As a result, there is no disturbance in the operation of the pairs of the differential transistors attributable to a phase selection.

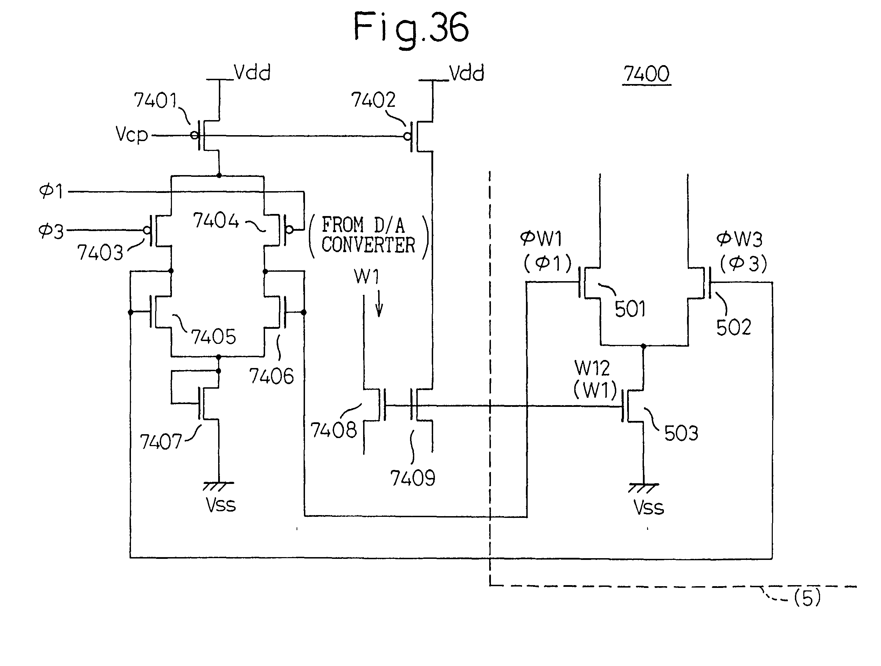

Fig. 36 is a circuit diagram showing one example of a pre-driver in a phase-combining circuit as a seventh embodiment of the timing signal generator circuit relating to the present invention. This shows an example of the pre-driver that gives signals (input phases φ1 and φ3, and the weight W1) to the pairs of differential transistors 501, 502 and 503 of the phase-combining circuit shown in Fig. 11.

In the weighting circuit (phase-combining circuit), clock signals (for example, input phases φ1 and φ3) for driving pairs of transistors that carry out the weighting have been in a constant amplitude irrespective of whether the signals are in a small amplitude or a large amplitude. In other words, the input phases (φ1 and φ3) supplied to the gates of the pairs of differential transistors have a constant amplitude regardless of the value of the weight (for example W1). Therefore, there has been a problem that a current waveform that appears in the output of the weighting circuit is not scaled in proportion to the weight. Further, when an input voltage that is larger than an input voltage sufficiently large for suitably carrying out a current steering of the pairs of differential transistors has been applied, a dead time occurs. During this dead time period, there is no change in the output currents of the pairs of differential transistors based on a change in the input. During this dead time period, the pairs of differential transistors operate as a switching device apart from a linear operation area. Therefore, there arises a time variation in the source voltage of the pairs of differential transistors, and a current waveform (wave) input to the phase-combining circuit does not become ideal. Further, the dead time period changes depending on the value of a weight. Therefore, the current wave used for combining phases is not scaled in proportion to the value of the weight. As a result, the linearity of the phase characteristic with respect to the control code is damaged.

A pre-driver 7400 of the seventh embodiment is, for example, suitable for processing and supplying the signals (input phases $\phi1$ and $\phi3$ and the weight W1) to the transistors 501, 502 and 503 in the phase-combining circuit shown in Fig. 11. As shown in Fig. 36, the pre-driver 7400 is constructed of p-MOS transistors 7401 to 7404 and n-MOS transistors 7405 to 7409. The transistors 7401 to 7409 are used for processing the signals (input phases $\phi1$ and $\phi3$ and the weight W1) to the transistors 501, 502 and 503 in the phase-combining circuit shown in Fig. 11. For example, four similar structures are provided for four pairs of differential transistors (four weights).

In the pre-driver 7400, the input clock signals (input phases $\phi1$ and $\phi3$) are first input to a level converter circuit (pre-driver) having the p-MOS pair of differential transistors 7403 and 7404 of the tail current proportional to the weight W1. The load device of the level converter circuit consists of the two diode-connected n-MOS transistors 7405 and 7406 and the diode-connected n-MOS transistor 7407 connected to the source of these transistors. For the transistor sizes of the n-MOS load of the pre-driver and the pairs of differential transistors (current converter circuits: transistors 501 and 502) of the phase-combining circuit, a mirror ratio is selected so that the pairs of the differential transistors generate a voltage slightly larger than the voltage that is sufficient for switching the current. Phase signals $\phi W1$ and $\phi W3$ obtained based on the processing with the weight W1 are supplied to the pairs of differential transistors 501 and 502. The weight (current) W1 from the D/A converter 530 flows to the transistor 7408, and a weight W12 obtained by processing via the transistor 7409 is supplied to the gate of the transistor 503.

As explained above, according to the pre-driver 7400 of the seventh embodiment, a weighted differential current wave that is integrated by the phase-combining circuit is scaled so that this current wave is more proportional to the weight. As a result, the linearity of the phase characteristic with respect to the control code is improved. Further, even if the power source voltage Vdd has varied, there is little variation in the voltage level that is input to the pairs of differential transistors of the phase-combining circuit and the common mode voltage. Therefore, it is possible to provide a circuit having small timing variation against a change in the power source voltage Vdd. For a phase having a small weight, an input signal is also small. Therefore, noise due to capacitive coupling also becomes smaller at a constant rate. Thus, there is no such problem that the noise due to a capacity coupling appears relatively large for a small weight. This also improves the linearity of the phase characteristic with respect to the control code.

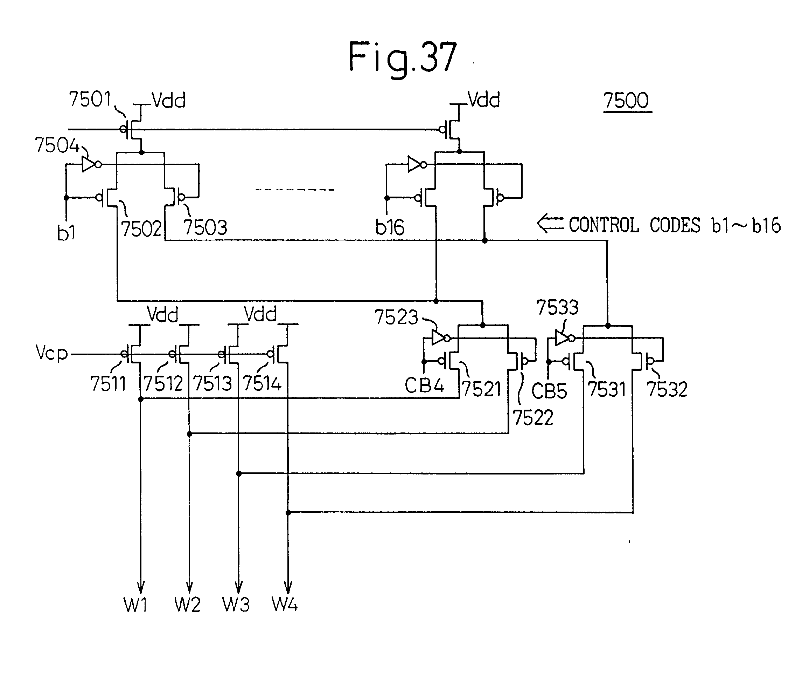

Fig. 37 is a circuit diagram showing one example of a weight signal generator circuit in a phase-combining circuit as an eighth embodiment of the timing signal generator circuit relating to the present invention.

This shows an example where a phase is designated by a six-bit digital control signal.

As shown in Fig. 37, a weight signal generator circuit 7500 of the eighth embodiment has sixteen constant-current sources constructed of p-MOS transistors 7501 to 7503 and an inverter 7504. The weight signal generator circuit 7500 converts the lower four bits (CB0 to CB3) of a six-bit control signal into sixteen control codes (thermometer codes) b1 to b16, and changes over currents of respective constant-current sources to generate complementary control currents. The upper two bits CB4 and CB5 are applied directly and via inverters 7523 and 7533 to control p-MOS transistors 7521, 7522, 7531 and 7523, to generate weights (currents) W1 to W4 from the complementary control currents. There are provided p-MOS transistors 7511 to 7514 for giving bias currents (for example, corresponding to Wmin in Fig. 29A and Fig. 29B) not dependent on control codes, to the weights W1 to W4 respectively.

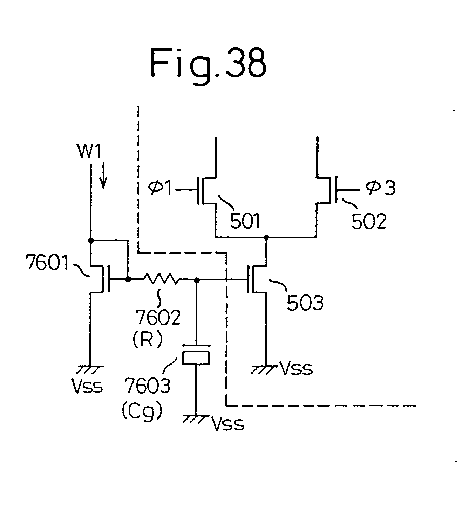

Fig. 38 is a circuit diagram showing a modified example of pairs of differential transistors to be applied to the phase-combining circuit of the present invention. This shows a modified example of pairs of differential transistors 501 to 503 shown in Fig.. 11.

As shown in Fig. 38, in the present embodiment, the weight W1 flows to a p-MOS transistor 7601 of which gate and drain are connected in common (diode connected), and is also supplied to the gate of a transistor 503 via a resistor 7602. The gate of the transistor 503 is connected to a low-potential power source Vss via a capacitor 7603. In other words, the gate voltage of the transistor 503 for controlling the tail current of the pairs of differential transistors is generated by a filter circuit consisting of the diode-connected transistor 7601, the resistor 7602, and the capacitor 7603. With this arrangement, the weight currents of the pairs of differential transistors are not changed instantly even if the control codes have changed, but are changed within a clock cycle period, for example. In other words, the time constant of the resistor 7602 (R) and the capacitor 7603 in the filter circuit is set to a time of about the clock cycle. Pairs of differential transistors for other weights W2 to W4 also have a similar structure.

According to the modified example shown in Fig. 38, there is an advantage that even if a control signal (control code) has changed asynchronously with the clock of the phase-combining circuit, there occurs no large phase error in the output of the timing signal generator circuit due to this change. Thus, the output of the phase-combining circuit can be set asynchronous with the control signal.

As described above, in order to increase the signal transmission speed between LSIs, for example, it is necessary that a circuit that receives a signal operates at a correct timing with the signal. As a method of generating a correct timing, there has been a method of providing a phase-variable timing signal generator circuit that uses a phase interpolator in the feedback loop like a DLL or PLL as described above.

It is possible to set a substantially accurate π (180 degrees) as a phase difference for differential clock signals. However, when two sets of differential clock signals (φ1,φ3; φ2,φ4) are used as input signals of four phases in a phase-combining circuit, a phase difference between the differential clock signals of each set may be deviated from π/2 (90 degrees), that is, between the signals φ1 and φ2 and between the signals φ3 and φ4. In other words, there is a possibility that a deviation exists in the input signal itself.

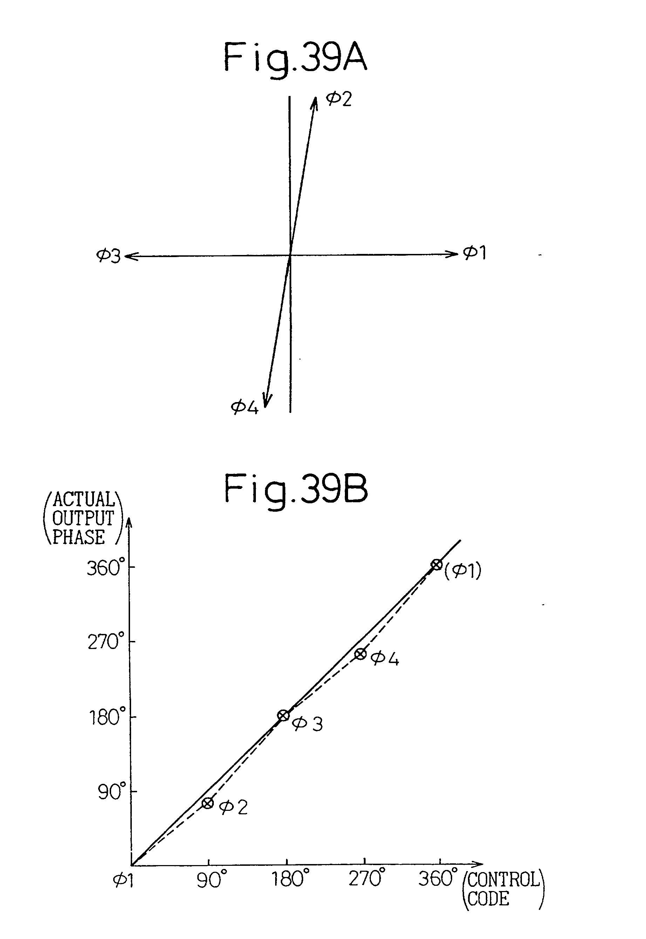

Fig. 39A and Fig. 39B are diagrams for explaining a problem when a phase of an input signal to be used in the phase-combining circuit has been deviated. Fig. 39A shows a state that a phase between differential clock signals (between signals φ1 and φ3, and between signals φ2 and φ4) has been deviated from a predetermined value when the two sets of differential clock signals (φ1,φ3; φ2,φ4) are used as input signals of four phases. Fig. 39B shows a relationship between the phase control codes and the actual output phases in this case.

The above-described phase-combining circuit shown in Fig. 11 uses the two sets of differential clock-signals (φ1,φ3; φ2,φ4) as input signals of four phases in the phase-combining circuit. The phase interpolator circuit (phase-combining circuit) integrates and compares a sum of the weighted inputs of these input signals, and generates clocks of phases corresponding to the weight values (W1 to W4). In other words, the phase interpolator shifts the weight from a first phase to a second phase thereby to generate a clock of an intermediate phase between the two phases. The precision of the output of the phase interpolator is limited by the precision of the reference phases (phases of the input signals φ1 to φ4) that are given to the inputs.

Therefore, when a phase difference of the differential signals (φ1,φ3; φ2,φ4) used as an input has deviated from 90 degrees as shown in Fig. 39A, for example, the phase characteristic with respect to the control code (the phase characteristic of a signal actually output with respect to the control code) is deviated from a straight line as shown in Fig. 39B.

Specifically, when the signal transmission speed is a high speed of a few Gbps, such as, for example, 2.5 Gbps, it is necessary that an error of a reception timing generator circuit (timing signal generator circuit) is set to an extremely small value of 10 ps to 20 ps (pico second). Therefore, a deviation of a phase difference of a differential signal used for the reference clocks (input signals of the phase-combining circuit) from the ideal value (90 degrees) also needs to be restricted to a small value of 10 to 20 ps in terms of time.

Accordingly, the input signals (two sets of differential signals) of four phases that are used as the reference clocks must be generated so that a mutual phase difference is accurately 90 degrees. It is furthermore necessary to transfer the generated signals to the phase interpolator by keeping this phase difference. However, in a multi-channel signal transmission circuit,-there occurs a delay in the reference clocks attributable to an input capacitance of the clock input circuit as a large number of transmission and reception circuits are driven. Further, the delay is different for each line (each reference clock). Therefore, it is very difficult to transfer signals by keeping a phase difference of 10 to 20 ps in terms of time.

In the light of the above difficulty, and in order to realize a phase-combining circuit having high precision, one aspect of the present invention explained below is for generating a reference clock having an accurate phase difference and for achieving an accurate phase interpolation without generating a phase error at the time of generating and transferring an input clock.

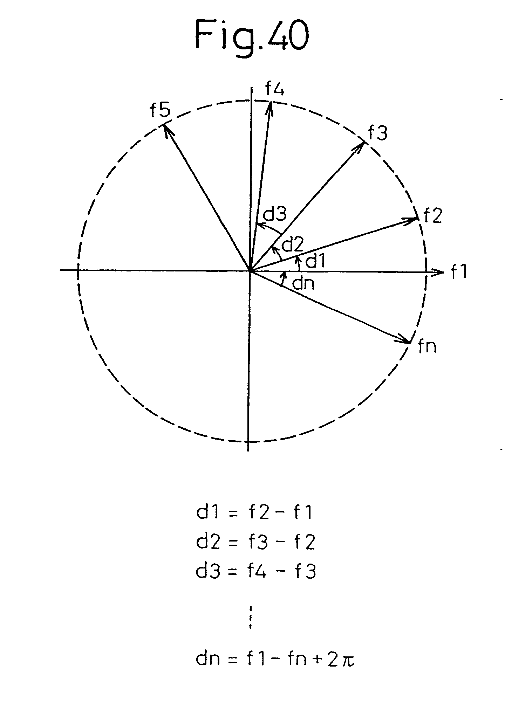

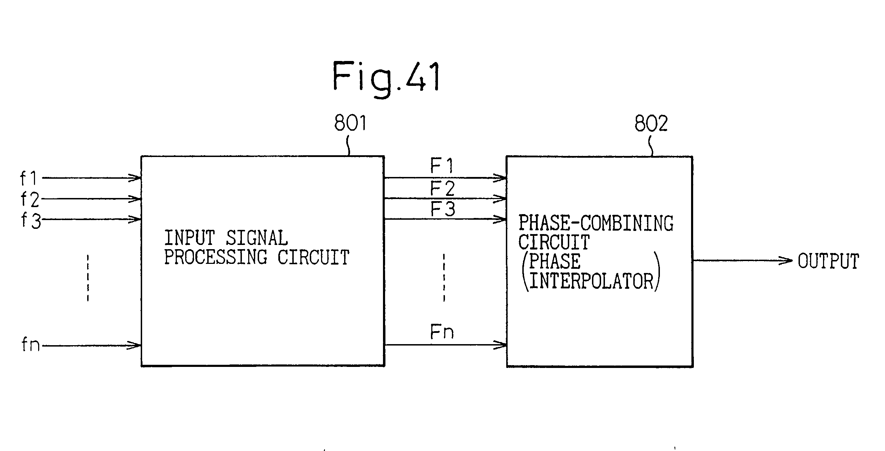

Fig. 40 is a diagram for explaining the principle of a timing signal generator circuit as one aspect of the present invention. Fig. 41 is a block diagram schematically showing the timing signal generator circuit shown in Fig. 40. In Fig. 41, a reference number 801 denotes an input signal processing circuit, and 802 denotes a phase-combining circuit (phase interpolator).

As shown in Fig. 40, phases of n signals are expressed as d1, f2, ---, and fn, and phase differences between adjacent signals are expressed as d1, d2, ---, and dn respectively. Therefore, the following relationship is established. d1 = f2 - f1, d2 = f3 - f2, d3 = f4 - f3, ---, and dn = f1 - fn +2n.

As shown in Fig. 41, according to the arrangement of Fig. 40, the input signal processing circuit 801 processes n input signals (f1 to fn), generates n signals (F1 to Fn), and supplies the processed signals (F1 to Fn) to the phase-combining circuit 802.

In the principle of this aspect of the present invention, f1 and f2 are combined, f2 and f3 are combined, and so on. Then, an intermediate phase of each combined set of phases is obtained. Therefore, phases of (f1 + f2)/2, (f2 + f3)/2, and so on are obtained with a constant phase shift. When a difference is mutually independent of each other, the intermediate phase is an average of the two phases, and a variance of errors becomes smaller by $2^{-0.5}$ times. As a result, errors become smaller by about 30%. Further, according to the principle of this aspect of the present invention, f1 to f3 are combined, f2 to f4 are combined, and so on, and an intermediate phase is obtained for each of these sets in a similar manner to the above. As a result, phases of (f1 + f2 + f3)/3, (f2 + f3 + f4)/3, and so on are obtained with a constant phase shift. Errors can be made further smaller in this way.

For generating intermediate phases, the signals to be combined together are not limited to adjacent two signals (f1 and f2, f2 and f3, ---) or three signals (f1, f2, f3, and f2, f3, f4, ---). It is also possible to combine two signals by skipping a predetermined number like (f1 and f3, f2 and f4, ---) or three signals like (f1, f3, f5, and f2, f4, f6, ---), for example.

Further, it is also possible to obtain intermediate phases (signals F1, F2, ---) by combining any optional k signals without limiting to two or three phases.

When there is a special relationship between phases of the signals, it is possible to obtain a further remarkable effect of reduction in errors.

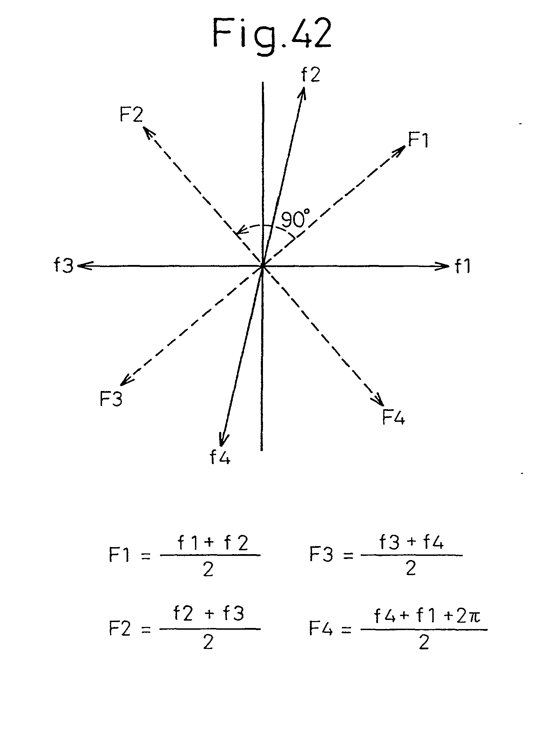

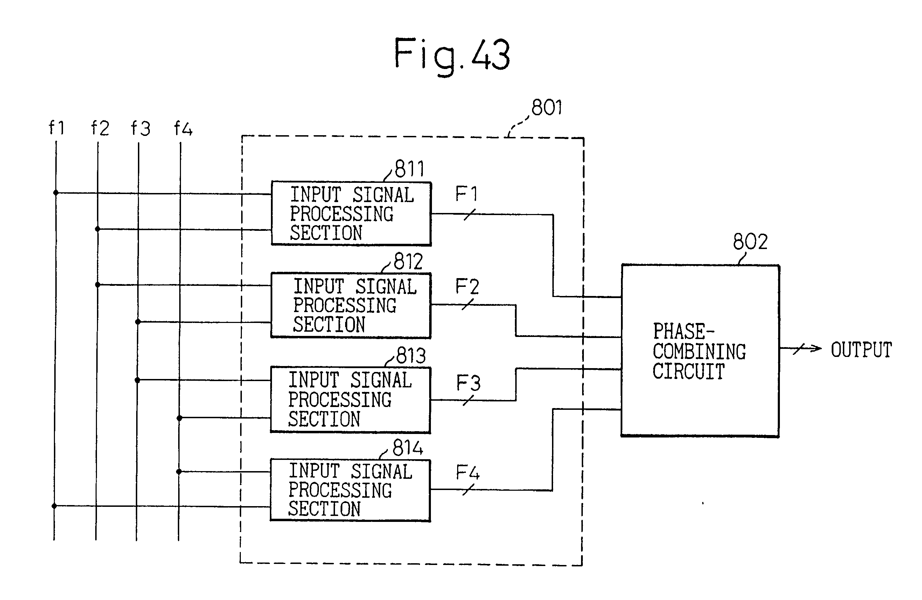

Fig. 42 is a diagram for explaining one operation principle of the timing signal generator circuit in this aspect of the present invention. Fig. 43 is a block circuit diagram schematically showing a ninth embodiment of the timing signal generator circuit to which the operation principle shown in Fig. 42 has been applied. In Fig. 43, a reference number 801 denotes an input signal processing circuit having four input signal processing sections 811 to 814, and 802 denotes a phase-combining circuit. Each of the input signal processing sections 811 to 814 can be structured as an interpolator having an equal weight of two inputs.

As shown in Fig. 42 and Fig. 43, the timing signal generator circuit of the ninth embodiment uses as input signals two sets of differential signals (f1, f3 and f2, f4) whose mutual phase difference is near 90 degrees. These signals f1 to f4 may be considered as signals of four phases. However, as they are differential signals, two phases with one phase in the middle skipped have a mutual phase difference of 180 degrees. In other words, the signal f1 and the signal f3 have a mutual phase difference of 180 degrees, and the signal f2 and the signal f4 have a mutual phase difference of 180 degrees. Consider a case where a phase difference between one set of differential signals (input signals) f1 (f3) and the other set of differential signals f2 (f4) is smaller than 90 degrees, as shown in Fig. 42. The signals f1 to f4 correspond, for example, to the signals $\phi 1$ to $\phi 4$ shown in Fig. 5 and Fig. 9 respectively.

As shown in Fig. 43, the input signals f1 to f4 are supplied to the input signal processing sections 811 to 814 of the input signal processing circuit 801 respectively, and they are output as reference signals (new input signals) F1 to F4 and supplied to the phase-combining circuit 802.

Specifically, when the signals f1 and f3 and the signals f2 and f4 are differential signals (complementary signals) respectively, these pairs of differential signals (f1, f3) and (f2, f4) are combined with an equal weight, and a new pair of differential signals (F1, F3) are output. Further, the original pairs of differential signals with one polarity changed (f2, f4) and (f3, f1) are combined with an equal weight, and a pair of differential signals (F2, F4) are also output. In other words, the signals F1 to F4 are processed as follows by the respective input signal processing sections 811 to 814, after excluding a constant offset phase based on the phase combining.

$$F1 = (f1 + f2) / 2$$

$$F2 = (f2 + f3) / 2$$

$$F3 = (f3 + f4) / 2$$

$$F4 = (f4 + f1 - 2\pi) / 2$$

In the above, the phase angles are defined as $0 < f1 < f2 < f3 < f4 < 2\pi$.

For Fi, a difference between adjacent phases becomes Fi+1 - Fi = (f i+2 - fi) / 2 = 90 degrees. This is because fi and fi+2 have a phase difference of 180 degrees (n) as they are a pair of differential phases. Specifically, the following relationship is obtained. F2 - F1 = (f2 + f3) / 2 - (f1 + f2) / 2 = (f3 - f1) /2 = 90 degrees. Further, F3 - F2 = (f3 + f4) / 2 - (f2 + f3) / 2 = (f4 - f3) / 2 = 90 degrees.

Therefore, even if the phase difference between the differential signals (for example, the phase difference between the signal f1 and the signal f2) is not exactly 90 degrees, the phase difference of the combined signals (for example, the phase difference between the signals F1 and F2) becomes 90 degrees. Thus, there is no influence of a timing error attributable to a clock generation or distribution. According to the ninth embodiment, the signals F1 to F4 that have an accurate phase difference of 90 degrees are supplied to the phase-combining circuit 802, and a predetermined phase-controlled output signal is obtained.

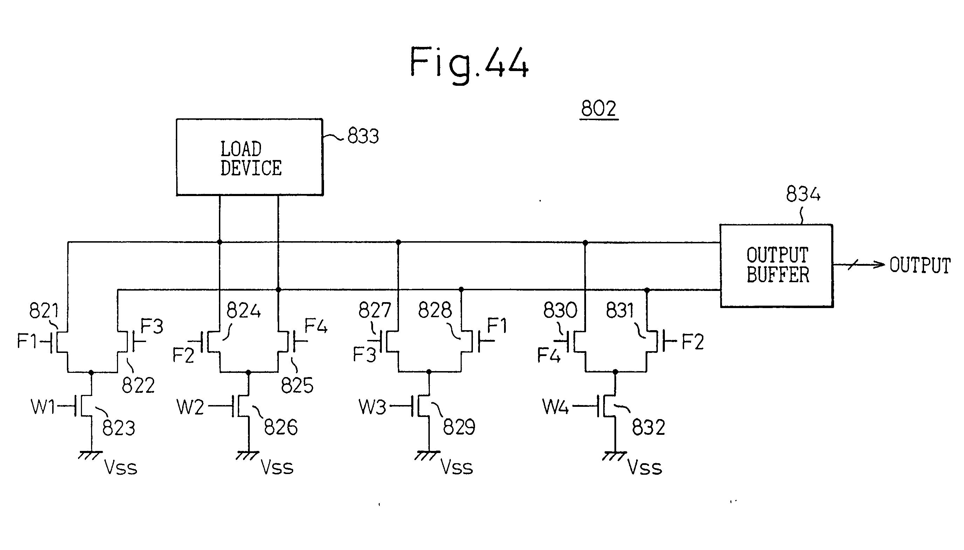

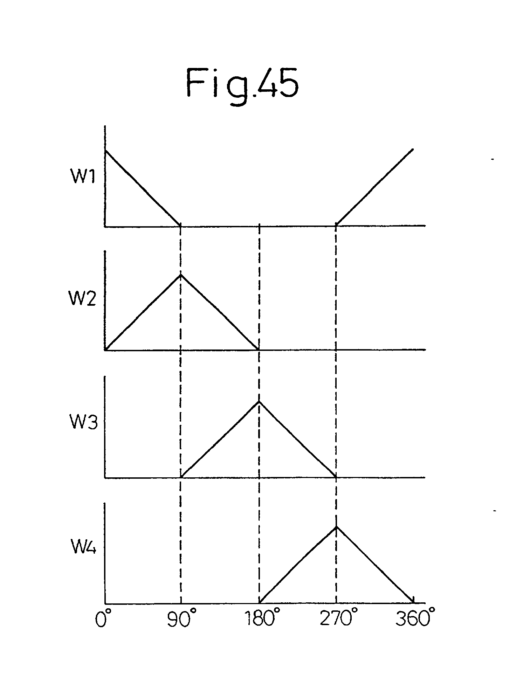

Fig. 44 is a circuit diagram showing one example of a phase-combining circuit in the timing signal generator circuit shown in Fig. 43. This circuit corresponds to the phase-combining circuit 5 shown in Fig. 11. Fig. 45 is a diagram showing one example of a change in the weight in the phase-combining circuit shown in Fig. 44.

As shown in Fig. 44, the signals (input phases) F1 to F4 processed by the input signal processing sections 811 to 814 respectively are supplied to the phase-combining circuit (variable weight interpolator) 802. This phase-combining circuit 802 includes pairs of differential transistors 821, 822, 824, 825, 827, 828, 830 and 831 supplied with the signals F1 and F3, F2 and F4, F3 and F1, and F4 and F2.respectively, transistors 823, 826, 829 and 832 supplied with the weights (weight signals) W1, W2, W3 and W4 at their gates respectively, a load device 833 connected in common to the pairs of differential transistors, and an output buffer 834. The output buffer 834 is for converting signal levels of a small amplitude at both ends of the load device 833 into output signals of a large amplitude (full CMOS amplitude). In Fig. 44, the output buffer 834 is structured as a supply-insensitive buffer circuit (refer to Fig. 31) in which a delay is not easily varied by a power source voltage. The structure of the weight signal generator circuit is omitted from Fig. 44.

The operation of the phase-combining circuit 802 is similar to that of the phase-combining circuit 5 shown in Fig. 11. The weight signals W1, W2, W3 and W4 are supplied to the gates of the transistors 823, 826, 829 and 832 respectively. By changing the weights as shown in Fig. 45, it is possible to obtain the phase precision of six bits in total, for example. As explained above, the present circuit has a small number of signal lines of two sets of differential signals for input signals. However, the input signals of the variable weight interpolator (phase-combining circuit) 802 have high relative phase precision. Further, the variable weight interpolator 802 exhibits excellent linearity, so that it is possible to generate high-precision timing signals.

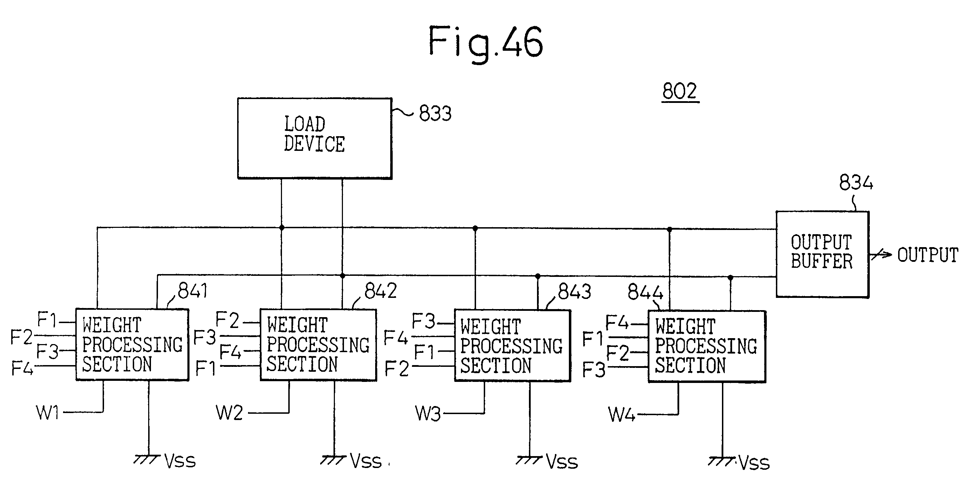

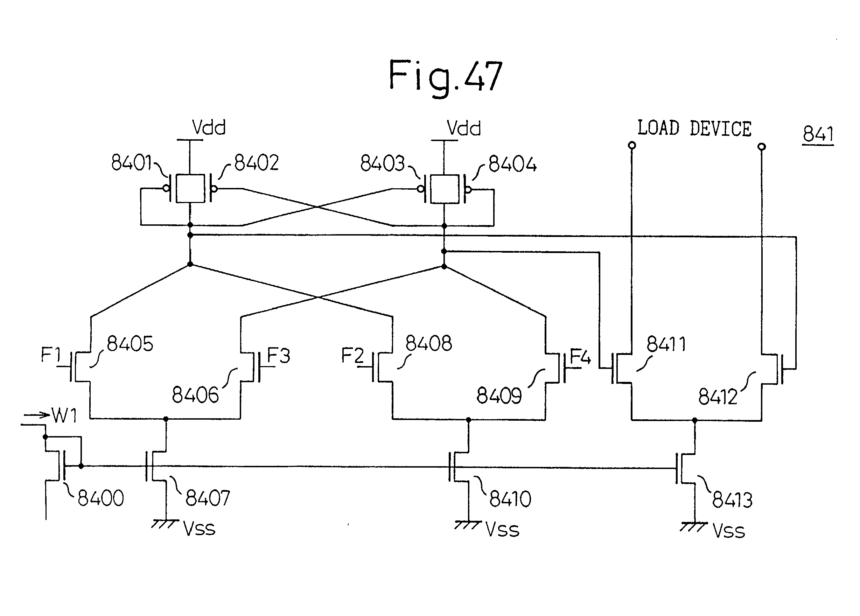

Fig. 46 is a block circuit diagram schematically showing a tenth embodiment of the timing signal generator circuit to which the operation principle shown in Fig. 42 has been applied. Fig. 47 is a circuit diagram showing one example of a phase-combining circuit in the timing signal generator circuit shown in Fig. 46. In Fig. 46, reference numbers 841 to 844 denote weight processing sections.

As shown in Fig. 46, the phase-combining circuit 802 in the timing signal generator circuit of the tenth embodiment is constructed of the four weight processing sections 841 to 844 to which the weights W1 to W4 and all the input phases (signals F1 to F4) have been supplied.

As shown in Fig. 47, each weight processing section (841) includes p-MOS transistors 8401 to 8404 that structure loads, and n-MOS transistors 8405 to 8413. Transistors 8405 and 8406 and transistors 8408 and 8409 constitute pairs of differential transistors respectively for applying weights (wl) based on the signals F1 to F4. These transistors are connected to the load device 833 via transistors 8411 and 8412. The four weight processing sections 841 to 844 are provided for the four weights W1 to W4 respectively, and are connected to the load device 833 respectively thereby to combine signals. A timing signal is output via the output buffer 834. In the tenth embodiment shown in Fig. 46, the supply-insensitive buffer circuit 834 is used as the output buffer in a similar manner to that of the circuit shown in Fig. 44.

As explained above, according to the tenth embodiment, the output of the fixed-weight interpolator (weight processing sections 841 to 844) is directly input to the variable-weight interpolator 802. Thus, a signal conversion into a CMOS full amplitude level by a comparator is omitted, which makes it possible to achieve a higher-speed signal transmission and a lower power consumption.

As described above, based on a complementary change in differential signals (differential clock signals) and a coupling of wires for transmitting the differential signals, it is possible to keep a substantially accurate phase difference of 180 degrees. Therefore, even if there has been a deviation between two sets of - differential signals (for example, f1 and f2), it is possible to set a phase difference to a predetermined value (for example, 90 degrees or 180 degrees/ 2) in the above-described processed signal (for example, F1 = (f1 + f2) / 2 or F2 = (f2 + f3) / 2). This applies not only to two sets of differential signals but also to three sets of differential signals (f1 f4; f2, f5; f3, f6). As described later, it is possible to set a phase difference between the signals F1 and F2 and a phase difference between the signal F2 and F3 accurately to 60 degrees (180 degrees/3) respectively, based on the processing of F1 = (f1 + f2 + f3) / 3, F2 = (f2 + f3 + f4) / 3, and F3 = (f3 + f4 + f5) / 3.

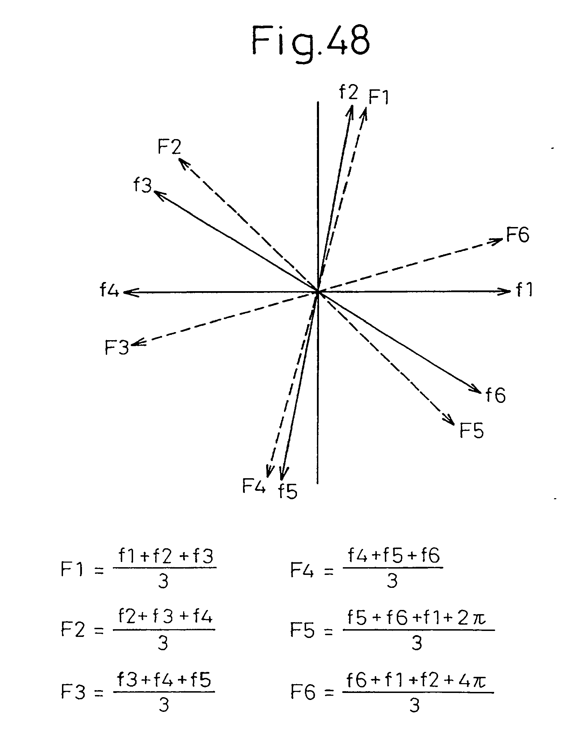

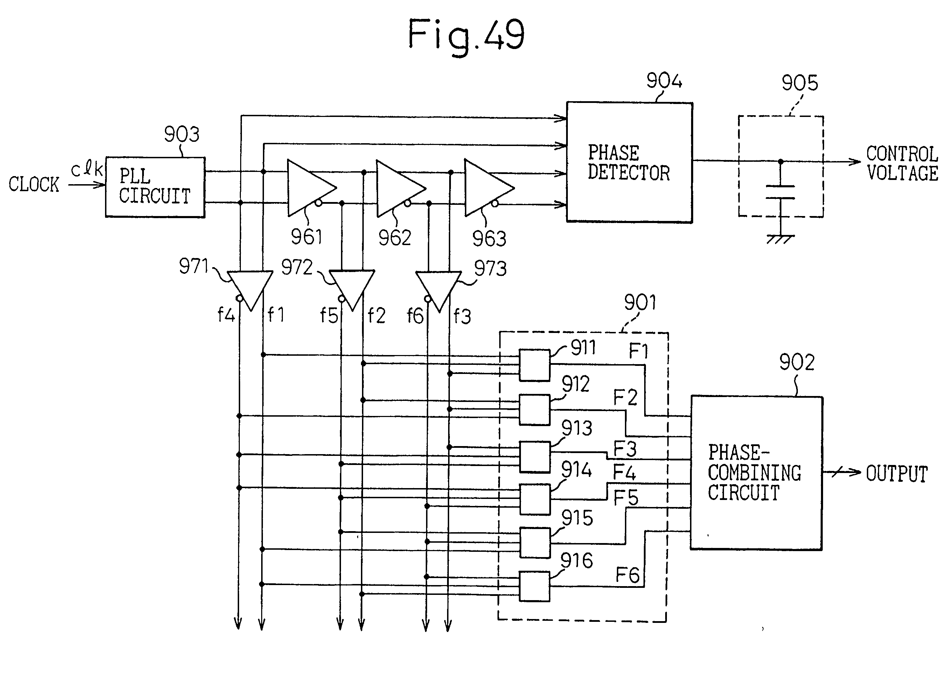

Fig. 48 is a diagram for explaining another operation principle of the timing signal generator circuit in this aspect of the present invention. Fig. 49 is a block circuit diagram schematically showing an eleventh embodiment of the timing signal generator circuit to which the operation principle shown in Fig. 48 has been applied. In Fig. 49, a reference number 901 denotes an input signal processing circuit having six input signal processing sections 911 to 916, and 902 denotes a phase-combining circuit. Each of the input signal processing sections 911 to 916 can be structured as an interpolator of an equal weight for three inputs.

As shown in Fig. 48 and Fig. 49, the timing signal generator circuit of the eleventh embodiment uses as input signals three sets of differential signals (f1, f4; f2, f5; f3, f6) of which mutual phase difference is near 60 degrees. These signals f1 to f6 may be considered as signals of sixth phases. However, as they are differential signals, two phases with two phases in the middle skipped have a mutual phase difference of 180 degrees. In other words, the signal f1 and the signal f4 have a mutual phase difference of 180 degrees, and the signal f2 and the signal f5 have a mutual phase difference of 180 degrees. Further, the signal-f3 and the signal f6 have a mutual phase difference of 180 degrees.

As shown in Fig. 49, a PLL circuit 903 generates a signal that is synchronous with a clock clk that has been supplied from the outside of the chip. Then, the phase of this signal is divided by using DLL sections 961 to 963, a phase detector 904 and a charge pump 905, to produce three sets of differential signals (f1, f4; f2, f5; f3, f6) whose phases are mutually different by 120 degrees. These differential signals are then supplied to an input signal processing circuit 901 via buffers 971 to 973.

The above input signals (three sets of differential signals f1, f4; f2, f5; f3, f6) are also used for driving other various circuits. Therefore, there is a case where the phase differences are not exactly 120 degrees due to a delay attributable to input capacitance and wiring capacitance of the input circuits. However, based on a complementary change and a coupling of lines for transmitting the differential signals, it is possible to keep the phase difference of each differential signal (differential clock signal) to 180 degrees substantially accurately.

In the eleventh embodiment, new signals F1 to F6 are generated as follows in a similar manner to that when the two sets of differential signals (f1, f3; f2, f4) are produced with reference to Fig. 42. Timing signals are generated by using these signals F1 to F6.

As shown in Fig. 49, the input signal processing sections 911 to 916 process the signals F1 to F6 as follows by excluding a constant offset phase due to the phase combining.

$$F1 = (f1 + f2 + f3) / 3$$

$$F2 = (f2 + f3 + f4) / 3$$

$$F3 = (f3 + f4 + f5) / 3$$

$$F4 = (f4 + f5 + f6) / 3$$

$$F5 = (f5 + f6 + f1 + 2\pi) / 3$$

$$F6 = (f6 + f1 + f2 + 4\pi) / 3$$

With the above arrangement, it is possible to set an accurate phase difference of 60 degrees (180 degrees / 3) for each of the phase difference between the signals F1 and F2, the phase difference between the signals F2 and F3, and the phase difference between the signals F3 and F4, respectively. The application of this aspect of the present invention is not limited to the two sets of differential signals (f1, f3; f2, f4) and the three sets of differential signals (f1, f4; f2, f5; f3, f6). This aspect of the present invention can also be applied to more sets of differential signals in a similar manner. Further, as described above, even if there is no special relationship between the phases of the signals, it is also possible to reduce errors in signals, by combining f1 and f2 and f2 and f3, for example, to produce an intermediate phase like F1 = (f1 + f2) / 2, F2 = (f2 + f3) / 2, etc.

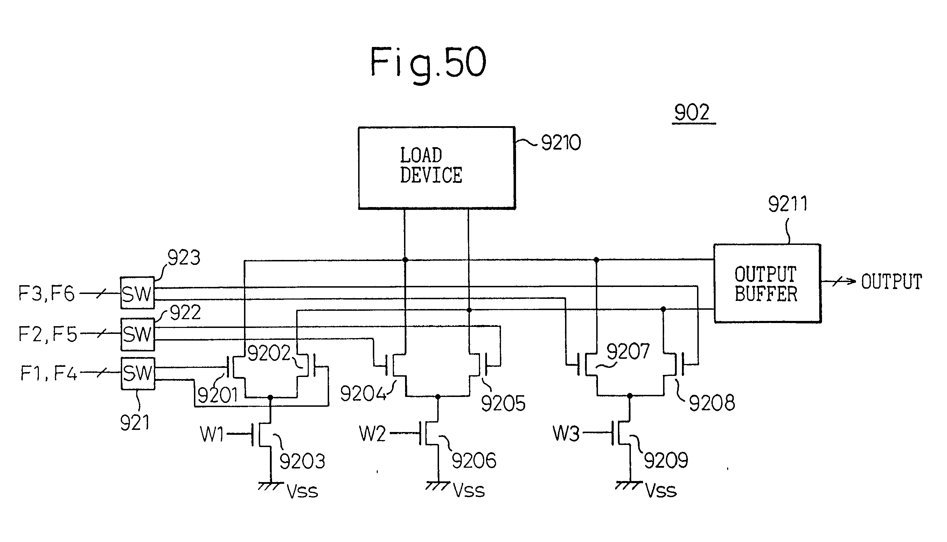

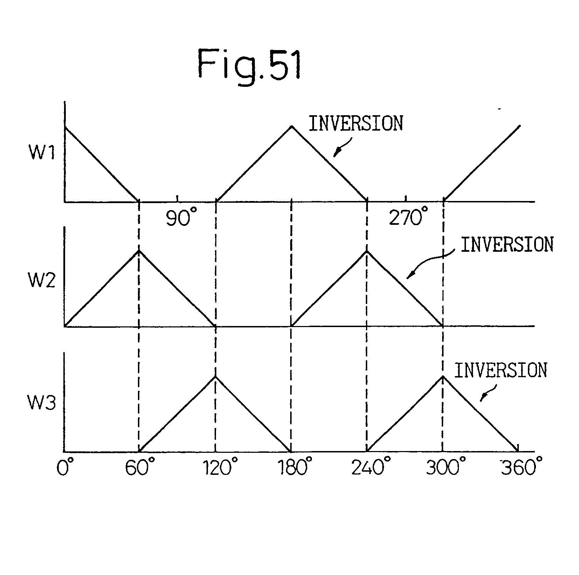

Fig. 50 is a circuit diagram showing one example of a phase-combining circuit in the timing signal generator circuit shown in Fig. 49. Fig. 51 is a diagram showing one example of a change in the weight in the phase-combining circuit shown in Fig. 50.

As shown in Fig. 50, signals (input phases) F1 to F6 that have been processed by the input signal processing sections 911 to 916 respectively are supplied to a phase-combining circuit (variable-weight interpolator) 902. This phase-combining circuit 902 is constructed of switches 921, 922 and 923 for inverting the signals F1, F4, F2, F5, F3 and F6 respectively, pairs of differential transistors 9201, 9202, 9204, 9205, 9207 and 9208 supplied with outputs of these switches 921 to 923 respectively, transistors 9203, 9206 and 9209 supplied with weights (weight signals) W1, W2 and W3 to their gates respectively, a load device 9210 connected in common to each pair of differential transistors, and an output buffer 921.

The weights W1 to W3 (currents: refer to Fig. 12A) are obtained as outputs of a weight signal generator circuit (D/A converter: 51, 530) that generates a weight from a phase control code, for example. For example, these weight signals are generated based on a phase control code consisting of two bits of polarity control signals and four bits of weight control signals, for example. In other words, as shown in Fig. 51, the weight W1 is inverted within a range of phases from 90 degrees to 270 degrees, the weight W2 is inverted within a range of phases from 150 degrees to 330 degrees, and the weight W3 is inverted within a range of phases from 210 degrees to 390 (30) degrees. The signals F1, F4, F2, F5, F3 and F6 change over the polarities of differential signals that are input to the pairs of differential transistors by the switches 921, 922 and 923 respectively.

The currents of the pairs of differential transistors (9201, 9202, 9204, 9205, 9207 and 9208) of which tail currents have been controlled by the weights W1 to W3 are integrated by the load device 9210. Then, zero crosses of differential signals obtained are detected, and a result is output. The load device 9210 of the phase-combining circuit 902 has an integration capacity added to the cross-coupled p-MOS load having a differential impedance in high-resistance, for example. As explained above, the cross-coupled p-MOS load shows a high impedance for a differential signal but shows a low impedance for an in-phase signal. Therefore, a common-mode voltage does not drift to a high level or to a low level even if a common-mode feedback circuit is not particularly provided. An output buffer (comparator) 9211 is connected to this load device 9210 to convert a signal of a small amplitude into an output signal of a large amplitude (full CMOS amplitude). In the circuit shown in Fig. 50, the output buffer 9211 is a supply-insensitive buffer circuit in which a delay is not much dependent on a power source voltage Vdd. As explained above, the phase-combining circuit shown in Fig. 50 can provide a high-precision timing signal generator circuit in a simple structure based on a small number of input phases.

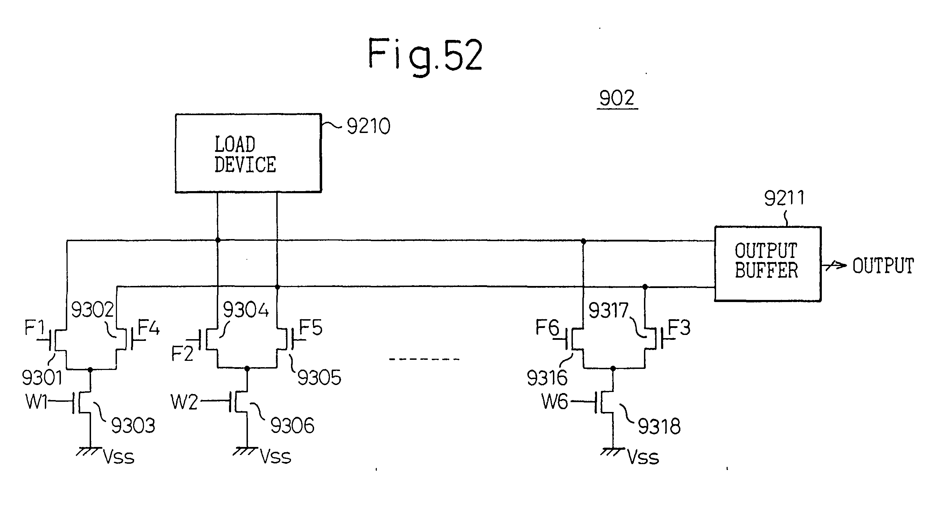

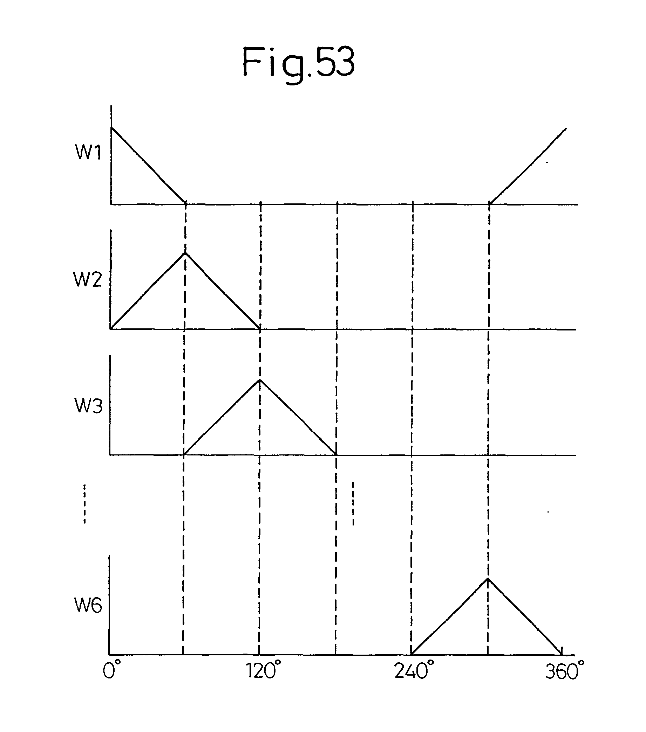

Fig. 52 is a circuit diagram showing another example of a phase-combining circuit in the timing signal generator circuit shown in Fig. 49. Fig. 53 is a diagram showing one example of a change in the weight in the phase-combining circuit shown in Fig. 52.

As shown in Fig. 52, a phase-combining circuit (variable-weight interpolator) 902 is constructed of pairs of differential transistors 9301, 9302, 9304, 9305, ---, 9316 and 9317 to which signals F1, F4, F2, F5, ---, F6 and F3 have been supplied, transistors 9303, 9306, ---, and 9318 supplied with weights (weight signals) W1, W2, ---, and W6 to their gates respectively, a load device 9210 connected in common to each pair of differential transistors, and an output buffer 9211. In other words, the phase-combining circuit shown in Fig. 52 supplies the signals F1, F4, F2, F5, ---, F6 and F3 to the respective pairs of differential transistors without the need for controlling the polarities of the signals F1, F4, F2, F5, F3 and F6 by providing the switches 921 to 923 in the phase-combining circuit as shown in Fig. 50. The weights W1 to W6 change as shown in Fig. 53.

In the phase-combining circuit shown in Fig. 52, instead of the inputs of three phases, inputs of six phases are applied. When the weights W1 to W6 are given that change based on a code of six bits as shown in Fig. 53, it is not necessary to invert the polarities of the input signals that are applied to the pairs of differential transistors. The phase-combining circuit shown in Fig. 52 uses a larger number of input phases than the input phases of the phase-combining, circuit shown in Fig. 50. However, this arrangement does not incur a disturbance of input signals due to the-inversion of polarities. As a result, it is possible to generate timing signals in higher precision.

As explained above, according to the above aspect of the present invention, it is possible to generate timing signals in high precision without receiving an influence of phase errors that are generated at the time of a generation and distribution of reference signals.

Next, another aspect of the present invention will be described.

In the construction of phase-combining circuits (phase interpolator circuits), weighted sum generator circuits and comparators are analog circuits, and designing the circuits with high linearity is becoming increasingly difficult with increasing miniaturization in semiconductor processes and attendant reductions in supply voltage. In view of this situation, it is needed to realize a phase-combining circuit or timing signal generator circuit having high linearity without requiring more than necessary linearity in the analog circuits.

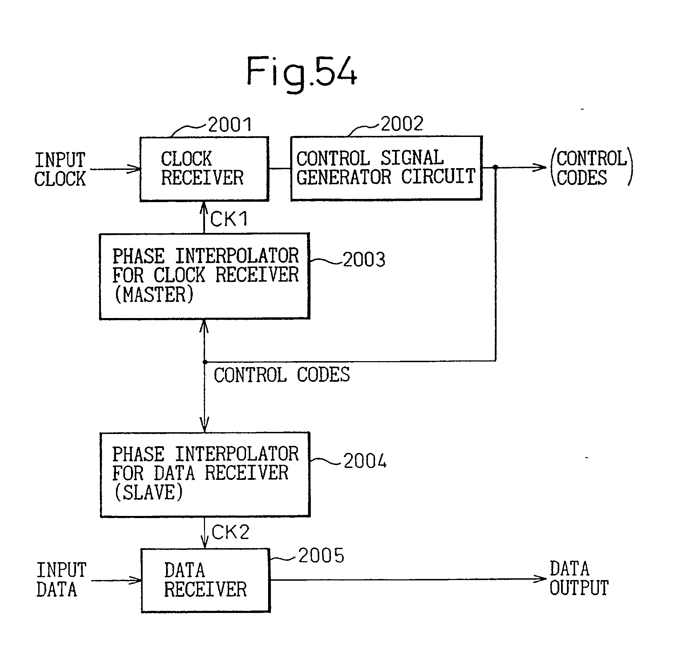

Fig. 54 is a block diagram showing one example of a system having master and slave phase-combining circuits (phase interpolators). In Fig. 54, reference numeral 2001 is a clock receiver, 2002 is a control signal generator circuit, 2003 and 2004 are the phase interpolators, and 2005 is a data receiver.

In the system shown in Fig. 54, the clock receiver 2001 receives a clock signal supplied from the outside, and the control signal generator circuit 2002 outputs a control code (digital control code) in accordance with a signal output from the clock receiver 2001; the control code from the control signal generator circuit 2002 is supplied to control the phase interpolator (master) 2003 for the clock receiver so that the phase of a clock CK1 output from it matches the phase of the clock (input clock) input to the receiver 2001.

The control code from the control signal generator 2002 is also supplied to the phase interpolator-(slave) 2004 for the data receiver, and a clock CK2 is thus supplied to the data receiver 2005. More specifically, when data are transferred in parallel by using a plurality of data lines, a plurality of phase interpolators 2004 for data receivers (the same number of phase interpolators as there are data lines) are provided, for example, for the phase interpolator 2003 for one clock receiver. Then, in accordance with the control code supplied from the control signal generator circuit 2005, the phase interpolator 2004 for each data receiver generates the clock CK2 and supplies it to the data receiver 2005. Here, the slave phase interpolators are not limited to those for the data receivers provided one for each data line, but are also provided for various other circuits that use synchronized clocks.

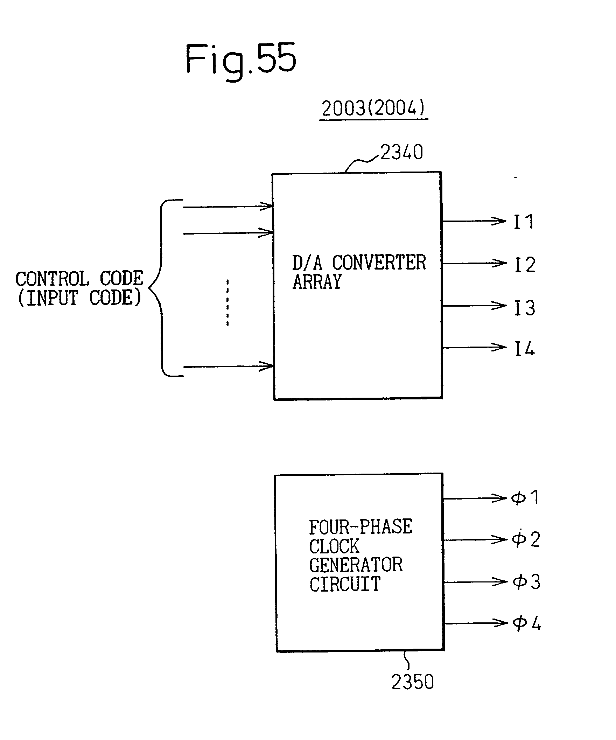

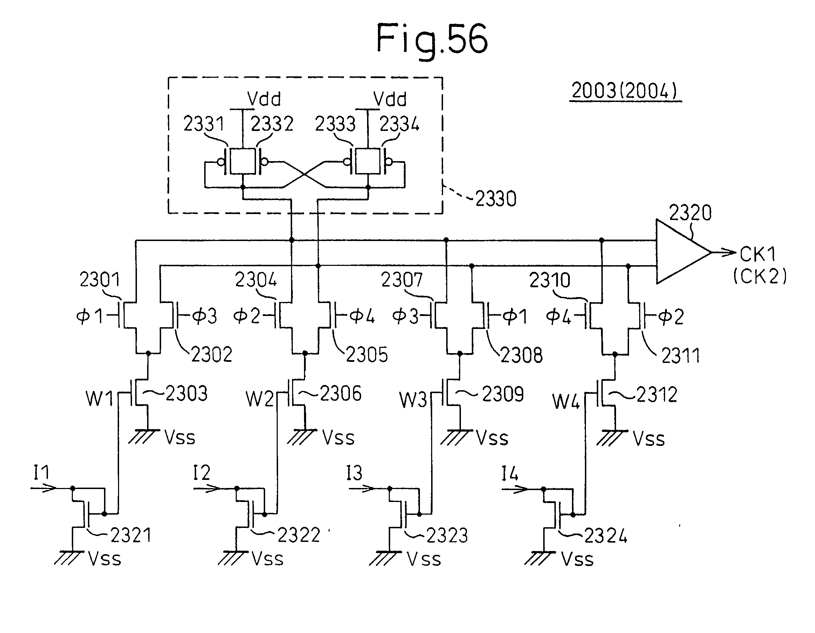

Figs. 55 and 56 are diagrams showing one example of a prior art phase-combining circuit.

As shown in Fig. 55, the prior art phase-combining circuit (phase interpolator) 2003 (2004) comprises, for example, D/A converters 2340 which output currents (weighting currents) I1 to 14, respectively, in accordance with the control code supplied from the control signal generator circuit 2002, and a four-phase clock generator circuit 2350 which generates four clock signals $\phi1$ to $\phi4$ shifted in phase by 90 degrees from one another.

Further, as shown in Fig. 56, in the phase interpolator 2003 (2004), the currents I1 to I4 from the D/A converters 2340 are made to flow through transistors 2321 to 2324, respectively, and applied as weights W1 to W4 to the gates of the transistors 2303, 2306, 2309, and 2312 respectively connected to differential pairs of transistors (2301, 2302; 2304, 2305; 2307, 2308; and 2310, 2311). The transistors in the respective differential pairs (2301, 2302; 2304, 2305; 2307, 2308; and 2310, 2311) are supplied at their gates with clock signals of different phases ($\phi$1, $\phi$3; $\phi$2, $\phi$4; $\phi$3, $\phi$1; and $\phi$4, $\phi$2), and are controlled in accordance with the respective weights W1 to W4, to output the clock CK1 (CK2) via a comparator 2320. In Fig. 56, reference numeral 2330 designates a load. The load 2330 is constructed from pMOS transistors 2331 to 2334.

The phase interpolator shown in Figs. 55 and 56 generates from the four phase clock signals $\phi$1 to $\phi$4 a voltage waveform corresponding to the integral of the weighted sum, and generates the desired phase by converting this waveform into a pulse wave by means of the comparator 2320. Here, the weights W1 to W4 are generated in accordance with the control code. The control code is supplied not only to the master phase interpolator 2003 but also to the slave phase interpolator 2004 to generate the clock.

In a system having master and slave phase interpolators such as the one shown in Fig. 54, if there exists a nonlinear relationship between the control code and output phase in the phase interpolators, phase errors induced by this linearity will be introduced in the outputs of the master and slave phase interpolators or in the output of each slave phase interpolator. Each phase interpolator also contains subtle characteristic errors due, for example, to variations in transistor characteristics, etc. and these errors become a problem when the clock frequency is increased to increase the data transfer rate. Accordingly, the nonlinearity between the control code and output phase in each phase interpolator must be reduced as far as possible, and while this requires improvements in semiconductor fabrication techniques to control the characteristics of each transistor; the weighted sum generator circuit and the comparator must also be designed with utmost care.

However, the weighted sum generator circuit and the comparator are analog circuits, and designing the circuits with high linearity is becoming increasingly difficult with increasing miniaturization in semiconductor processes and attendant reductions in supply voltage. Further, subtle phase shifts are introduced in the signals transferred on the plurality of data lines (signal lines) because of such factors as the length of each signal line and the existence of parasitic capacitors, and this has made it difficult to latch all the data transferred on these signal lines at optimum timing.

In view of the above-outlined problems with the prior art,
a phase-combining circuit and timing signal generator circuit having high linearity without requiring more than necessary linearity in the analog circuits can be realised. This embodiment, not forming part of the present invention can also individually control the timing of output signals of the phase-combining circuit.

Various such embodiments of the phase-combining circuit and timing signal generator circuit not forming part of the present invention will be described in detail below with reference to relevant drawings.

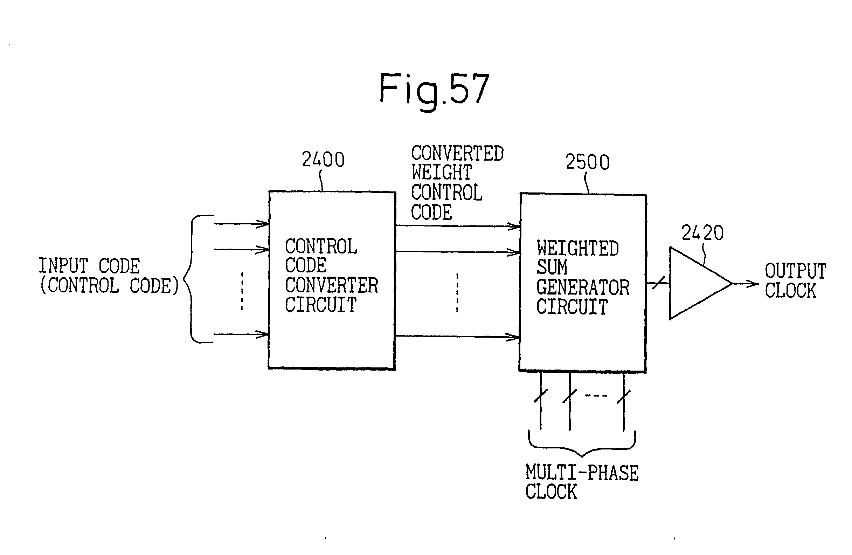

Fig. 57 is a block diagram showing the basic functional configuration of the phase-combining circuit.

In Fig. 57, reference numeral 2400 is a control code converter circuit, 2500 is a weighted sum generator circuit, and 2420 is a comparator. The weighted sum generator circuit 2500 shown here corresponds to the circuitry comprising the D/A converter array 2340, load 2330, and transistors 2301 to 2312 and 2321 to 2324 in the phase-combining circuit previously shown in Figs. 55 and 56.

As shown in Fig. 57, in the phase-combining circuit a control code (input code) is input to the weighted sum generator circuit 2500 via the control code converter circuit 2400. That is, in the phase-combining circuit of Fig. 57, the control code converter circuit 2400 is interposed between the input code to the phase interpolator (the output of the control signal generator circuit in Fig. 54) and the weighted sum generator circuit 2500 which takes a weighted sum on multiple phase clocks (for example, four phase clocks $\phi$1 to $\phi$4). Here, the weighted sum generator circuit 2500 is chosen to have a resolution sufficiently higher than a value corresponding to the number of bits in the input code (control code) (so as to provide smaller phase steps).

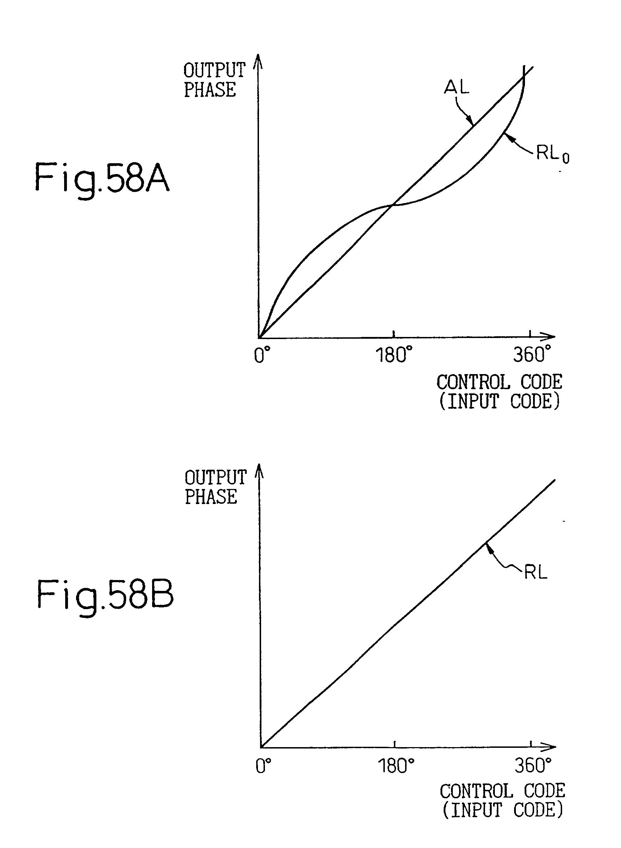

Figs. 58A and 58B are diagrams for explaining the operation of the phase-combining circuit shown in Fig. 57. In Fig. 58A, reference character AL indicates an ideal curve (ideal straight line) representing an ideal relationship between the output signal phase of the phase-combining circuit and the control code, and RLo represents a characteristic curve showing the relationship between the output signal phase and the control code in the prior art phase-combining circuit (the configuration without the control code converter circuit 2400). In Fig. 58B, reference character RL indicates a characteristic curve (substantially coinciding with the ideal straight line) showing the relationship between the output signal phase and the control code in the phase-combining circuit of Fig. 57.

As is apparent from a comparison between Figs. 58A and 58B, According to this phase-combining circuit , even when the circuit has the characteristic such that a nonlinearity would occur between the control code and the output phase if the control code were input directly to the weighted sum generator circuit, since the control code converter circuit 2400 converts the control code (input code) in such a manner as to correct for the nonlinearity, and supplies the resulting weight control code (converted weight control code) to the weighted sum generator circuit, the linearity of the phase-combining circuit as a whole can be greatly improved.

In this way, the linearity of the circuit as a whole can be enhanced by adding a small amount of digital circuitry and without requiring excessive linearity in the analog circuits such as the weighted sum generator circuit (weight generator circuit) and the comparator.

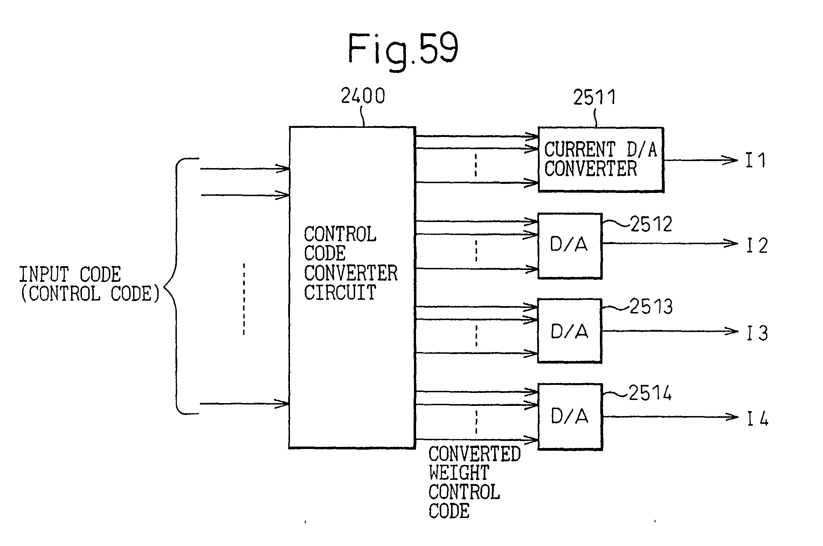

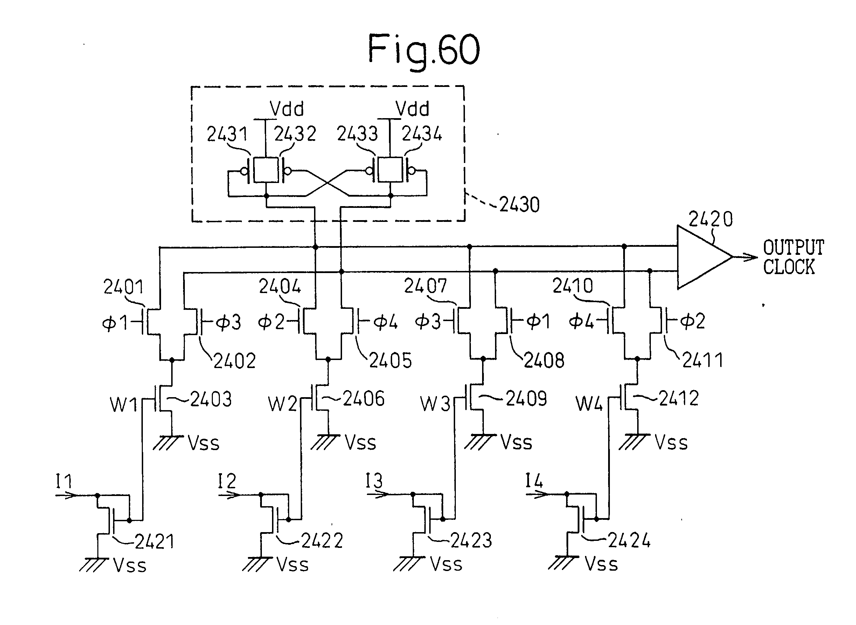

Figs. 59 and 60 are diagrams showing a first embodiment of a phase-combining circuit according to the arrangement of Fig. 57.

In Fig. 59, reference numerals 2511 to 2514 are current D/A converters which output currents (weighting currents) I1 to I4 in accordance with the converted control code into which the input code (control code) has been converted by the control code converter circuit 2400. Here, the weighted sum generator circuit 2500 shown in Fig. 57 corresponds to the circuitry comprising the D/A converters (D/A converter array) 2511 to 2514, load 2430, and transistors 2401 to 2412 and 2421 to 2424 in the phase-combining circuit (phase interpolator) shown in Figs. 59 and 60. The phase clock signals ($\phi$1, $\phi$3; $\phi$2, $\phi$4; $\phi$3, $\phi$1; and $\phi$4, $\phi$2) applied to the gates of the respective transistors (2401, 2402; 2404, 2405; 2407, 2408; and 2410, 2411) are generated, for example, by using a PLL and causing them to synchronize with a clock supplied from outside the chip. These phase clock signals $\phi$1 to $\phi$4 are phase shifted, for example, by 90 degrees relative to one another.

As shown in Fig. 59, in the phase-combining circuit (phase interpolator) of this embodiment, the input code (for example, the control code from the control signal generator circuit 2002 in Fig. 54) is converted by the control code converter circuit 2400 so that the relationship between the control code and the output phase becomes linear, and the control code thus converted is supplied to the D/A converters 2511 to 2514. More specifically, the converted weight control code, obtained by converting the input code by the control code converter circuit 2400 so that the relationship between the control code and the output phase becomes linear, is input to the D/A converters 2511 to 2514, and the currents (weighting currents) I1 to I4 corresponding to the converted weight control code are output from the respective D/A converters 2511 to 2514.

The remainder of the operation is the same as that previously described with reference to Fig. 56; that is, the currents I1 to I4 from the D/A converters 2511 to 2514 are made to flow through the corresponding transistors 2421 to 2424, and applied as weights W1 to W4 to the gates of the transistors 2403, 2406, 2409, and 2412 respectively connected to the differential pairs of transistors (2401, 2402; 2404, 2405; 2407, 2408; and 2410, 2411). The transistors in the respective differential pairs (2401, 2402; 2404, 2405; 2407, 2408; and 2410, 2411) are supplied at their gates with clock signals of different phases ($\phi$1, $\phi$3; $\phi$2, $\phi$4; $\phi$3, $\phi$1; and $\phi$4, $\phi$2), and are controlled in accordance with the respective weights W1 to W4, to output the clock (corresponding to the clock CK1 or CK2 in Fig. 54) via the comparator 2420. In Fig. 60, reference numeral 2430 designates a load. The load 2430 is constructed from pMOS transistors 2431 to 2434.

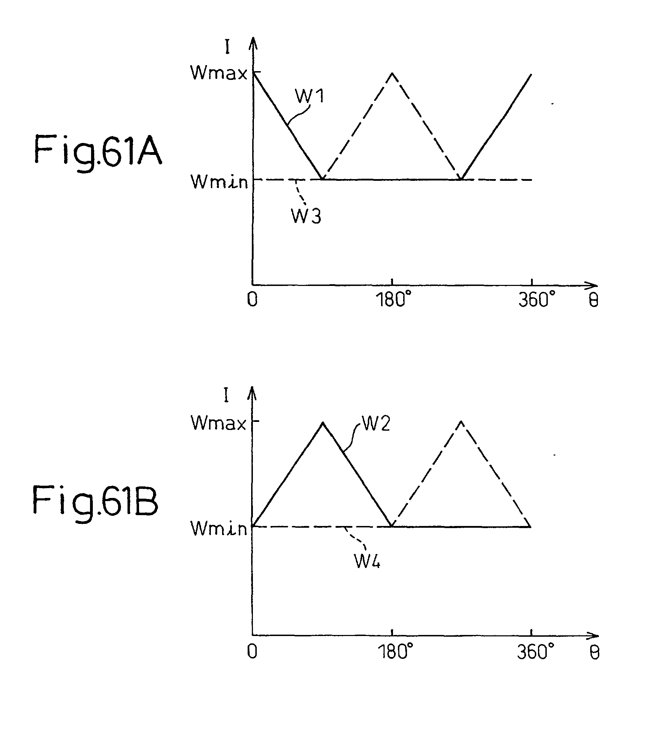

Figs. 61A and 61B are diagrams showing one example of how the weights change in the phase-combining circuit of this embodiment: Fig. 61A shows the change of the weights W1 and W3, and Fig. 61B depicts the change of the weights W2 and W4.

The weights W1 to W4 (the output currents of the current D/A converters 2511 to 2514) change as shown, for example, in Figs. 61A and 61B. Here, ordinate I represents the current, and abscissa $\theta$ the output phase of the phase-combining circuit, and the output phase when the weight W1 takes a maximum value Wmax is taken as the origin of the phase.

As shown in Figs. 61A and 61B, each weight Wn (W1 to W4) takes a maximum value Wmax as the highest value and a minimum value Wmin as the lowest value and, at any output phase, takes a nonzero value (a predetermined bias current is included). That is, the weights (currents) W1 to W4 generated by the D/A converters 2511 to 2514 each include a predetermined (wmin) bias current to ensure stable operation of the transistors to which the weights are applied.

In the example of Figs. 61A and 61B, each weight Wn (W1 to W4) is shown as a triangular wave with its lower half clamped.

In this embodiment, the input code is 6 bits long per cycle, and the converted weight control code is 9 bits long per cycle; that is, the control code converter circuit 2400 generates the 9-bit weight control code from the 6-bit input code. Here, if the relationship between the 6-bit input code (the control code output from the control signal generator circuit 2002) and the output phase of each phase interpolator is nonlinear, the input-output characteristic as a whole can be made linear by choosing the relationship between the input code and the converted weight control code in such a manner as to offset the nonlinearity.

In this way, according to the phase-combining circuit (phase interpolator) of this embodiment, when, in each phase interpolator (each slave), the input code (control code) is converted by the control code converter circuit 2400 into the converted weight control code for input to the D/A converters 2511 to 2514 so that the relationship between the input code and the output phase becomes linear, the output (phase) of each slave phase interpolator (2004) can also be made to precisely match the phase of the input clock, as in the case of the master phase interpolator (2003).

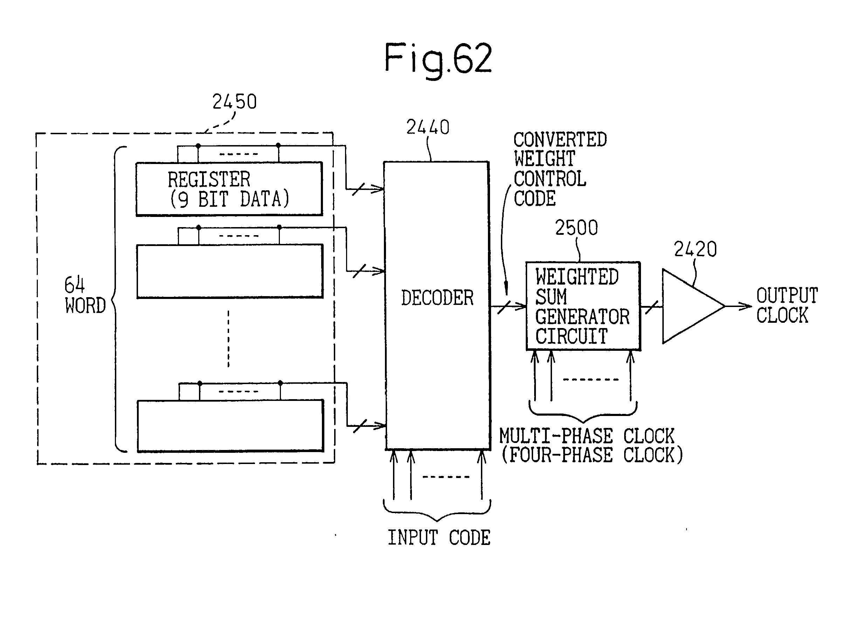

Fig. 62 is a block diagram showing a second embodiment of a phase-combining circuit using the arrangement of Fig. 57 (not forming part of the present invention).

As shown in Fig. 62, in the second embodiment, the conversion from the input code to the converted weight control code is performed by a decoder 2440 based on the data stored in a memory (register array) 2450. To generate the 9-bit converted weight control code from the 6-bit input code, the memory for storing the mapping between the input code and the converted weight control code need only have a capacity as small as 9 bits (for the converted weight control code) $\times 2^6$ (for 64 words of the input code); therefore, the memory can be constructed as the register array 2450. The input code is used as an address to specify the location in the memory at which the corresponding converted weight control code is stored, and the decoder 2440 outputs the data stored at the specified location as the converted weight control code.

The second embodiment offers the advantage that the mapping between the input code and the output phase (the converted weight control code) can be changed flexibly by altering the contents of the memory. It is also possible to compensate for variations in characteristics due to production processes.

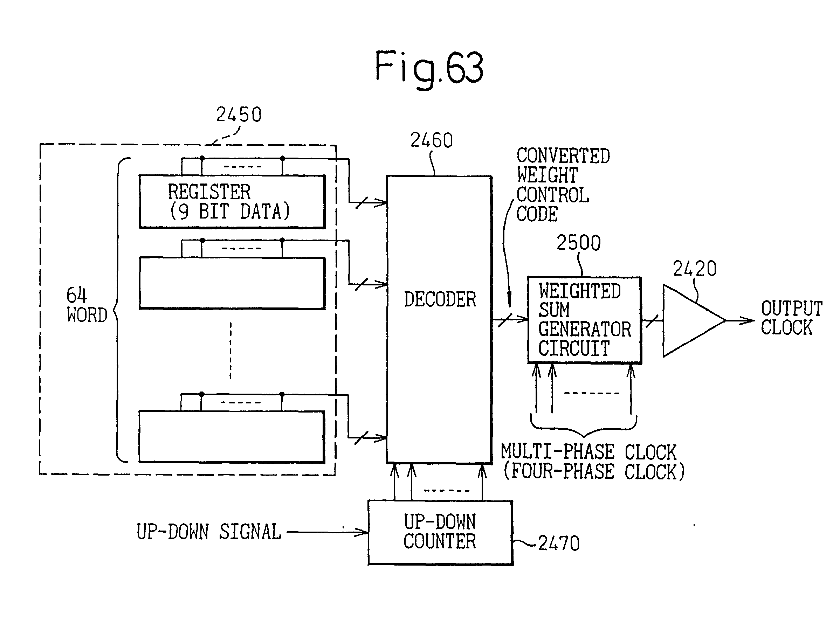

Fig. 63 is a block diagram showing a third embodiment of a phase-combining circuit rot forming part of the present invention.

As is apparent from the comparison of Fig. 63 with Fig. 62, rather than supplying the input code directly to the decoder 2440 as in the above-described second embodiment, in the third embodiment an up-down signal is input to an up-down counter 2470 and, in accordance with an output of the up-down counter 2470, a decoder 2460 reads the corresponding converted weight control code from the register array 2450 and outputs it for phase control.

More specifically, in the third embodiment, the address to specify the location of the weight control code to be used is incremented or decremented in accordance with the up-down signal, and the converted weight control code stored at the specified location in the register array 2450 is read out of the register array 2450 and, using its value, a weighted sum is generated. For the slave phase interpolator, for example, supplying the up-down signal is preferable to supplying the entire input code (control code), because the number of signal lines used to transfer the up-down signal (control code) can be reduced.

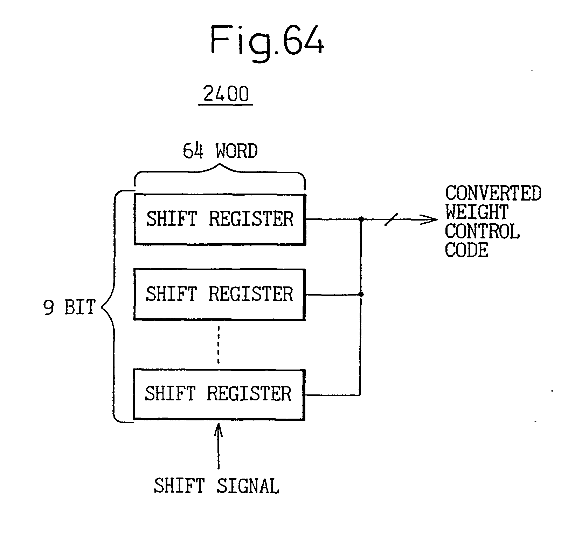

Fig. 64 is a block diagram showing a control code converter circuit as a fourth embodiment of a phase-combining circuit.

In the fourth embodiment, the control code converter circuit 2400 is constructed using a shift register array 2460 in place of the register array 2450 and decoder 2440 in the second embodiment shown in Fig. 62.

More specifically, as shown in Fig. 64, the control code converter circuit 2400 in the fourth embodiment comprises 64-word shift registers, one for each of the 9 bits, and produces a 9-bit output code (converted weight control code) from a 6-bit input code by shifting the bits to the right or left in accordance with the application of a shift signal (up-down signal). The fourth embodiment offers the advantage that when controlling the phase of each slave phase interpolator provided for each of multi-channel transmission lines, synchronized operation can be performed while maintaining channel-to-channel skew at a proper value.

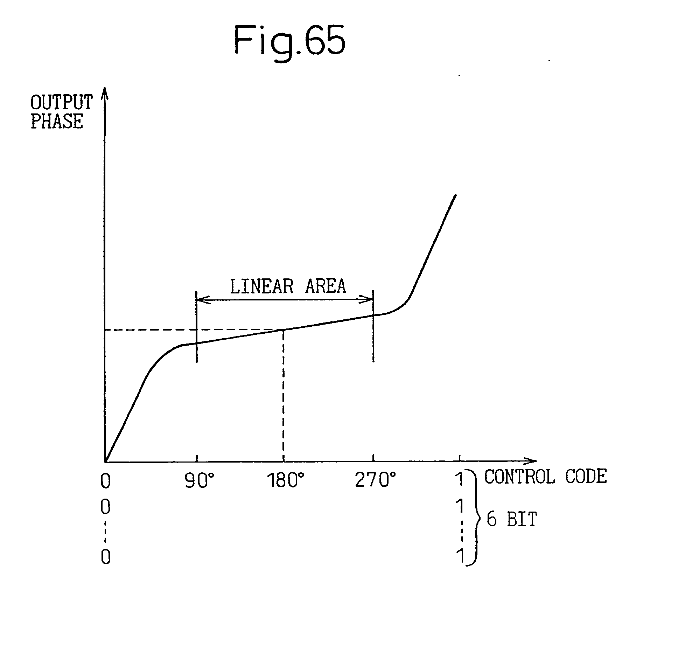

Fig. 65 is a diagram showing an output phase versus control code relationship for explaining a fifth embodiment of a phase-combining circuit

In the fifth embodiment, the relationship between the converted weight control code corresponding to the input code and the output phase is made as linear as possible within the phase range that the phase interpolator uses. More specifically, in the fifth embodiment, the relationship between the input code and the converted weight control code is chosen so that it becomes linear within the range that the phase interpolator uses (for example, the range of 90 to 270 degrees), not over the entire range of 360 degrees ($2\pi$) (the range corresponding to one clock cycle). In this way, when it is known that the range that the phase interpolator uses is limited, a higher resolution can be achieved. The fifth embodiment thus offers the advantage of being able to achieve high linearity and high resolution which are usually desirable characteristics.

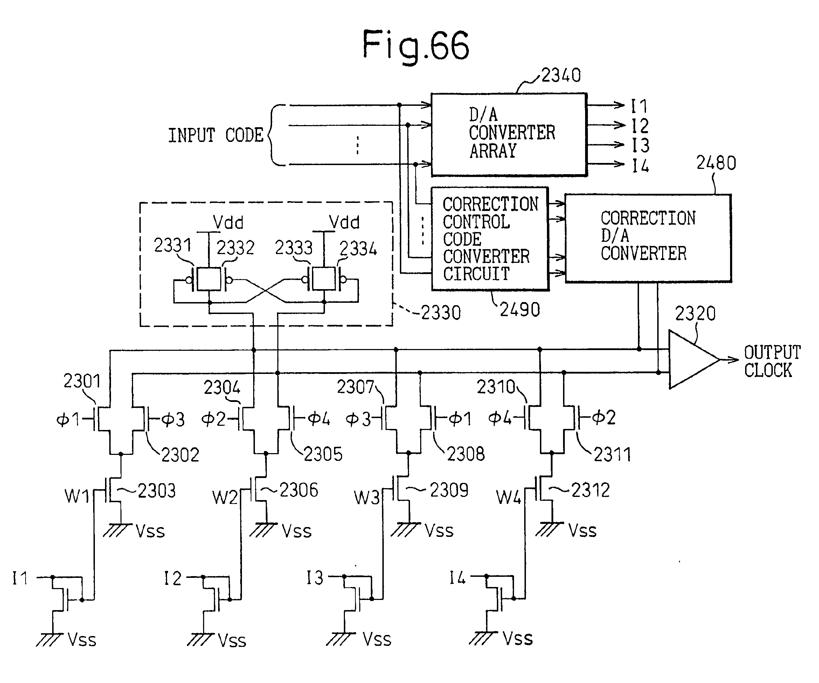

Fig. 66 is a circuit diagram showing a sixth embodiment of a phase-combining circuit.

As can be seen from the comparison of Fig. 66 with previously given Figs. 55 and 56, the sixth embodiment includes a current D/A converter (correction D/A converter) 2480 for generating a correction weight, in addition to the regular weight generator circuit (weighted sum generator circuit) provided in the prior art phase-combining circuit. More specifically, in the sixth embodiment, outputs of the correction D/A converter 2480 are supplied as inputs to the comparator 2320 to correct for the nonlinearity of the output phase relative to the input code. An output (for example, 4 bits) of a correction control code converter circuit 2490 for converting the input code (for example, 6 bits) into a correction control code is supplied as an input to the correction D/A converter 2480.

It will be noted that, in the sixth embodiment, the resolution of the current D/A converters (D/A converter array 2340) for generating the weighting currents I1 to I4 from the input code (converted weight control code: 6 bits), for example, is 6 bits as in the prior art example, and there is no need to increase the resolution to 9 bits as in the first embodiment shown in Fig. 59. Needless to say, the D/A converter array (2340) has a current output range sufficient to cover the width of nonlinearity (displacement from the ideal linear relationship) obtained with the normal weight range. Further, the correction D/A converter 2480 need only perform D/A conversion on the correction code of, for example, 4 bits, into which the input code has been converted by the correction control code converter circuit 2490, and as a result, the circuit configuration as a whole can be simplified.

In this way, in the sixth embodiment, since the combined weights obtained by combining the regular weights with the correction weight are used for phase generation, the linearity between the input code and the output phase can be enhanced by appropriately selecting the value of the correction weight; furthermore, not only can the amount of circuitry, such as a memory device, be reduced by reducing the number of bits in the correction data, but a more precise correction for nonlinearity can be achieved.

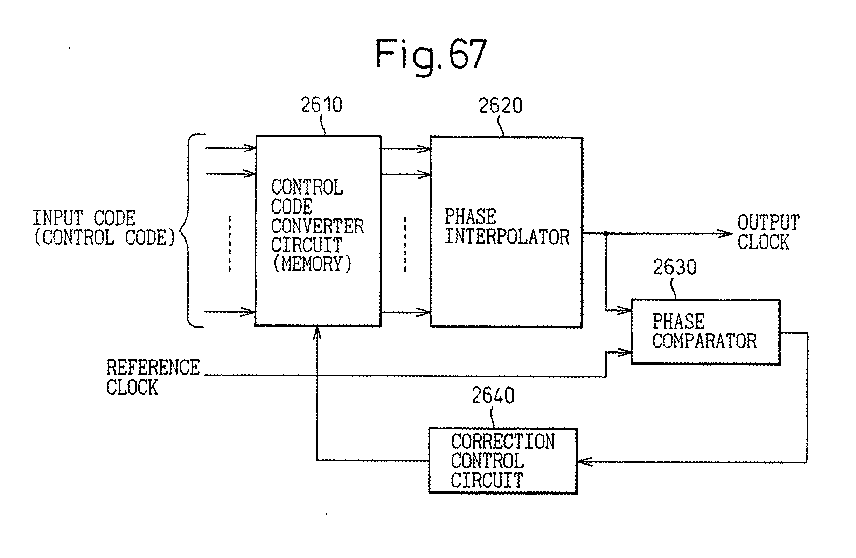

Fig. 67 is a circuit diagram showing a seventh embodiment of a phase-combining circuit.

In Fig. 67, reference numeral 2610 is a control code converter circuit, 2620 is a phase interpolator, 2630 is a phase comparator, and 2640 is a correction control circuit. Thus, the phase-combining circuit of the seventh embodiment includes the control code converter circuit 2610, phase comparator 2630, and correction control circuit 2640, in addition to the phase interpolator 2620.

As shown in Fig. 67, in the seventh embodiment, a reference clock is received from the outside, the phase of the output clock is compared in the phase comparator 2630 with the phase of the reference clock, and writing is performed to a memory in the control code converter circuit 2610 via the correction control circuit 2640 (the memory here corresponds, for example, to the register array 2450 in the second embodiment shown in Fig. 62). The writing to the memory is performed at the initial setting stage, etc., for example, during system power-on.

In the seventh embodiment, the correspondence between the input code and the converted weight control code is corrected using the phase of the externally applied reference clock. That is, to perform the correction, a variable phase reference clock is applied from the outside, and at the same time, a phase-locked loop is formed at the phase interpolator 2620 side with such circuits as the phase comparator 2630 for comparing the phase of the output clock with the phase of the reference clock and the correction control circuit 2640 having a digital filter, etc. for processing the result of the comparison (a digital signal "0" or "1" indicating a phase advance or delay). Then, the desired input code is applied from the outside and, at the same time, the reference clock having the desired phase for output is applied; in this condition, the phase-locked loop is operated to adjust the converted weight control code to such a value that makes the output clock match the reference clock, and the values of the input code and the converted weight control code obtained at this time are written to the memory. By repeating this operation for each input code, desired dependency can be obtained over a prescribed phase output range of the output clock (for example, over the entire range of one cycle, i.e., 360 degrees ($2\pi$)).

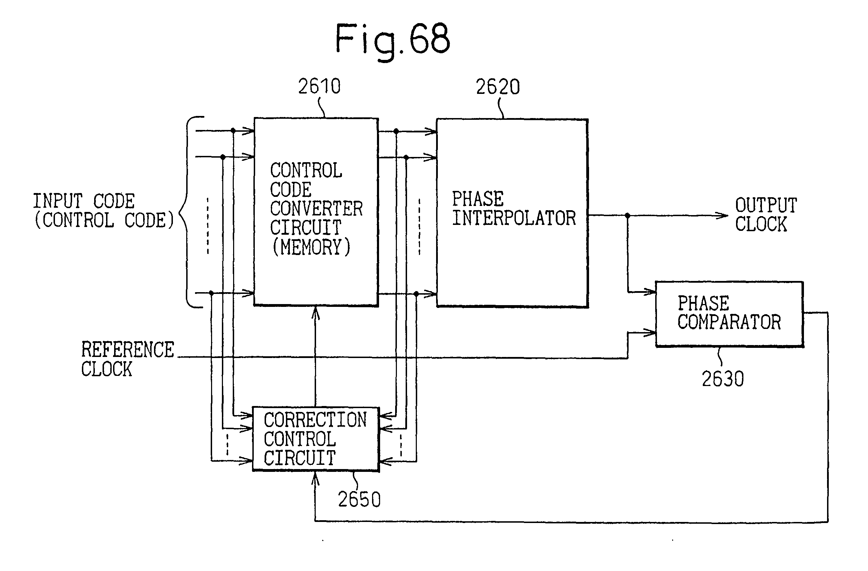

Fig. 68 is a circuit diagram showing an eighth embodiment of a phase-combining circuit.

In the seventh embodiment described above, the correction using the reference clock has been performed for all input codes, but in the eighth embodiment, the correction is performed by selecting a limited number of values from the entire set of input codes. More specifically, in the eighth embodiment, the correction using the reference clock is performed only at four points (for example, at 90 degrees, 180 degrees, 270 degrees, and 360 degrees (0 degree)), and for any input code in-between, the correction control circuit 2650 generates the converted weight control code by linear interpolation.

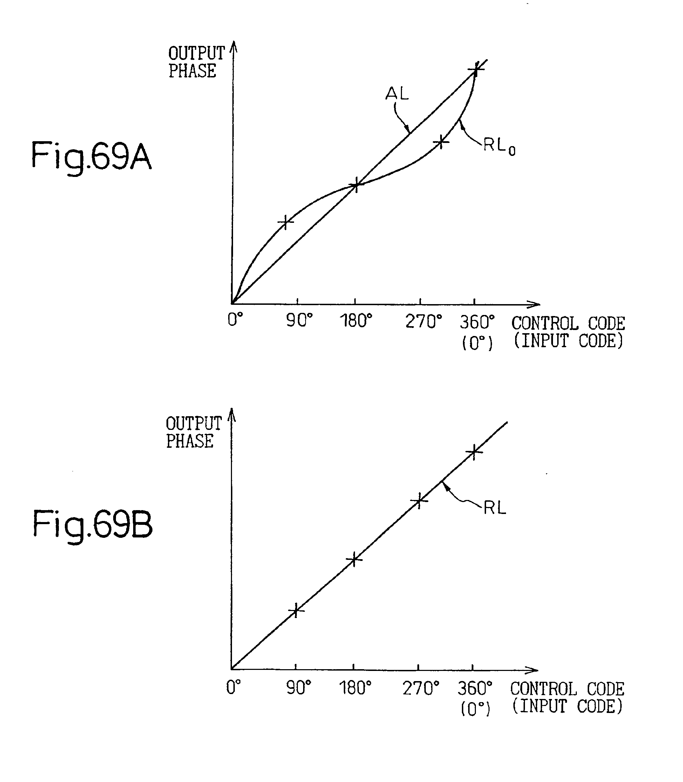

Figs. 69A and 69B are diagrams for explaining the operation of the phase-combining circuit shown in Fig. 68.

In Fig. 69A, reference character AL indicates an ideal curve (ideal straight line) representing an ideal relationship between the output signal phase of the phase-combining circuit and the control code, and RLo represents a characteristic curve showing the relationship between the output signal phase and the control code when the control code conversion is not performed. In Fig. 69B, reference character RL indicates a characteristic curve (linearly interpolated) showing the relationship between the output signal phase and the control code in the phase-combining circuit of the eighth embodiment.

Since the nonlinearity of a phase interpolator (phase-combining circuit) in general can be represented mostly by a gently sloping S-shaped curve, as shown in Fig. 69A, if the converted weight control code is generated by performing the correction using the reference clock for the input codes only at four points, for example, at 90 degrees, 180 degrees, 270 degrees, and 360 degrees (0 degree), and for any input code in-between, the converted weight control code is generated by linear interpolation, a sufficient linear characteristic can be obtained. In this way, by performing the correction only at a limited number of points when the desired characteristic is a linear characteristic, the eighth embodiment offers the advantage of being able to shorten the time required for the correction and to simplify, at the same time, the configuration of the correction signal generator.

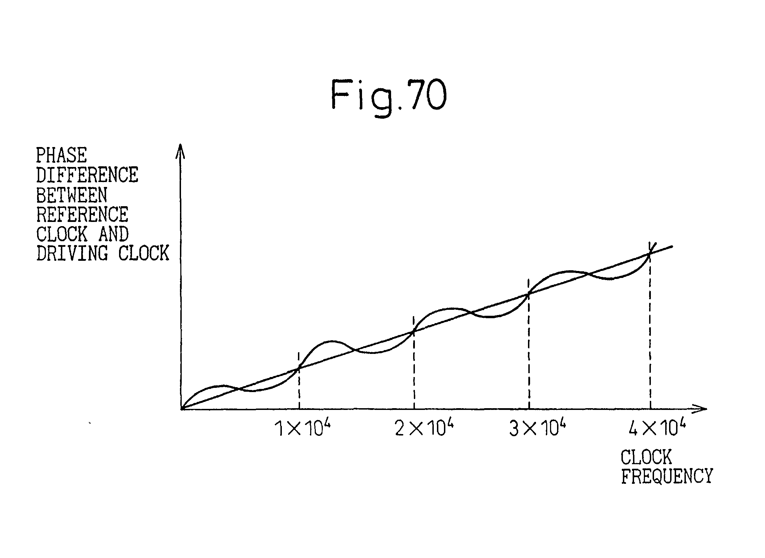

Fig. 70 is a diagram for explaining a ninth embodiment of a phase-combining circuit.

As shown in Fig. 70, rather than using a variable phase reference clock for controlling the phase of the output clock, the ninth embodiment uses a reference clock whose frequency is slightly different from that of a phase interpolator driving clock (for example, clock $\phi1$ selected from among the four phase clocks $\phi1$ to $\phi4$).

More specifically, if a clock having a frequency difference of 100 ppm relative to the phase interpolator driving clock $\phi1$ is used as the reference clock, a phase difference of one cycle, i.e., 360 degrees ($2\pi$), would result after $10^4$ clock cycles. This phase difference is sufficiently trackable by the correction phase-locked loop containing the phase interpolator, and in the range of this number of clock cycles, the two clock phases can be considered to deviate relative to each other linearly over time. Accordingly, by integrating the relationship between the code value tracked by the phase-locked loop and the number of clock cycles (one cycle of the integration is set equal to the length of time that elapses until the phase difference becomes 360 degrees), the value of the converted weight control code that achieves a linear relationship between the input code and the output clock phase can be obtained.

As described above, according to the above aspect of the present invention, a phase interpolator can be provided that achieves an input code versus output phase characteristic having highly precise linearity (or any desired dependency) without requiring more than-necessary precision in the linearity of the analog circuits such as the weighted sum generator circuit and the comparator.

As explained in detail in the above, according to the present invention, it is possible to provide a high-precision timing signal generator circuit in a simple structure based on a small number of input phases. Further, according to the present invention, it is also possible to avoid the need for a phase selector circuit that becomes the cause of phase errors and jitters.

Many different embodiments of the present invention may be constructed without departing from the scope of the present invention, and it should be understood that the present invention is not limited to the specific embodiments described in this specification, except as defined in the appended claims.

**Claims**

1. A phase-combining circuit (5) for combining three or more cyclic input signals of different phases in accordance with a control signal to output a phase-controlled signal comprising:

   a weight signal generating circuit (51) for generating weights according to the control signal;
   a weighting circuit for giving the weights to the respective input signals,
   wherein the weighting circuit includes a plurality of pairs (501, 502, 504...) of differential transistors of which gates are supplied with the input signals, a plurality of transistors (503, 506, 509...), each connected to a pair of differential transistors, and each of which is supplied with the weight (W1,...) so that the current proportional to the weight flows in it;
   and at least one load device (52) including a pair of MOS integrated capacitors (521, 522), one (521) connected between a voltage source (Vdd) and each first transistor (501, 504,...) of the pairs of differential transistors and the other (522) connected between the voltage source (Vdd) and each second transistor (502, 505,...) of the pairs of differential transistors,
   in which the load device further includes two cross-coupled pairs of MOS transistors (523, 524 and 525, 526), each pair of MOS transistors being connected in parallel between the voltage source (Vdd) and respective ones of the pairs of differential transistors (501, 502, 504,...) so as to form a load, one gate of each pair of MOS transistors being connected to said first transistors (501, 504,...) of the pairs of differential transistors, and the other gate of each pair of MOS transistors being connected to said second transistors (502, 505,...) of the pairs of differential transistors,
   and wherein a constant current (I1, I2) is supplied to each of said pairs of differential transistors, so that a high impedance is presented to a differential signal applied to a pair of the differential transistors (501, 502, 504) and a low impedance is presented to an in-phase signal applied to a pair of the differential transistors (501, 502, 504).

2. A phase-combining circuit (5) according to claim 1, wherein three or more input signals are combined.

3. The phase-combining circuit (5) as claimed in claim 1 or 2, wherein the control signals are supplied as digital control codes (CDO - CD8), and the weight signal generating circuit (51) generates weight signals by digital-to-analog converting the control codes.

4. The phase-combining circuit (5) as claimed in claim 1, wherein the weight signals are current signals.

5. The phase-combining circuit (5) as claimed in any preceding claim, wherein the input signals of different phases are directly supplied to the weighting circuit.

6. The phase-combining circuit (5) as claimed in any preceding claim, wherein the weighting circuit includes:

   a pre-driver (550) having an output amplitude that increases or decreases with the weight; and
   a weighted signal generator that is driven by the pre-driver.

7. The phase-combining circuit (5) as claimed in claim 1, wherein said weighting circuit includes:

a variable weight section for giving a variable weight of one of positive and negative polarities to each input signal; and
an inverting section (563, 564) for inverting the polarity of the weight of each signal after the signal has been weighted.

8.  A timing signal generator circuit (5) comprising:

    a phase signal generating circuit for generating two or more different phase signals as input signals;
    a phase-combining circuit according to claim 1; and
    a control signal generating circuit for generating the control signals.

9.  The timing signal generator circuit as claimed in claim 8, wherein the weight signals are current signals.

10. The timing signal generator circuit as claimed in claims 8 or 9, wherein the different phase signals are directly supplied to the weighting circuit.

11. The timing signal generator circuit as claimed in any of claims 8 to 10, wherein the weighting circuit includes:

    a pre-driver (550) having an output amplitude that increases or decreases with the weight; and
    a weighted signal generator that is driven by the pre-driver.

12. The timing signal generator circuit as claimed in any of claims 8 to 11, wherein said phase signal generating circuit generates phase signals of four phases, each signal having a mutual phase difference of 90 degrees.

13. The timing signal generator circuit as claimed in claim 12, wherein said phase signal generating circuit is a four-phase clock generator using a DLL.

14. The timing signal generator circuit as claimed in any of claims 8 to 13, wherein said timing signal generator circuit is arranged to generate internal clocks in a semiconductor integrated circuit device, and said control signal generating circuit generates a control signal according to a phase deviation between an external clock supplied from the outside and the internal clock.

15. The timing signal generator circuit as claimed in claim 13, wherein said control signal generating circuit is operable to change the control code only when the phase deviation between the external clock and the internal clock is larger than a predetermined value.

16. The timing signal generator circuit as claimed in claim 8, wherein the weighting circuit includes:

    a variable weight section for giving a variable weight of one of positive and negative polarities to each phase signal; and
    an inverting section for inverting the polarity of the weight of each signal after the signal has been weighted.

**Patentansprüche**

1.  Phasenkombinationsschaltung (5) zum Kombinieren von drei oder mehr zyklischen Eingangssignalen mit verschiedenen Phasen gemäß einem Steuersignal, um ein phasengesteuertes Signal auszugeben, umfassend:

    eine Gewichtssigialerzeugungsschaltung (51) zum Erzeugen von Gewichten gemäß dem Steuersignal;
    eine Wichtungsschaltung, um den jeweiligen Eingangssignalen die Gewichte zu verleihen;
    bei der die Wichtungsschaltung eine Vielzahl von Paaren (501, 502, 504, ...) von Differenztransistoren enthält, deren Gates die Eingangssignale zugeführt werden, eine Vielzahl von Transistoren (503, 506, 509, ...), die jeweils mit einem Paar von Differenztransistoren verbunden sind und denen jeweils das Gewicht (W1, ...) zugeführt wird, so dass der zu dem Gewicht proportionale Strom in ihm fließt;
    und wenigstens eine Lastvorrichtung (52), die ein Paar von integrierten MOS-Kondensatoren (521, 522) enthält, von denen der eine (521) zwischen einer Spannungsquelle (Vdd) und jedem ersten Transistor (501, 504, ...) von den Paaren von Differenztransistoren verbunden ist und der andere (522) zwischen der Spannungsquelle (Vdd) und jedem zweiten Transistor (502, 505, ...) von den paaren von Differenztransistoren verbunden ist,

in der die Lastvorrichtung ferner zwei kreuzgekoppelte Paare von MOS-Transistorcn (523, 524 und 525, 526) enthält, wobei jedes Paar von MOS-Transistoren zwischen der Spannungsquelle (Vdd) und jeweiligen der Paare von Differenztransistoren (501, 502, 504, ...) parallel verbunden ist, um eine Last zu bilden, ein Gate von jedem Paar von MOS-Transistoren mit den ersten Transistoren (501, 504, ...) von den Paaren von Differenztransistoren verbunden ist und das andere Gate von jedem Paar von MOS-Transistoren mit den zweiten Transistoren (502, 505, ...) von den Paaren von Differenztransistoren verbunden ist,

und bei der ein konstanter Strom (I1, I2) jedem von den Paaren von Differenztransistoren zugeführt wird, so dass eine hohe Impedanz für ein Differenzsignal vorhanden ist, das auf ein Paar der Differenztransistoren (501, 502, 504) angewendet wird, und eine niedrige Impedanz für ein In-Phase-Signal vorhanden ist, das auf ein Paar der Differenztransistoren (501, 502, 509) angewendet wird.

**2.** Phasenkombinationsschaltung (5) nach Anspruch 1, bei der drei oder mehr Eingangssignale kombiniert werden.

**3.** Phasenkombinationsschattung (5) nach Anspruch 1 oder 2, bei der die Steuersignale als digitale Steuercodes (CDO - CD8) zugeführt werden und die Gewichtssignalsrzeugungsschaltung (51) Gewichtssignale durch Digital-Analog-Konvertierung der Steuercodes erzeugt.

**4.** Phasenkombinationsschaltung (5) nach Anspruch 1, bei der die Gewichtssignale Stromsignale sind.

**5.** Phasenkombinationsschaltung (5) nach einem vorhergehenden Anspruch, bei der die Eingangssignale mit verschiedenen Phasen der Wichtungsschaltung direkt zugeführt werden.

**6.** Phasenkombinationasshaltung (5) nach einem vorhergehenden Anspruch, bei der die Wichtungsschaltu.ng enthält:

einen Vor-Treiber (550), der eine Ausgangsamplitude hat, die mit dem Gewicht zunimmt oder abnimmt; und einen Generator gewichteter Signale, der durch den Vor-Treiber angetrieben wird.

**7.** Phasenkombinationsschaltung (5) nach Anspruch 1, bei der die Wichtungsschaltung enthält:

eine variable Gewichtssektion, um jedem Eingangssignal ein variables Gewicht mit einer positiven oder negativen Polarität zu verleihen; und eine Invertierungassektion (563, 564) zum Invertieren der Polarität des Gewichtes jedes Signals, nachdem das Signal gewichtet worden ist.

**8.** Zeitlagensignalgeneratorschaltung (5), umfassend:

eine Phasensignalerzeugungsschaltung zum Erzeugen von zwei oder mehr verschiedenen Phasensignalen als Eingangssignale; eine Phasenkombinationsschaltung nach Anspruch 1; und eine Steuersignalerzeugungsschaltung zum Erzeugen der Steuersignale.

**9.** Zeitlagensignalgeneratorschaltung nach Anspruch 8, bei der die Gewichtssignale Stromsignale sind.

**10.** Zeitlagensignalgeneratorschaltung nach Anspruch 8 oder 9, bei der die verschiedenen Phasensignale der wichtungsschaltung direkt zugeführt werden.

**11.** Zeitlagensignalgeneratorschaltung nach einem der Ansprüche 8 bis 10, bei der die Wichtungsschaltung enthält:

einen Vor-Treiber (550), der eine Ausgangsamplitude hat, die mit dem Gewicht zunimmt oder abnimmt; und einen Generator gewichteter Signale, der durch den Vor-Treiber angetrieben wird.

**12.** Zeitlagensignalgeneratorschaltung nach einem der Ansprüche 8 bis 11, bei der die Phasensignalerzeugungsschaltung Phasensignale mit vier Phasen erzeugt, wobei jedes Signal eine gegenseitige Phasendifferenz von 90 Grad hat.

**13.** Zeitlagensignalgeneratorschaltung nach Anspruch 12, bei der die Phasensignalerzeugungsschaltung ein VierPhasen-Taktgenerator unter Verwendung einer DLL ist.

**14.** Zeitlagensignalgeneratorschaltung nach einem der Ansprüche 8 bis 13, bei der die Zeitlagcnsignalgeneratorschal-

tung angeordnet ist, um interne Takte in einer integrierten Halbleiterschaltungsvorrichtung zu erzeugen, und die Steuersignalerzeugungsschaltung ein Steuersignal gemäß einer Phasenabweichung zwischen einem externen Takt, der von außen zugeführt wird, und dem internen Takt erzeugt.

**15.** Zeitlagensignalgeneratorschaltung nach Anspruch 13, bei der die Steuersignalerzeugungsschaltung betriebsfähig ist, um den Steuercode nur zu verändern, wenn die Phasenabweichung zwischen dem externen Takt und dem internen Takt größer als ein vorbestimmter Wert ist.

**16.** Zeitlagensignalgeneratorschaltung nach Anspruch 8, bei der die Wichtungsschaltung enthält:

eine variable Gewichtssektion, um jedem Phasensignal ein variables Gewicht mit positiver oder negativer Polarität zu verleihen; und
eine invertierungssektion zum Invertieren der Polarität des Gewichtes jedes Signals, nachdem das Signal gewichtet worden ist.

## Revendications

**1.** Circuit de combinaison de phases (5) pour combiner trois signaux d'entrée cycliques ou plus de différentes phases conformément à un signal de commande pour délivrer un signal commandé en phase comprenant :

un circuit de génération de signal de coefficient de pondération (51) pour générer des coefficients de pondération conformément au signal de commande ;
un circuit de pondération pour appliquer les coefficients de pondération aux signaux d'entrée respectifs,
dans lequel le circuit de pondération comprend une pluralité de paires (501, 502, 504, ...) de transistors différentiels dont les grilles reçoivent les signaux d'entrée, une pluralité de transistors (503, 506, 509, ...), connectés chacun à une paire de transistors différentiels, et qui reçoivent chacun le coefficient de pondération (W1, ...) de sorte que le courant proportionnel au coefficient de pondération circule dans ceux-ci ;
et au moins un dispositif de charge (52) comprenant une paire de condensateurs MOS intégrés (521, 522), l'un (521) connecté entre une source de tension (Vdd) et chaque premier transistor (501, 504, ...) des paires de transistors différentiels et l'autre (522) connecté entre la source de tension (Vdd) et chaque deuxième transistor (502, 505, ...) des paires de transistors différentiels,
dans lequel le dispositif de charge comprend en outre deux paires à couplage transversal de transistors MOS (523, 524 et 525, 526), chaque paire de transistors MOS étant connectée en parallèle entre la source de tension (Vdd) et les transistors respectifs des paires de transistors différentiels (501, 502, 504, ...) de manière à former une charge, une grille de chaque paire de transistors MOS étant connectée auxdits premiers transistors (501, 504, ...) des paires de transistors différentiels, et l'autre grille de chaque paire de transistors MOS étant connectée auxdits deuxièmes transistors (502, 505, ...) des paires de transistors différentiels,
et dans lequel un courant constant (I1, I2) est fourni à chacune desdites paires de transistors différentiels, de sorte qu'une haute impédance soit présentée à un signal différentiel appliqué à une paire des transistors différentiels (501, 502, 504) et qu'une faible impédance soit présentée à un signal en phase appliqué à une paire des transistors différentiels (501, 502, 504).

**2.** Circuit de combinaison de phases (5) selon la revendication 1, dans lequel trois signaux d'entrée ou plus sont combinés.

**3.** Circuit de combinaison de phases (5) selon la revendication 1 ou 2, dans lequel les signaux de commande sont fournis en tant que codes de commande numériques (CD0 à CD8), et le circuit de génération de signal coefficient de pondération (51) génère des signaux de coefficient de pondération en convertissant de numérique en analogique les codes de commande.

**4.** Circuit de combinaison de phases (5) selon la revendication 1, dans lequel les signaux de coefficient de pondération sont des signaux de courant.

**5.** Circuit de combinaison de phases (5) selon l'une quelconque des revendications précédentes, dans lequel les signaux d'entrée de différentes phases sont directement fournis au circuit de pondération.

**6.** Circuit de combinaison de phases (5) selon l'une quelconque des revendications précédentes, dans lequel le circuit de pondération comprend :

un pré-dispositif de commande (550) ayant une amplitude de sortie qui augmente ou diminue avec le coefficient de pondération ; et
un générateur de signal pondéré qui est commandé par le pré-dispositif de commande.

**7.** Circuit de combinaison de phases (5) selon la revendication 1, dans lequel ledit circuit de pondération comprend :

une section à coefficient de pondération variable pour appliquer un coefficient de pondération variable de l'une de polarités positive et négative à chaque signal d'entrée ; et
une section d'inversion (563, 564) pour inverser la polarité du coefficient de pondération de chaque signal après que le signal a été pondéré.

**8.** Circuit de générateur de signal de synchronisation (5) comprenant :

un circuit de génération de signal de phase pour générer deux signaux de phases différentes ou plus en tant que signaux d'entrée ;
un circuit de combinaison de phases selon la revendication 1 ; et
un circuit de génération de signal de commande pour générer les signaux de commande.

**9.** Circuit de générateur de signal de synchronisation selon la revendication 8, dans lequel les signaux de coefficient de pondération sont des signaux de courant.

**10.** Circuit de générateur de signal de synchronisation selon la revendication 8 ou 9, dans lequel les signaux de différentes phases sont directement fournis au circuit de pondération.

**11.** Circuit de générateur de signal de synchronisation selon l'une quelconque des revendications 8 à 10, dans lequel le circuit de pondération comprend :

un pré-dispositif de commande (550) ayant une amplitude de sortie qui augmente ou diminue avec le coefficient de pondération ; et
un générateur de signal pondéré qui est commandé par le pré-dispositif de commande.

**12.** Circuit de générateur de signal de synchronisation selon l'une quelconque des revendications 8 à 11, dans lequel ledit circuit de génération de signal de phase génère des signaux de phase de quatre phases, tous les signaux ayant des différences de phase mutuelles de 90 degrés.

**13.** Circuit de générateur de signal de synchronisation selon la revendication 12, dans lequel ledit circuit de génération de signal de phase est un générateur d'horloge à quatre phases utilisant une DLL.

**14.** Circuit de générateur de signal de synchronisation selon l'une quelconque des revendications 8 à 13, dans lequel ledit circuit de générateur de signal de synchronisation est agencé pour générer des horloges internes dans un dispositif de circuit intégré à semi-conducteurs, et ledit circuit de génération de signal de commande génère un signal de commande conformément à un écart de phase entre une horloge externe fournie de l'extérieur et l'horloge interne.

**15.** Circuit de générateur de signal de synchronisation selon la revendication 13, dans lequel ledit circuit de génération de signal de commande ne peut être utilisé pour modifier le code de commande que lorsque l'écart de phase entre l'horloge externe et l'horloge interne est supérieur à une valeur prédéterminée.

**16.** Circuit de générateur de signal de synchronisation selon la revendication 8, dans lequel le circuit de pondération comprend :

une section à coefficient de pondération variable pour appliquer un coefficient de pondération variable de l'une de polarités positive et négative à chaque signal de phase ; et
une section d'inversion pour inverser la polarité du coefficient de pondération de chaque signal après que le signal a été pondéré.

Fig.1A

Fig.1B

Fig.1C

Fig.2

OUTPUT
TS

Σ  202

W1  211
W2  212
W3  213
W4  214

φ1
φ2
φ3
φ4

Fig.3A

$\phi 1$

$90°$

$\phi 2$

O

[WEIGHT]

Fig.3B

W1

O

$\theta$

W2

# Fig.4

EP 1 104 110 B1

# Fig.5

EP 1 104 110 B1

# Fig.6

<u>11</u>

# Fig.7

<u>12</u>

# Fig.8

130 (131~135)

# Fig.9

150(151,152)

# Fig.10

EP 1 104 110 B1

# Fig.11

EP 1 104 110 B1

# Fig.12A

# Fig.12B

# Fig.13

52

Vdd    Vdd         Vdd         Vdd

523    524     525    526

↓I1  ↓I2    I1↓  ↓I2

521                                        522

TO EACH PAIR OF DIFFERENTIAL
TRANSISTORS

# Fig.14

UP-DOWN SIGNAL GENERATOR CIRCUIT
[NUMBER OF "1"]-[NUMBER OF "0"]=8,6,4: UP
[NUMBER OF "0"]-[NUMBER OF "1"]=8,6,4: DOWN

41

4

42

UP

DOWN

UP-DOWN
COUNTER

DD0

DD1

DD2

DD7

DD →

430

431

432

437

D/A
CONVERTER

(W1~W4)

51(530)

5

CLOCK

EP 1 104 110 B1

# Fig.15

CONTROL CODE

EP 1 104 110 B1

# Fig.16

4210

UP          DOWN

clk

4211    4212
4213    4214

4215
4216

clk'

/UP    /DOWN

# Fig.17

4211

42111

in
(clk)

out

42112

42113

UP

# Fig.18

EP 1 104 110 B1

Fig.19

5000

Fig.20

D/A CONVERTER

530(51)

Ir
TES
CD0
/CD0
CD8
/CD8

CD10
/CD10
CD18
/CD18

W1
W2
W3
W4

541 W11
542 W12 W21
543 W22 W31
544 W32 W41 W42

PRE-DRIVER 550

φ1
φ2
φ3
φ4

φW1
/φW1
φW2
/φW2
φW3
/φW3
φW4
/φW4

MIXER & OUTPUT BUFFER 560

Vdd

571 CK
572 /CK

# Fig.21

EP 1 104 110 B1

# Fig.22

W11▷

φ1▷

φ3▷

**551**

PRE-
DRIVER
UNIT

▷ φW1

▷ φW3

**550**

W21▷

**552**

PRE-
DRIVER
UNIT

▷ /φW1

▷ /φW3

W31▷

φ2▷

φ4▷

**553**

PRE-
DRIVER
UNIT

▷ φW2

▷ φW4

W41▷

**554**

PRE-
DRIVER
UNIT

▷ /φW2

▷ /φW4

# Fig.23

# Fig.24

EP 1 104 110 B1

# Fig.25

EP 1 104 110 B1

# Fig.26

EP 1 104 110 B1

# Fig.27

541

# Fig.28

EP 1 104 110 B1

Fig.29A

Fig.29B

Fig.30A

Fig.30B

# Fig.31

EP 1 104 110 B1

# Fig.32

EP 1 104 110 B1

# Fig.33

# Fig.34

φ1  φ2  φ3  φ4

2(φ1,/φ1)  W1    /7301
                 PHASE-
2(φ2,/φ2)  W2    COMBINING
                 UNIT

                 /7310
                 SELECTOR → OUT

2(φ2,/φ2)  W2    /7302
                 PHASE-
2(φ3,/φ3)  W1    COMBINING
                 UNIT

2(φ3,/φ3)  W1    /7303
                 PHASE-
2(φ4,/φ4)  W2    COMBINING
                 UNIT

2(φ4,/φ4)  W2    /7304
                 PHASE-
2(φ1,/φ1)  W1    COMBINING
                 UNIT

EP 1 104 110 B1

59

# Fig.35

# Fig.36

EP 1 104 110 B1

# Fig.37

EP 1 104 110 B1

# Fig.38

# Fig.39A

# Fig.39B

# Fig.40

$$d1 = f2 - f1$$
$$d2 = f3 - f2$$
$$d3 = f4 - f3$$

$$\vdots$$

$$dn = f1 - fn + 2\pi$$

# Fig.41

EP 1 104 110 B1

801

f1 →
f2 →
f3 →

INPUT SIGNAL
PROCESSING CIRCUIT

:

fn →

F1 →
F2 →
F3 →

:

Fn →

802

PHASE-COMBINING
CIRCUIT
(PHASE
INTERPOLATOR)

→ OUTPUT

# Fig.42

$$F1 = \frac{f1 + f2}{2} \qquad F3 = \frac{f3 + f4}{2}$$

$$F2 = \frac{f2 + f3}{2} \qquad F4 = \frac{f4 + f1 + 2\pi}{2}$$

# Fig.43

EP 1 104 110 B1

# Fig.44

802

EP 1 104 110 B1

# Fig.45

# Fig.46

EP 1 104 110 B1

# Fig.47

EP 1 104 110 B1

# Fig.48

$$F1 = \frac{f1 + f2 + f3}{3}$$

$$F2 = \frac{f2 + f3 + f4}{3}$$

$$F3 = \frac{f3 + f4 + f5}{3}$$

$$F4 = \frac{f4 + f5 + f6}{3}$$

$$F5 = \frac{f5 + f6 + f1 + 2\pi}{3}$$

$$F6 = \frac{f6 + f1 + f2 + 4\pi}{3}$$

# Fig.49

# Fig.50

EP 1 104 110 B1

# Fig.51

# Fig.52

EP 1 104 110 B1

# Fig.53

# Fig.54

# Fig.55

2003(2004)

2340

D/A CONVERTER ARRAY

CONTROL CODE (INPUT CODE)

I1
I2
I3
I4

FOUR-PHASE CLOCK GENERATOR CIRCUIT

φ1
φ2
φ3
φ4

2350

# Fig.56

EP 1 104 110 B1

# Fig.57

EP 1 104 110 B1

Fig.58A

OUTPUT PHASE

AL

RL$_0$

0°     180°     360°

CONTROL CODE
(INPUT CODE)

Fig.58B

OUTPUT PHASE

RL

0°     180°     360°

CONTROL CODE
(INPUT CODE)

# Fig.59

INPUT CODE
(CONTROL CODE)

2400

CONTROL
CODE
CONVERTER
CIRCUIT

2511

CURRENT D/A
CONVERTER → I1

2512

D/A → I2

2513

D/A → I3

2514

D/A → I4

CONVERTED
WEIGHT
CONTROL
CODE

EP 1 104 110 B1

Fig.60

Fig.61A

I

Wmax

W1

Wmin

W3

0          180°          360°          θ

Fig.61B

I

Wmax

W2

Wmin

W4

0          180°          360°          θ

# Fig.62

EP 1 104 110 B1

# Fig.63

# Fig.64

2400

64 WORD

9 BIT

| SHIFT REGISTER |
| SHIFT REGISTER |
| SHIFT REGISTER |

CONVERTED
WEIGHT
CONTROL
CODE

SHIFT SIGNAL

# Fig.65

# Fig.66

EP 1 104 110 B1

# Fig.67

# Fig.68

EP 1 104 110 B1

Fig.69A

Fig.69B

# Fig.70

PHASE
DIFFERENCE
BETWEEN
REFERENCE
CLOCK AND
DRIVING CLOCK

$1 \times 10^4$   $2 \times 10^4$   $3 \times 10^4$   $4 \times 10^4$

CLOCK
FREQUENCY

EP 1 104 110 B1

**REFERENCES CITED IN THE DESCRIPTION**

**Patent documents cited in the description**

- US 5485490 A

- WO 9837656 A